(19) Europäisches Patentamt
European Patent Office
Office européen des brevets

(11) EP 4 628 319 A1

(12) **EUROPEAN PATENT APPLICATION**
published in accordance with Art. 153(4) EPC

(43) Date of publication:
**08.10.2025 Bulletin 2025/41**

(21) Application number: **23897888.6**

(22) Date of filing: **30.11.2023**

(51) International Patent Classification (IPC):
***B41N 1/14*** *(2006.01)* ***B41C 1/10*** *(2006.01)*
***B41M 1/06*** *(2006.01)* ***G03F 7/00*** *(2006.01)*
***G03F 7/004*** *(2006.01)* ***G03F 7/075*** *(2006.01)*
***G03F 7/095*** *(2006.01)*

(52) Cooperative Patent Classification (CPC):
**B41C 1/10; B41M 1/06; B41N 1/14; G03F 7/00; G03F 7/004; G03F 7/075; G03F 7/095**

(86) International application number:
**PCT/JP2023/043021**

(87) International publication number:
**WO 2024/117242 (06.06.2024 Gazette 2024/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.11.2022 JP 2022192211**
**10.07.2023 JP 2023113277**

(71) Applicant: **FUJIFILM Corporation**
**Tokyo 106-8620 (JP)**

(72) Inventors:
- **AIZU, Kohei**
  **Haibara-gun, Shizuoka 421-0396 (JP)**
- **MIMURA, Tomonori**
  **Haibara-gun, Shizuoka 421-0396 (JP)**

(74) Representative: **HGF**
**HGF Limited**
**1 City Walk**
**Leeds LS11 9DX (GB)**

(54) **LITHOGRAPHIC PRINTING PLATE PRECURSOR, METHOD FOR MANUFACTURING LITHOGRAPHIC PRINTING PLATE, AND LITHOGRAPHIC PRINTING METHOD**

(57) A lithographic printing plate precursor includes: a support; and an image-recording layer on the support, and the image-recording layer contains (meth)acrylic polymer A having a substituent containing two or more silicon atoms in a side chain.

EP 4 628 319 A1

## Description

### BACKGROUND OF THE INVENTION

1. Field of the Invention

The present disclosure relates to a lithographic printing plate precursor, a method of preparing a lithographic printing plate, and a lithographic printing method.

2. Description of the Related Art

Generally, a lithographic printing plate consists of a lipophilic image area that receives ink in a printing process and a hydrophilic non-image area that receives dampening water. Lithographic printing is a method exploiting the mutual repulsion of water and oil-based ink, in which the lipophilic image area and the hydrophilic non-image area of a lithographic printing plate are used as an ink-receiving portion and a dampening water-receiving portion (non-ink-receiving portion) respectively, the adhesiveness of ink is varied within the surface of the lithographic printing plate such that only the image area receives the ink, and then printing is performed by the transfer of the ink to a printing substrate such as paper.

In the related art, in order to prepare this lithographic printing plate, a lithographic printing plate precursor (also referred to as PS plate) has been widely used which is obtained by providing a lipophilic image-recording layer on a hydrophilic support. Generally, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing a surface of the hydrophilic support.

As a lithographic printing plate precursor of the related art, a lithographic printing plate precursor containing a compound having a substituent containing a silicon atom in an image-recording layer is known (for example, see JP2009-237381A, JP2004-029680A, JP2006-235390A, and JP1997-054432A (JP-H09-054432A)).

### SUMMARY OF THE INVENTION

An object to be achieved by an embodiment of the present disclosure is to provide a lithographic printing plate precursor having an image-recording layer with an excellent surface state of a coating film.

An object to be achieved by another embodiment of the present disclosure is to provide a method of preparing a lithographic printing plate using the lithographic printing plate precursor and a lithographic printing method using the lithographic printing plate precursor.

The present disclosure includes the following aspects.

<1> A lithographic printing plate precursor comprising: a support; and an image-recording layer on the support, in which the image-recording layer contains a (meth)acrylic polymer A having a substituent containing two or more silicon atoms in a side chain.

<2> A lithographic printing plate precursor comprising: a support; and an image-recording layer on the support, in which the image-recording layer contains a polymer B having a constitutional unit represented by Formula (I),

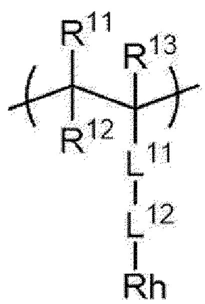

(I)

In Formula (I), $R^{11}$ and $R^{12}$ each independently represent a hydrogen atom or an alkyl group, $R^{13}$ represents a hydrogen atom or a monovalent substituent, $L^{11}$ and $L^{12}$ each independently represent a single bond or a divalent linking group, and Rh represents a substituent containing two or more silicon atoms.

<3> The lithographic printing plate precursor according to <1> or <2>, in which the lithographic printing plate precursor

is an on-press development type lithographic printing plate precursor.

<4> The lithographic printing plate precursor according to any one of <1> to <3>, in which the image-recording layer further contains resin particles.

<5> The lithographic printing plate precursor according to any one of <1> to <3>, in which the image-recording layer further contains a color developing agent.

<6> The lithographic printing plate precursor according to any one of <1> or <3> to <5>, in which the (meth)acrylic polymer A is a copolymer including the constitutional unit having a substituent containing two or more silicon atoms in a side chain and a constitutional unit having a hydrophilic group in the side chain.

<7> The lithographic printing plate precursor according to any one of <1> or <3> to <6>, in which the (meth)acrylic polymer A is a copolymer including the constitutional unit having a substituent containing two or more silicon atoms in a side chain and a constitutional unit having a polyalkyleneoxy group in the side chain.

<8> The lithographic printing plate precursor according to any one of <2> to <5>, in which Rh in Formula (I) is a group including two or more structures represented by Formula (Ia),

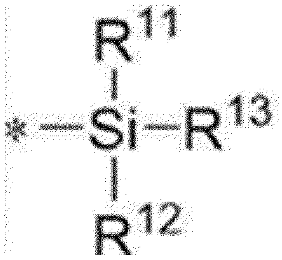 (Ia)

In Formula (Ia), * represents a bonding position, and $R^{11}$, $R^{12}$, and $R^{13}$ each independently represent an alkyl group, an alkenyl group, an aryl group, or an alkylene aryl group.

<9> The lithographic printing plate precursor according to any one of <2> to <5>, in which the polymer B is a copolymer further having a constitutional unit having a hydrophilic group in a side chain.

<10> The lithographic printing plate precursor according to <9>, in which the constitutional unit having a hydrophilic group in a side chain is a constitutional unit represented by Formula (a4),

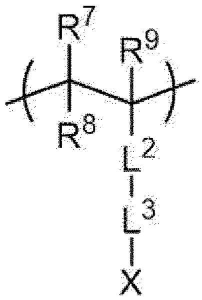 (a4)

In Formula (a4), $R^7$ and $R^8$ each independently represent a hydrogen atom or an alkyl group, $R^9$ represents a hydrogen atom or a monovalent substituent, $L^2$ represents -C(=O)-O- or -C(=O)-NH-, $L^3$ represents a single bond or a divalent linking group, and X represents a hydrophilic group.

<11> The lithographic printing plate precursor according to <10>, in which, in Formula (a4), $L^2$ represents -C(=O)-NH-.

<12> The lithographic printing plate precursor according to <10> or <11>, in which, in Formula (a4), the hydrophilic group represented by X is a hydroxyl group, a polyalkyleneoxy group, or a group obtained by combining two or more of these groups.

<13> The lithographic printing plate precursor according to any one of <2>, <3>, and <8> to <12>, in which the polymer B is a copolymer further having a constitutional unit having a polyalkyleneoxy group in a side chain.

<14> The lithographic printing plate precursor according to any one of <2> or <8> to <13>, in which $L^{11}$ in Formula (I) is an ester bond.

<15> A method of preparing a lithographic printing plate, including:

a step of exposing the lithographic printing plate precursor according to any one of <3> to <14> in a shape of an image; and

a step of supplying at least one selected from the group consisting of a printing ink and dampening water on a printer to remove an image-recording layer in a non-image area.

<16> A lithographic printing method including:

a step of exposing the lithographic printing plate precursor according to any one of <3> to <14> in a shape of an image;
a step of supplying at least one selected from the group consisting of a printing ink and dampening water on a printer to remove an image-recording layer in a non-image area and to prepare a lithographic printing plate; and
a step of performing printing using the obtained lithographic printing plate.

According to one embodiment of the present disclosure, it is possible to provide a lithographic printing plate precursor having an image-recording layer with excellent surface state of a coating film.
Further, according to another embodiment of the present disclosure, it is possible to provide a method of preparing a lithographic printing plate using the lithographic printing plate precursor and a lithographic printing method using the lithographic printing plate precursor.

## BRIEF DESCRIPTION OF THE DRAWINGS

Fig. 1 is a schematic cross-sectional view of an embodiment of an aluminum support suitably used in the present disclosure.
Fig. 2 is a schematic cross-sectional view of an embodiment of an aluminum support having an anodic oxide film.
Fig. 3 is a graph showing an example of an alternating waveform current waveform diagram used for an electrochemical roughening treatment in a manufacturing method of an aluminum support having an anodic oxide film.
Fig. 4 is a side view showing an example of an electrolytic cell (radial type cell) in an electrochemical roughening treatment using alternating current in a method of producing an aluminum support having an anodic oxide film.
Fig. 5 is a lateral view conceptually showing a brush graining step used in a mechanical roughening treatment in a manufacturing method of an aluminum support having an anodic oxide film.
Fig. 6 is a schematic view of an anodization treatment device used for an anodization treatment in a manufacturing method of an aluminum support having an anodic oxide film.

## DESCRIPTION OF THE PREFERRED EMBODIMENTS

Hereinafter, the contents of the present disclosure will be specifically described. The following configuration requirements will be described on the basis of typical embodiments of the present disclosure, but the present disclosure is not limited to such embodiments.
In the present specification, a numerical range expressed using "to" includes numerical values listed before and after "to" as the lower limit value and the upper limit value.
In addition, in the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).
In the present specification, "(meth)acryl" is a term used to explain a concept including both the acryl and methacryl, and "(meth)acryloyl" is a term used to explain a concept including both the acryloyl and methacryloyl.
In addition, the term "step" in the present specification means not only an independent step but also a step that cannot be clearly differentiated from other steps as long as the intended goal of the step is achieved.
In the present disclosure, "% by mass" has the same definition as "% by weight", and "part by mass" has the same definition as "part by weight".
In the present disclosure, unless otherwise specified, as each component contained in a composition, one component or one constitutional unit may be used alone, or two or more components or two or more constitutional units may be used in combination. In addition, in the present disclosure, unless otherwise specified, as each component contained in a polymer or each constitutional unit contained in a polymer, one component or one constitutional unit may be used alone, or two or more components or two or more constitutional units may be used in combination.
Furthermore, in the present disclosure, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.
In the present disclosure, a combination of two or more preferred aspects is a more preferred aspect.

In addition, in the present disclosure, unless otherwise specified, each of the weight-average molecular weight (Mw) and number-average molecular weight (Mn) is a molecular weight that is detected using a gel permeation chromatography (GPC) analysis apparatus using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present disclosure, the term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

In the present disclosure, "excellent in printing durability" means that a large number of sheets can be printed using a lithographic printing plate, and printing durability exhibited in a case where an ultraviolet-curable ink (UV ink) used as a printing ink will be also described as "UV printing durability" hereinafter.

Hereinafter, the present disclosure will be specifically described.

(Lithographic printing plate precursor)

A first embodiment of a lithographic printing plate precursor (also simply referred to as a "lithographic printing plate precursor") according to the present disclosure includes: a support; and an image-recording layer on the support, and the image-recording layer contains (meth)acrylic polymer A having a substituent containing two or more silicon atoms in a side chain.

A second embodiment of the lithographic printing plate precursor according to the present disclosure includes: a support and an image-recording layer on the support, in which the image-recording layer contains a polymer B having a constitutional unit (b1) represented by Formula (I).

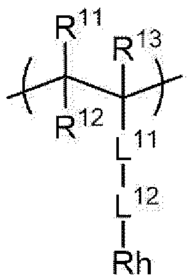

(I)

In Formula (I), $R^{11}$ and $R^{12}$ each independently represent a hydrogen atom or an alkyl group, $R^{13}$ represents a hydrogen atom or a monovalent substituent, $L^{11}$ and $L^{12}$ each independently represent a single bond or a divalent linking group, and Rh represents a substituent containing two or more silicon atoms.

In the present specification, the expression "lithographic printing plate precursor according to the embodiment of the present disclosure" denotes both of the above-described first embodiment and the above-described second embodiment, unless otherwise specified. Furthermore, in a case where a term such as "image-recording layer" is simply mentioned, unless otherwise specified, the term refers to the image-recording layer of both the first embodiment and the second embodiment, or the like.

As a result of intensive studies, the present inventors have found that the lithographic printing plate precursor having an image-recording layer with an excellent surface state of a coating film can be provided by adopting the above-described configuration.

The detailed mechanism that brings about the aforementioned effect is unclear, but is assumed to be as below.

In the first embodiment, it is considered that the (meth)acrylic polymer A having a substituent containing two or more silicon atoms in a side chain in the image-recording layer is likely to be unevenly distributed on the surface in a case of forming the image-recording layer due to the structure of the side chain, and contributes to the surface smoothness of the image-recording layer.

In the second embodiment, it is considered that the polymer B having the constitutional unit (b1) represented by Formula (I) contained in the image-recording layer is also likely to be unevenly distributed on the surface in a case of forming the image-recording layer due to the structure of the side chain, and contributes to the surface smoothness of the image-recording layer.

As a result, it is presumed that unevenness is less likely to be visually recognized in a case where the surface is

visually observed, and an image-recording layer having an excellent coating film surface state is obtained.

Hereinafter, the "coating film surface state" may be simply referred to as "surface state".

Furthermore, in a case where the lithographic printing plate precursor according to the embodiment of the present disclosure is an on-press development type lithographic printing plate precursor, it is considered that the (meth) acrylic polymer A or the polymer B unevenly distributed on the surface of the image-recording layer enhances the wettability of dampening water on the surface of the lithographic printing plate precursor (that is, the surface of the image-recording layer) and the permeation of dampening water into the image-recording layer, due to the presence of the silicon atom in the side chain. As a result, it is presumed that the on-press development type lithographic printing plate precursor, which is the lithographic printing plate precursor according to the present disclosure, exhibits particularly excellent on-press developability.

Here, the "on-press development type lithographic printing plate precursor" means a lithographic printing plate precursor applied to "on-press development" in which the lithographic printing plate precursor is mounted on a printer without performing development in the related art after exposure, and the unnecessary portion of the image-recording layer is removed in the initial stage of the normal printing step.

[(Meth)acrylic polymer A having substituent containing two or more silicon atoms in side chain]

In the first embodiment of the lithographic printing plate precursor according to the present disclosure, the image-recording layer contains the (meth)acrylic polymer A having a substituent containing two or more silicon atoms in a side chain.

The (meth)acrylic polymer A has a structure in which a side chain having a substituent including two or more silicon atoms is bonded to a main chain composed of a (meth)acrylic resin chain.

The substituent containing two or more silicon atoms is not particularly limited as long as the atomic group constituting the substituent contains two or more silicon atoms. From the viewpoint of on-press developability, it is preferable that the substituent having two or more silicon atoms includes the silicon atom as a silicon-oxygen bond (Si-O bond). The substituent having two or more silicon atoms preferably has two or more silicon-oxygen bonds, preferably has three or more silicon-oxygen bonds, and preferably has 3 to 12 silicon-oxygen bonds. The substituent including two or more silicon atoms preferably includes a silicon-oxygen bond as a polysiloxane structure.

In addition, from the viewpoint of on-press developability, the substituent containing two or more silicon atoms preferably has a branched structure, and more preferably has a branched structure branched around a silicon atom.

The substituent containing two or more silicon atoms is preferably a group having two or more structures represented by Formula (a1).

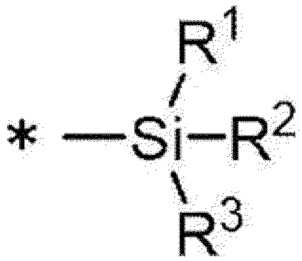 (a1)

In Formula (a1), * represents a bonding position, and $R^1$, $R^2$, and $R^3$ each independently represent an alkyl group, an alkenyl group, an aryl group, or an alkylene aryl group.

Examples of the alkyl group represented by $R^1$, $R^2$, and $R^3$ include a linear alkyl group having 1 to 18 carbon atoms, and a branched or cyclic alkyl group having 3 to 18 carbon atoms. Specific examples the alkyl group described above include a methyl group, an ethyl group, a propyl group, a butyl group, an isopropyl group, a tert-butyl group, a cyclohexyl group, and the like.

Examples of the alkenyl group represented by $R^1$, $R^2$, and $R^3$ include an alkenyl group having 2 to 12 carbon atoms. Specific examples of the alkenyl group described above include a vinyl group, a 1-propenyl group, a 1-butenyl group, a 1-methyl-1-propenyl group, a 1-cyclopentenyl group, a 1-cyclohexenyl group, and the like.

Examples of the aryl group represented by $R^1$, $R^2$, and $R^3$ include an aryl group having 6 to 12 carbon atoms. Specific examples the aryl group described above include a phenyl group, an $\alpha$-methylphenyl group, a naphthyl group, and the like.

Examples of the alkylene aryl group represented by $R^1$, $R^2$, and $R^3$ include an alkylene aryl group having 7 to 30 carbon atoms.

In Formula (a1), it is preferable that $R^1$, $R^2$, and $R^3$ are each independently an alkyl group, it is more preferable

that $R^1$, $R^2$, and $R^3$ all are the same alkyl group, it is even more preferable that $R^1$, $R^2$, and $R^3$ all are an alkyl group having 1 to 4 carbon atoms, and it is particularly preferable that $R^1$, $R^2$, and $R^3$ all are a methyl group.

The substituent including two or more silicon atoms is preferably a group including three or more structures represented by Formula (a1), and more preferably a group including 3 to 6 structures represented by Formula (a1).

The substituent including two or more silicon atoms is preferably a group represented by Formula (a2).

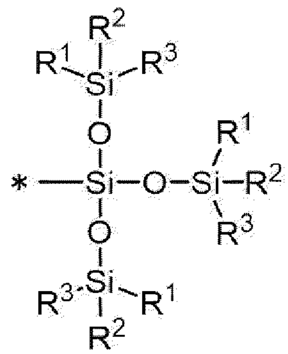
(a2)

In Formula (a2), * represents a bonding position, and $R^1$, $R^2$, and $R^3$ each independently represent an alkyl group, an alkenyl group, an aryl group, or an alkylene aryl group.

$R^1$, $R^2$, and $R^3$ in Formula (a2) have the same meanings as $R^1$, $R^2$, and $R^3$ in Formula (a1), and preferred aspects thereof are also the same.

From the viewpoint of obtaining more excellent on-press developability, the (meth)acrylic polymer A is preferably a copolymer including a constitutional unit having a substituent including two or more silicon atoms in the side chain and a constitutional unit having a hydrophilic group in the side chain.

The constitutional unit having a hydrophilic group in the side chain is preferably a constitutional unit having a polyalkyleneoxy group in the side chain. That is, the (meth)acrylic polymer A is preferably a copolymer including a constitutional unit having a substituent including two or more silicon atoms in a side chain and a constitutional unit having a polyalkyleneoxy group in a side chain.

Examples of the constitutional unit having a substituent containing two or more silicon atoms in the side chain include a group having two or more structures represented by Formula (a1) and preferably a constitutional unit having a group represented by Formula (a2) in the side chain.

Specifically, the constitutional unit having a substituent containing two or more silicon atoms in the side chain is preferably a constitutional unit represented by Formula (a3).

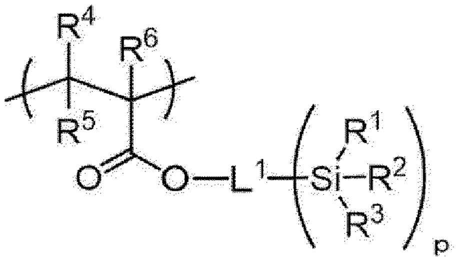
(a3)

In Formula (a3), $R^1$, $R^2$, and $R^3$ each independently represent an alkyl group, an alkenyl group, an aryl group, or an alkylene aryl group, $R^4$ and $R^5$ each independently represent a hydrogen atom or an alkyl group, $R^6$ represents a hydrogen atom or a monovalent substituent, $L^1$ represents a p+1-valent linking group, and p represents an integer of 2 to 12.

$R^1$, $R^2$, and $R^3$ in Formula (a3) have the same meanings as $R^1$, $R^2$, and $R^3$ in Formula (a1), and preferred aspects thereof are also the same.

Examples of the alkyl group represented by $R^4$ and $R^5$ include a linear alkyl group having 1 to 18 carbon atoms, and a branched or cyclic alkyl group having 3 to 18 carbon atoms. Specific examples the alkyl group described above include a methyl group, an ethyl group, a propyl group, a butyl group, an isopropyl group, a tert-butyl group, a cyclohexyl group, and the like.

$R^4$ and $R^5$ are preferably a hydrogen atom.

Examples of the monovalent substituent represented by $R^6$ include an alkyl group, an alkenyl group, and an aryl group. The alkyl group, the alkenyl group, and the aryl group are the same as the alkyl group, the alkenyl group, and the aryl

group represented by $R^1$, $R^2$, and $R^3$, respectively, and preferred aspects thereof are also the same.

$R^6$ is preferably a hydrogen atom or a methyl group.

Examples of the p+1-valent linking group represented by $L^1$ include a p+1-valent hydrocarbon group having 1 to 10 carbon atoms. As the p+1-valent linking group, a hydrocarbon group in which a part of carbon atoms constituting the hydrocarbon group are substituted with heteroatoms is also suitably used. As the hydrocarbon group, a saturated hydrocarbon group is preferable. Here, examples of the heteroatom substituting a part of the carbon atom include a silicon atom, an oxygen atom, and a nitrogen atom, and among these, a silicon atom or an oxygen atom is preferable.

The p+1-valent linking group represented by $L^1$ is preferably a branched saturated hydrocarbon group, and is also preferably a branched saturated hydrocarbon group in which a part of carbon atoms constituting the branched saturated hydrocarbon group are substituted with a heteroatom (preferably, a silicon atom and an oxygen atom).

p is an integer of 2 to 12, and is preferably an integer of 3 to 12.

Specific examples of the monomer unit for forming a constitutional unit having a substituent containing two or more silicon atoms in the side chain include monomers represented by K-1 to K-12. Specific examples of the monomer unit forming the constitutional unit having a substituent containing two or more silicon atoms in the side chain are not limited thereto.

In the following structures, n is an integer of 2 to 1,000.

K-1

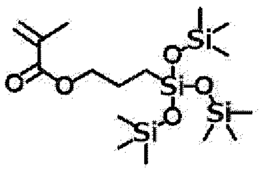

K-2

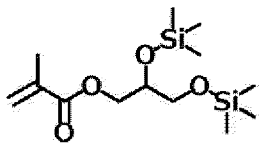

K-3

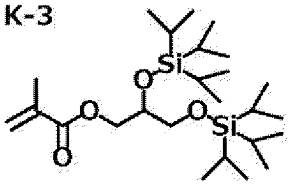

K-4

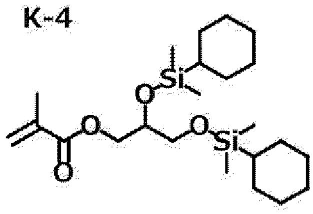

K-5

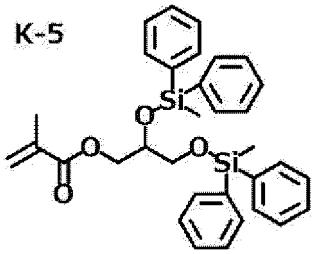

K-6

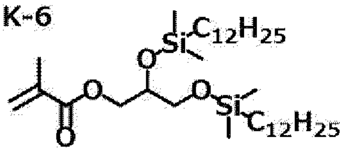

K-7

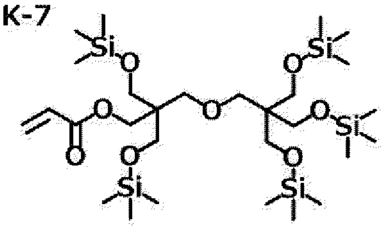

K-8

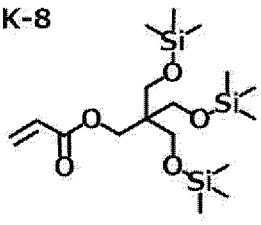

K-9

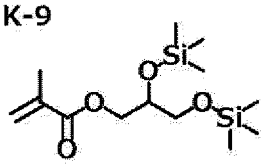

K-10

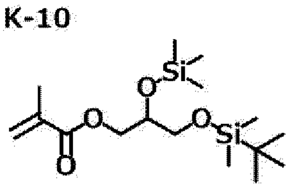

K-11

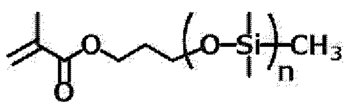

K-12

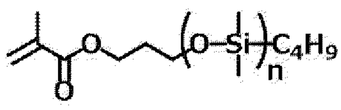

The constitutional unit having a hydrophilic group in a side chain, which is contained in the (meth)acrylic polymer A, is preferably a constitutional unit represented by Formula (a4).

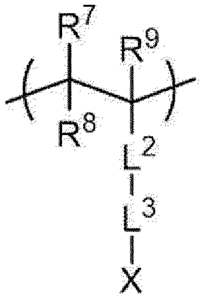 (a4)

In Formula (a4), $R^7$ and $R^8$ each independently represent a hydrogen atom or an alkyl group, $R^9$ represents a hydrogen atom or a monovalent substituent, $L^2$ represents -C(=O)-O- or -C(=O)-NH-, $L^3$ represents a single bond or a divalent linking group, and X represents a hydrophilic group.

The alkyl group represented by $R^7$ and $R^8$ is the same as the alkyl group represented by $R^4$ and $R^5$ in Formula (a3), and preferred aspects thereof are also the same.

The monovalent substituent represented by $R^9$ is the same as the monovalent substituent represented by $R^6$ in Formula (a3), and a preferred aspect thereof is also the same.

The divalent linking group represented by $L^3$ is not particularly limited as long as it is a group that can link $L^2$ and X. Examples of the divalent linking group represented by $L^3$ include an alkylene group. The alkylene group is preferably an alkylene group having 2 to 10 carbon atoms, and more preferably an alkylene group having 4 to 8 carbon atoms.

Examples of the hydrophilic group represented by X include a hydroxyl group, a phosphoric acid group, a polyalkyleneoxy group, and a group obtained by combining two or more of these groups. Here, examples of the polyalkyleneoxy group include a polyethyleneoxy group, a polypropyleneoxy group, a polybutyleneoxy group, and a group obtained by combining these groups.

Specific examples of the monomer unit for forming the constitutional unit having a hydrophilic group in the side chain include a monomer (monomer) represented by H-1 to H-25. Specific examples of the monomer unit that forms the constitutional unit having a hydrophilic group in the side chain are not limited thereto.

In the following structures, n and m are each independently an integer of 2 to 100.

In the following structures, the description of "random" means that a plurality of polyalkyleneoxy groups are randomly arranged.

H-1

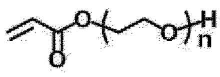

H-2

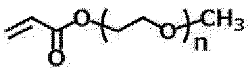

H-3

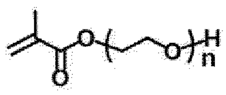

H-4

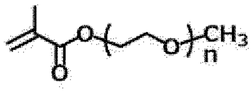

H-5

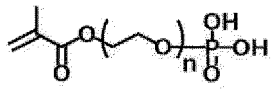

H-6

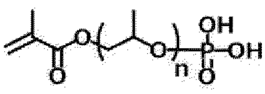

H-7

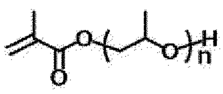

H-8

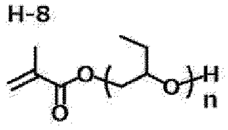

H-9

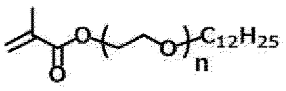

H-10

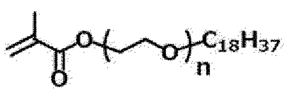

H-11

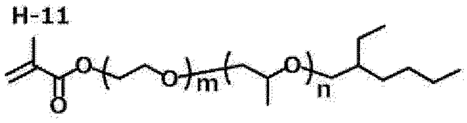

H-12

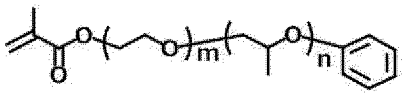

H-13
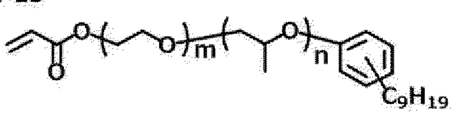
H-14
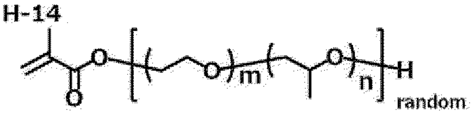

H-15
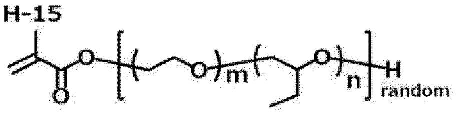
H-16
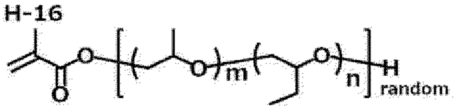

H-17
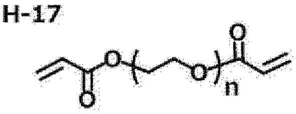
H-18
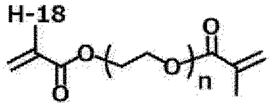
H-19
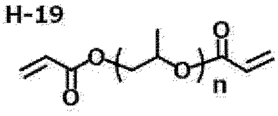

H-20
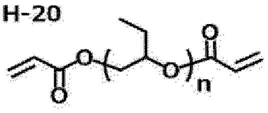
H-21
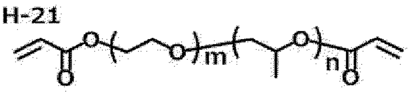
H-22
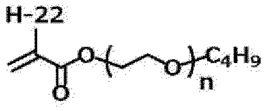

H-23
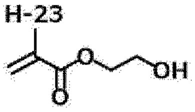
H-24
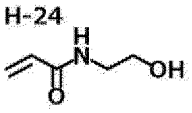
H-25
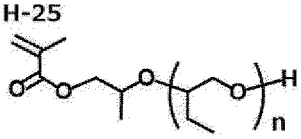

H-26
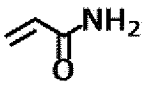
H-27
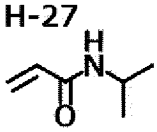
H-28
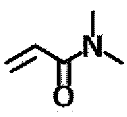
H-29
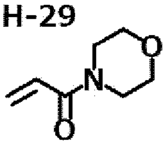

H-30
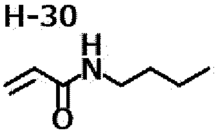
H-31
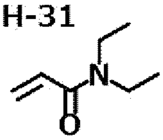
H-32
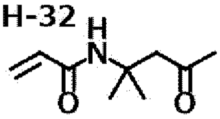

H-33
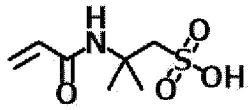
H-34
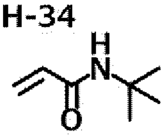
H-35
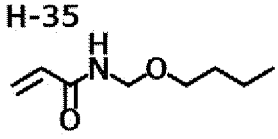

H-36
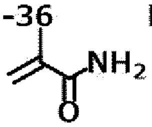
H-37
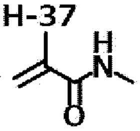
H-38
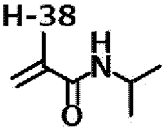
H-39
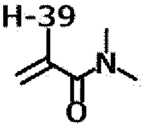
H-40
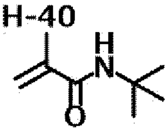

The (meth)acrylic polymer A may include one kind of constitutional unit having a substituent including two or more silicon atoms in the side chain alone, or may include two or more kinds thereof.

In the (meth)acrylic polymer A, the content of the constitutional unit having a substituent containing two or more silicon atoms in the side chain may be 100% by mass, preferably 15% by mass to 70% by mass, more preferably 20% by mass to 60% by mass, and still more preferably 25% by mass to 50% by mass, with respect to the mass of the (meth)acrylic polymer A.

In addition, the (meth)acrylic polymer A may include only one kind of the constitutional unit having a hydrophilic

group in the side chain, or may include two or more kinds thereof.

In the (meth)acrylic polymer A, the content of the constitutional unit having a hydrophilic group in the side chain is preferably 30% by mass to 85% by mass, more preferably 40% by mass to 80% by mass, and still more preferably 50% by mass to 75% by mass with respect to the mass of the (meth)acrylic polymer A.

The (meth)acrylic polymer A may further include other constitutional units.

Examples of the other constitutional unit include a constitutional unit having a carboxylic acid group in the side chain. Examples of the constitutional unit having a carboxylic acid group in the side chain include (meth)acrylic acid, itaconic acid, an itaconic acid derivative, and the like. It is preferable that the constitutional unit having a carboxylic acid group in the side chain is included as a constitutional unit different from the above-mentioned constitutional unit having a hydrophilic group in the side chain.

Examples of the other constitutional units include alkyl (meth)acrylate (the number of carbon atoms in the alkyl group is 1 to 24), a styrene derivative, maleic acid anhydride, maleimide anhydride, (meth)acrylonitrile, a vinyl ether derivative, an alkyl (meth)acrylamide derivative, and the like.

In the (meth)acrylic polymer A, the content of the other constitutional units is preferably 0% by mass to 20% by mass with respect to the mass of the (meth)acrylic polymer A.

From the viewpoint of obtaining an image-recording layer having an excellent surface state, the weight-average molecular weight of the (meth)acrylic polymer A is preferably in a range of 5,000 to 100,000 and more preferably in a range of 8,000 to 60,000.

Specific examples of the (meth)acrylic polymer A include P-1 to P-10 shown in Examples described later. Specific examples of the (meth)acrylic polymer A are not limited thereto.

The content of the (meth)acrylic polymer A is preferably 0.001% by mass to 0.1% by mass and more preferably 0.002% by mass to 0.01% by mass with respect to the total mass of the coating liquid for an image-recording layer.

[Polymer B]

The polymer B has a constitutional unit (b1) represented by Formula (I).

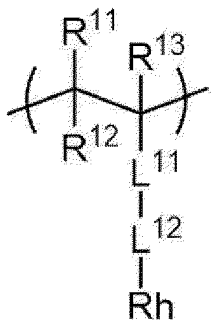

(I)

In Formula (I), $R^{11}$ and $R^{12}$ each independently represent a hydrogen atom or an alkyl group, $R^{13}$ represents a hydrogen atom or a monovalent substituent, $L^{11}$ and $L^{12}$ each independently represent a single bond or a divalent linking group, and Rh represents a substituent containing two or more silicon atoms.

The alkyl group represented by $R^{11}$ and $R^{12}$ is the same as the alkyl group represented by $R^4$ and $R^5$ in Formula (a3), and preferred aspects thereof are also the same.

The monovalent substituent represented by $R^{13}$ is the same as the monovalent substituent represented by $R^6$ in Formula (a3), and a preferred aspect thereof is also the same.

Examples of the divalent linking group represented by $L^{11}$ include -C(=O)-O-(so-called ester bond) and -C(=O)-NH-.

The divalent linking group represented by $L^{11}$ is preferably -C(=O)-O-, which is an ester bond.

The divalent linking group represented by $L^{12}$ is not particularly limited as long as it is a group that can link $L^{11}$ and Rh. Examples of the divalent linking group represented by $L^{12}$ include an alkylene group. The alkylene group is the same as the alkylene group in $L^3$ of Formula (a4), and the preferred aspect thereof is also the same.

The substituent containing two or more silicon atoms represented by Rh is the same as the substituent containing two or more silicon atoms in the (meth)acrylic polymer A, and the same applies to the preferred aspect thereof.

Specifically, Rh in Formula (I) is preferably a group including two or more structures represented by Formula (Ia).

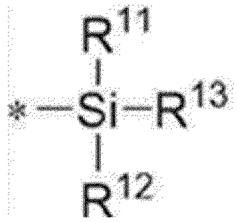

(Ia)

In Formula (Ia), * represents a bonding position, and $R^{11}$, $R^{12}$, and $R^{13}$ each independently represent an alkyl group, an alkenyl group, an aryl group, or an alkylene aryl group.

Here, Formula (Ia) has the same meaning as Formula (a1) in the (meth)acrylic polymer A, and the same applies to the preferred aspect thereof.

Specific examples of the constitutional unit (b1) represented by Formula (I) include constitutional units derived from monomers represented by K-1 to K-12, which are specific examples of constitutional units having a substituent containing two or more silicon atoms in a side chain in the (meth)acrylic polymer A. Specific examples of the constitutional unit (b1) represented by Formula (I) are not limited thereto.

The polymer B preferably further has a constitutional unit having a hydrophilic group in a side chain.

In one aspect, the constitutional unit having a hydrophilic group in the side chain is preferably a constitutional unit having a polyalkyleneoxy group in the side chain. That is, in one aspect, the polymer B is preferably a copolymer further having the constitutional unit (b2) having a polyalkyleneoxy group in the side chain.

The constitutional unit having a hydrophilic group in the side chain in the polymer B is the same as the constitutional unit having a hydrophilic group in the side chain in the (meth)acrylic polymer A, and the preferred aspect thereof is also the same.

That is, examples of another aspect of the constitutional unit having a hydrophilic group in the side chain in the polymer B include the constitutional unit represented by Formula (a4).

In Formula (a4), the preferred aspects of $R^7$, $R^8$, $R^9$, $L^2$, $L^3$, and X are as described above.

In a case where the constitutional unit having a hydrophilic group in the side chain in the polymer B is a constitutional unit represented by Formula (a4), $L^2$ represents -C(=O)-O- or -C(=O)-NH-, and among these, -C(=O)-NH- is preferable.

In addition, in a case where the constitutional unit having a hydrophilic group in the side chain in the polymer B is a constitutional unit represented by Formula (a4), preferred examples of the hydrophilic group represented by X in Formula (a4) include a hydroxyl group, a polyalkyleneoxy group, and a group obtained by combining two or more of these groups.

Specific examples of the constitutional unit having a hydrophilic group in the side chain in the polymer B include constitutional units derived from monomers represented by H-1 to H-40, which are specific examples of constitutional units having a hydrophilic group in the side chain in the (meth)acrylic polymer A. Specific examples of the constitutional unit having a hydrophilic group in the side chain in the polymer B are not limited thereto.

The polymer B may contain only one constitutional unit (b1) represented by Formula (I), or two or more thereof.

In the polymer (I), the content of the constitutional unit (b1) represented by Formula (I) may be 100% by mass with respect to the mass of the polymer B, and is preferably 15% by mass to 70% by mass, more preferably 20% by mass to 60% by mass, and even more preferably 25% by mass to 50% by mass with respect to the mass of the polymer B.

In addition, in a case where the polymer B includes a constitutional unit having a hydrophilic group in a side chain, the polymer B may include one kind of constitutional unit having a hydrophilic group in a side chain, which is selected from the constitutional unit (b2) having a hydrophilic group in a side chain and the constitutional unit (a4) having a hydrophilic group in a side chain, or may include two or more kinds thereof.

In the polymer B, the content of the constitutional unit having a hydrophilic group in the side chain is preferably 30% by mass to 85% by mass, more preferably 40% by mass to 80% by mass, and still more preferably 50% by mass to 75% by mass with respect to the mass of the polymer B.

The polymer B may further include other constitutional units.

Examples of the other constitutional unit include a constitutional unit having a carboxylic acid group in the side chain. Examples of the constitutional unit having a carboxylic acid group in the side chain include (meth)acrylic acid, itaconic acid, an itaconic acid derivative, and the like. It is preferable that the constitutional unit having a carboxylic acid group in the side chain is included as a constitutional unit different from the above-mentioned constitutional unit having a hydrophilic group in the side chain.

Examples of the other constitutional units include alkyl (meth)acrylate (the number of carbon atoms in the alkyl group is 1 to 24), a styrene derivative, maleic acid anhydride, maleimide anhydride, (meth)acrylonitrile, a vinyl ether derivative, an alkyl (meth)acrylamide derivative, and the like.

In the polymer B, the content of the other constitutional units is preferably 0% by mass to 20% by mass with respect to the mass of the polymer B.

From the viewpoint of obtaining an image-recording layer having excellent surface state, the weight-average molecular weight of the polymer B is preferably 5,000 to 100,000 and more preferably 8,000 to 60,000.

Specific examples of the polymer B include P-1 to P-10 shown in Examples described later. Specific examples of the polymer B are not limited thereto.

The content of the polymer B is preferably 0.001% by mass to 0.1% by mass and more preferably 0.002% by mass to 0.01% by mass with respect to the total mass of the coating liquid for an image-recording layer.

The lithographic printing plate precursor according to the embodiment of the present disclosure is not particularly limited as long as it has the image-recording layer containing the (meth)acrylic polymer A or the polymer B described above.

The lithographic printing plate precursor according to the embodiment of the present disclosure may be a positive tone lithographic printing plate precursor or a negative tone lithographic printing plate precursor. Among these, from the viewpoint of further exhibiting the effects of the present disclosure, the lithographic printing plate precursor according to the present disclosure is preferably a negative tone lithographic printing plate precursor.

In addition, since the lithographic printing plate precursor according to the present disclosure exhibits excellent on-press developability as described above, the lithographic printing plate precursor is preferably an on-press development type lithographic printing plate precursor.

Hereinafter, each of the configuration requirements in the lithographic printing plate precursor according to the present disclosure will be specifically described.

<Image-recording layer>

The image-recording layer used in the present disclosure may be a positive tone image-recording layer or a negative tone image-recording layer as long as it contains the above-described (meth)acrylic polymer A or polymer B. Among these, from the viewpoint of further exhibiting the effects of the present disclosure, the image-recording layer is preferably a negative tone image-recording layer.

Examples of the image-recording layer used in the present disclosure may include thermal positive type image-recording layers described in JP1995-285275A (JP-H07-285275A) and JP2003-345014A, thermal negative type image-recording layers described in JP1995-020625A (JP-H07-020625A) and JP1999-218903A (JP-H11-218903A), and photopolymer negative type image-recording layers described in JP2001-100412A, JP2002-169282A and JP2008-015504A.

Further, the image-recording layer used in the present disclosure is preferably a water-soluble or water-dispersible negative tone image-recording layer. In addition, in the lithographic printing plate precursor according to the present disclosure, from the viewpoint of on-press developability, a non-exposed portion of the image-recording layer is preferably removable by at least any of dampening water or printing ink.

Hereinafter, a negative tone image-recording layer suitable for an on-press development type lithographic printing plate precursor will be described in detail as an example.

The negative tone image-recording layer suitable for the on-press development type lithographic printing plate precursor preferably contains, for example, an infrared absorber, a polymerization initiator, a polymerizable compound, a color developing agent, particles, and other components, in addition to the above-described (meth)acrylic polymer A or polymer B.

[Infrared absorber]

The infrared absorber is not particularly limited, and examples thereof include pigments and dyes.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine dye, a squarylium colorant, a pyrylium salt, a nickel thiolate complex, and an indolenine cyanine dye are preferable. A cyanine dye or an indolenine cyanine dye is more preferable. Among these, a cyanine dye is particularly preferable.

The aforementioned infrared absorber is preferably a cationic polymethine colorant having an oxygen atom, a nitrogen atom, or a halogen atom at the meso-position. Preferred examples of the cationic polymethine colorant include a cyanine dye, a pyrylium colorant, a thiopyrylium colorant, an azulenium colorant, and the like. From the viewpoint of ease of availability, solubility in a solvent during an introduction reaction, and the like, a cyanine dye is preferable.

Specific examples of the cyanine dye include the compounds described in paragraphs "0017" to "0019" of JP2001-133969A and the compounds described in paragraphs "0016" to "0021" of JP2002-023360A and paragraphs

"0012" to "0037" of JP2002-040638A. As the cyanine dye, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

Furthermore, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" to " 0076" of JP2008-195018A are preferable.

In addition, as the aforementioned infrared absorber, a decomposable compound that decomposes due to exposure to infrared, which will be described later as a discoloring compound of the outermost layer, is also suitably used.

From the viewpoint of printing durability, the highest occupied molecular orbital (HOMO) of the infrared absorber is preferably -5.250 eV or less, more preferably -5.30 eV or less, even more preferably -5.80 eV or more and -5.35 eV or less, and particularly preferably -5.65 eV or more and -5.40 eV or less.

From the viewpoint of temporal stability, sensitivity improvement, and UV printing durability, the lowest unoccupied molecular orbital (LUMO) of the infrared absorber is preferably less than -3.70 eV, more preferably less than -3.80 eV, even more preferably -4.20 eV or more and less than -3.80 eV, and particularly preferably -4.00 eV or more and less than -3.80 eV.

One infrared absorber may be used alone, or two or more infrared absorbers may be used in combination.

In addition, as the infrared absorber, a pigment and a dye may be used in combination.

The content of the infrared absorber with respect to the total mass of the image-recording layer is preferably 0.1% by mass to 10.0% by mass, and more preferably 0.5% by mass to 5.0% by mass.

[Polymerization initiator]

The polymerization initiator is not particularly limited and a well-known polymerization initiator can be used.

The polymerization initiator preferably includes an electron-donating polymerization initiator, and more preferably includes an electron-accepting polymerization initiator and an electron-donating polymerization initiator.

[Electron-donating polymerization initiator (polymerization aid)]

The electron-donating polymerization initiator is a compound which donates one electron by intermolecular electron migration to an orbit of an infrared absorber that has lost one electron in a case where electrons of the infrared absorber are excited or perform intramolecular migration by infrared exposure, and thus generates polymerization initiation species such as radicals.

The electron-donating polymerization initiator is preferably an electron-donating radical polymerization initiator.

The electron-donating polymerization initiator preferably includes a boron compound, more preferably includes a borate compound, even more preferably includes a tetraaryl borate compound, and particularly preferably includes a tetraphenylborate compound.

From the viewpoint of printing durability, the borate compound is preferably a tetraaryl borate compound or a monoalkyl triaryl borate compound, and more preferably a tetraaryl borate compound.

From the viewpoint of printing durability, the borate compound is preferably a tetraaryl borate compound having one or more electron-donating groups or electron withdrawing groups, and more preferably a tetraaryl borate compound having one electron-donating group or one electron withdrawing group in each aryl group.

From the viewpoint of printing durability, the electron-donating group is preferably an alkyl group or an alkoxy group, and more preferably an alkoxy group.

From the viewpoint of decomposition properties, examples of the electron withdrawing group include a halogen atom, an alkyl halide group, an acyl group, a carboxy group, and the like.

A countercation that the borate compound has is not particularly limited, but is preferably an alkali metal ion or a tetraalkyl ammonium ion and more preferably a sodium ion, a potassium ion, or a tetrabutylammonium ion.

The countercation that the borate compound has may also be a cationic polymethine colorant in the infrared absorber described in the present specification. For example, the aforementioned borate compound may be used as the countercation of the cyanine dye.

Specifically, preferred examples of the borate compound include sodium tetraphenyl borate.

Specifically, as the electron-donating polymerization initiator, for example, the following B-1 to B-9 are preferable. It goes without saying that the present disclosure is not limited thereto. In the following chemical formulas, Ph represents a phenyl group, and Bu represents an n-butyl group.

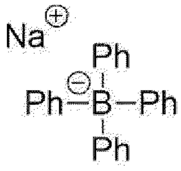

B - 1

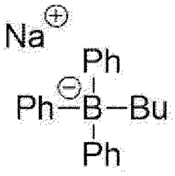

B - 2

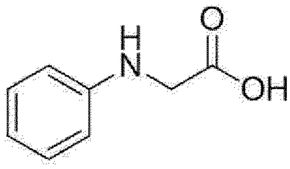

B - 3

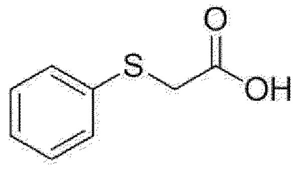

B - 4

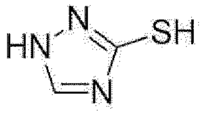

B - 5

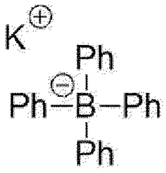

B - 6

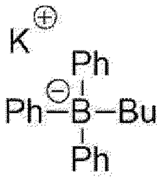

B - 7

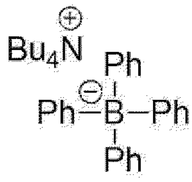

B - 8

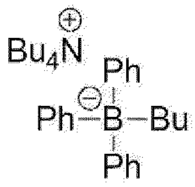

B - 9

From the viewpoint of sensitivity improvement, the highest occupied molecular orbital (HOMO) of the electron-donating polymerization initiator is preferably -6.00 eV or more, more preferably -5.95 eV or more, even more preferably -5.93 eV or more, and particularly preferably more than -5.90 eV.

The upper limit of HOMO is preferably -5.00 eV or less, and more preferably -5.40 eV or less.

One electron-donating polymerization initiator may be used alone, or two or more electron-donating polymerization initiators may be used in combination.

From the viewpoint of sensitivity and printing durability, the content of the electron-donating polymerization initiator with respect to the total mass of the image-recording layer is preferably 0.01% by mass to 30% by mass, more preferably 0.05% by mass to 25% by mass, and even more preferably 0.1% by mass to 20% by mass.

From the viewpoint of UV printing durability, the content of the electron-donating polymerization initiator in the image-recording layer is preferably higher than the content of the infrared absorber, more preferably 1.1 to 5 times the content of the infrared absorber, and particularly preferably 1.5 to 3 times the content of the infrared absorber.

In the present disclosure, the polymerization initiator may be a compound in the form of conjugate salt of an electron-donating polymerization initiator and an electron-accepting polymerization initiator.

For example, in the present disclosure, the polymerization initiator is preferably a compound in the form of a conjugate salt of an anion in the electron-donating polymerization initiator and a cation in the electron-accepting polymerization initiator, more preferably a compound in the form of a conjugate salt of an onium cation and a borate anion, even more preferably a compound in the form of a conjugate salt of an iodonium cation or sulfonium cation and a borate anion, and particularly preferably a compound in the form of a conjugate salt of a diaryliodonium cation or a triarylsulfonium cation and a tetraarylborate anion.

Preferred aspects of the anion in the electron-donating polymerization initiator and the cation in the electron-accepting polymerization initiator are the same as the preferred aspects of the anion in the aforementioned electron-donating polymerization initiator and the cation in the aforementioned electron-accepting polymerization initiator.

In a case where the image-recording layer contains an anion as an electron-donating polymerization initiator and a cation as an electron-accepting polymerization initiator (that is, in a case where the image-recording layer contains a compound in the form of a conjugate salt described above), the image-recording layer is regarded as containing an electron-accepting polymerization initiator and an electron-donating polymerization initiator.

The compound in the form of a conjugate salt of an electron-donating polymerization initiator and an electron-accepting polymerization initiator may be used as an electron-donating polymerization initiator or an electron-accepting polymerization initiator.

The compound in the form of a conjugate salt of an electron-donating polymerization initiator and an electron-accepting polymerization initiator may be used in combination with the aforementioned electron-donating polymerization initiator or used in combination with the aforementioned electron-accepting polymerization initiator.

The image-recording layer of the on-press development type lithographic printing plate precursor further contains an infrared absorber and an electron-donating polymerization initiator. From the viewpoint of sensitivity improvement and printing durability, HOMO of the infrared absorber - HOMO of the electron-donating polymerization initiator is preferably 0.70 eV or less, more preferably 0.60 eV or less, even more preferably 0.50 eV or less, and particularly preferably 0.50 eV to -0.10 eV.

The negative sign means that HOMO of the electron-donating polymerization initiator is higher than HOMO of the

infrared absorber.

In the present disclosure, the energy of molecular orbital (MO) such as the highest occupied molecular orbital (HOMO) and the lowest unoccupied molecular orbital (LUMO) is calculated by the following methods.

First, free counterions in the compound as a calculation object are excluded from the calculation object. For example, for a cationic electron-accepting polymerization initiator and a cationic infrared absorber, counteranions are excluded from the calculation object, and for an anionic electron-donating polymerization initiator, countercations are excluded from the calculation object. "Free" mentioned herein means that the compound as an object and the counterions thereof are not covalently linked to each other.

The structural optimization is carried out by DFT (B3LYP/6-31G(d)) using quantum chemical calculation software Gaussian 16.

The MO energy is calculated by DFT (B3LYP/6-31+G(d,p)/PCM (solvent = methanol)) with quantum chemical calculation software Gaussian16 by using the optimum structure obtained by the structural optimization. For an iodine-containing compound, the MO energy is calculated under the condition of DFT (B3LYP/DGDZVP/PCM (solvent = methanol)).

The optimum structure mentioned herein means a structure in which the total energy obtained by DFT calculation is the most stable. The most stable structure is found by repeating the structural optimization as necessary.

By the following formula, the MO energy Ebare (unit: hartree) obtained by the above MO energy calculation is converted into Escaled (unit: eV) used as the values of HOMO and LUMO in the present disclosure.

$$\text{[Calculation formula for HOMO] Escaled} = 0.823168 \text{ x } 27.2114 \text{ x Ebare} - 1.07634$$

$$\text{[Calculation formula for LUMO] Escaled} = 0.820139 \times 27.2114 \times \text{Ebare} - 1.086039$$

27.2114 is simply a coefficient for converting hartree into eV, and 0.823168 and -1.07634 used for calculating HOMO and 0.820139 and -1.086039 used for calculating UMO are adjustment coefficients. These are determined such that the calculated values of HOMO and LUMO of the compound as a calculation object match the measured values.

[Electron-accepting polymerization initiator]

The electron-accepting polymerization initiator is a compound which accepts an electron by intermolecular electron migration in a case where electrons of an infrared absorber are excited by infrared exposure, and generates a polymerization initiation species such as radicals.

The electron-accepting polymerization initiator is a compound that generates a polymerization initiation species such as a radical or a cation by either or both of light energy and heat energy, and can be appropriately selected from known thermal polymerization initiators, compounds having a bond that requires low bond dissociation energy, photopolymerization initiators, and the like.

The electron-accepting polymerization initiator is preferably a radical polymerization initiator and more preferably an onium salt compound.

In addition, as the electron-accepting polymerization initiator, an infrared-ray-sensitive polymerization initiator is preferable.

From the viewpoint of sensitivity improvement and UV printing durability, the electron-accepting polymerization initiator is preferably an iodonium salt compound or a compound having an alkyl halide group, and more preferably a compound having an alkyl halide group.

In addition, from the viewpoint of sensitivity improvement and UV printing durability, the compound having an alkyl halide group is preferably a compound having a perhalogenoalkylsulfonyl group, more preferably a compound having a trihalogenomethylsulfonyl group, and particularly preferably a compound having a tribromomethylsulfonyl group.

Among the above electron-accepting polymerization initiators, from the viewpoint of curing properties, an oxime ester compound and an onium salt compound are preferable. Particularly, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

Specific examples of these compounds will be shown below, but the present disclosure is not limited thereto.

As the iodonium salt compound, for example, a diaryliodonium salt compound is preferable. Particularly, an electron-donating group, for example, a diphenyl iodonium salt compound substituted with an electron-donating group such as an alkyl group or an alkoxyl group is more preferable. Furthermore, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate bis(4-t-butylphenyl)iodonium=hexafluorophosphate.

Examples of counteranions of the iodonium salt compound and the sulfonium salt compound include a sulfonate anion, a carboxylate anion, a tetrafluoroborate anion, a hexafluorophosphate anion, a p-toluene sulfonate anion, a tosylate anion, a sulfonamide anion, and a sulfonimide anion.

Among the above, a sulfonamide anion or a sulfonimide anion is preferable, and a sulfonimide anion is more preferable.

As the sulfonamide anion, an aryl sulfonamide anion is preferable.

As the sulfonimide anion, a bisaryl sulfonimide anion is preferable.

Specific examples of the sulfonamide anion and the sulfonimide anion include those described in WO2019/013268A.

From the viewpoint of developability, and UV printing durability of the lithographic printing plate to be obtained, the aforementioned electron-accepting polymerization initiator preferably includes a compound represented by Formula (II) or Formula (III), and particularly preferably includes a compound represented by Formula (II).

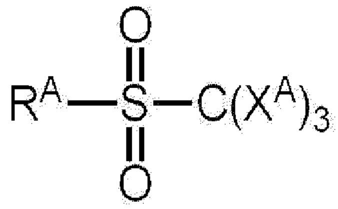
(II)

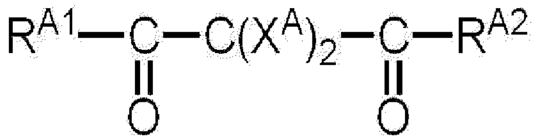
(III)

In Formula (II) and Formula (III), $X^A$ represents a halogen atom, and $R^A$, $R^{A1}$, and $R^{A2}$ each independently represent a monovalent hydrocarbon group having a carbon number of 1 to 20.

$R^A$ in Formula (II) is preferably an aryl group.

Examples of $X^A$ in Formula (II) and Formula (III) include a fluorine atom, a chlorine atom, a bromine atom, and an iodine atom. Among these, a chlorine atom or a bromine atom is preferable because these have excellent sensitivity, and a bromine atom is particularly preferable.

$R^A$, $R^{A1}$, and $R^{A2}$ in Formula (II) and Formula (III) preferably each independently represent an aryl group. Particularly, from the viewpoint of excellent balance between sensitivity and storage stability, $R^A$, $R^{A1}$, and $R^{A2}$ more preferably each independently represent an aryl group substituted with an amide group.

The aforementioned electron-accepting polymerization initiator particularly preferably includes a compound represented by Formula (IV).

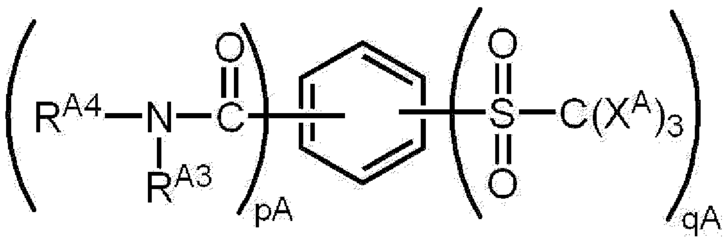
(IV)

In Formula (IV), $X^A$ represents a halogen atom, $R^{A3}$ and $R^{A4}$ each independently represent a hydrogen atom or a monovalent hydrocarbon group having a carbon number of 1 to 20, and pA and qA each independently represent an integer of 1 to 5. Here, pA + qA = 2 to 6.

Specific examples of the electron-accepting polymerization initiator include compounds represented by the following formulas. However, the present disclosure is not limited thereto.

In the following structures, "Et" represents an ethyl group, "nPr" represents an n-propyl group, "nBu" represents an n-butyl group, "Ph" represents a phenyl group, and "cHex" represents a cyclohexyl group.

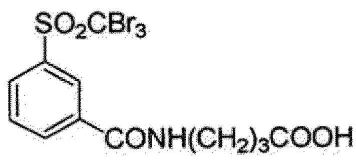
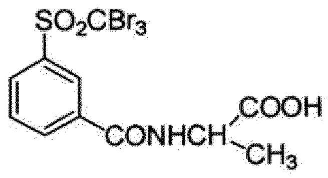
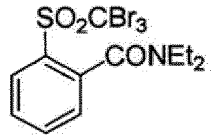

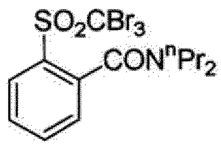
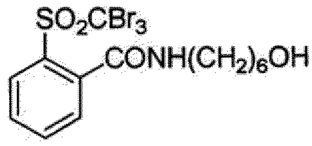
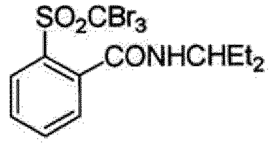

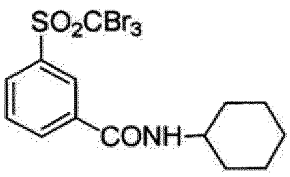
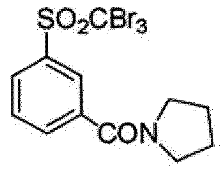
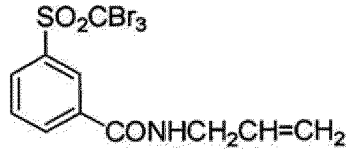

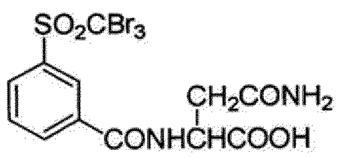
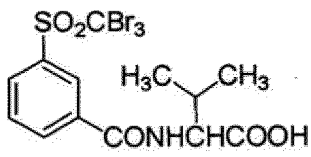
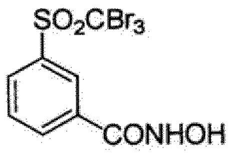

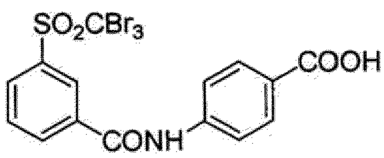
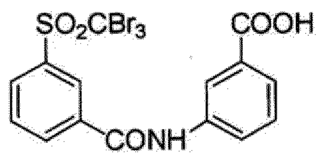
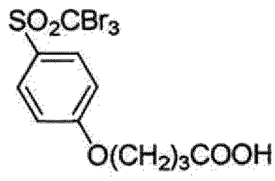

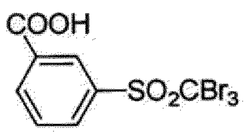
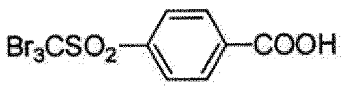
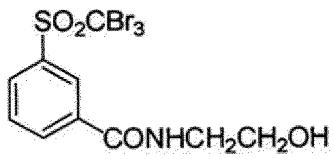

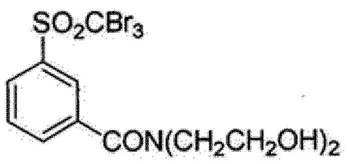
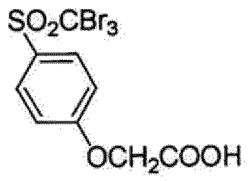
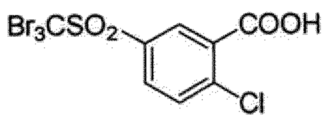

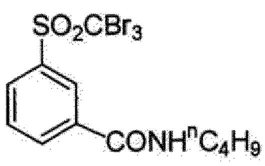
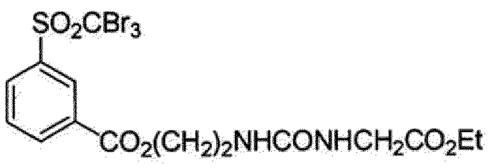

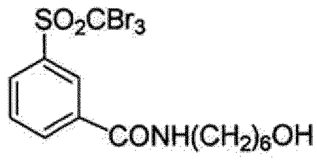
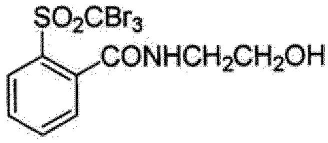
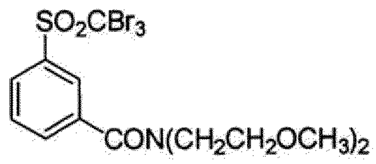
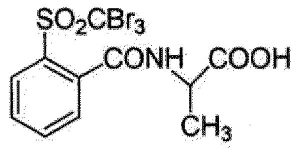
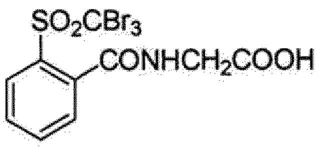
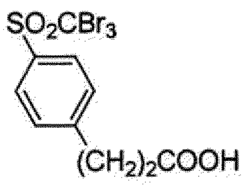
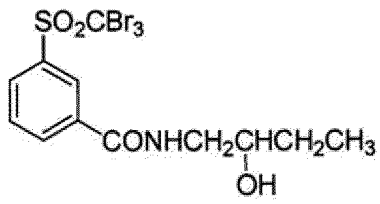
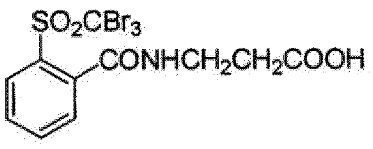
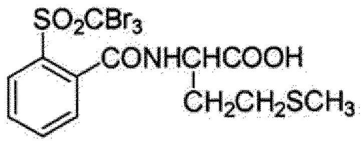
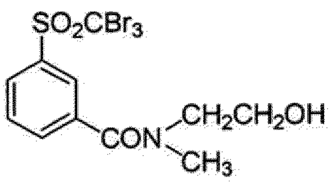
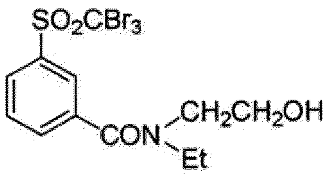
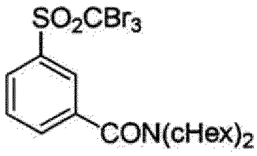
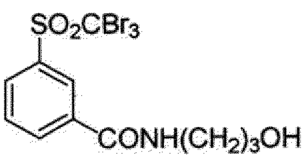
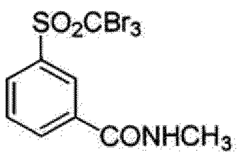
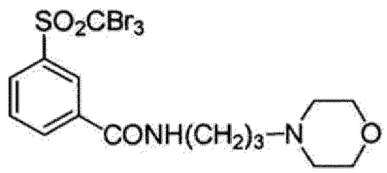
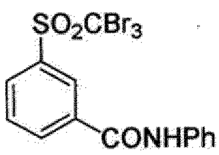
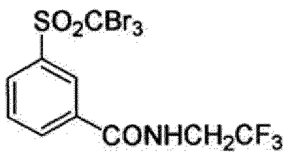
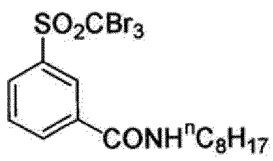
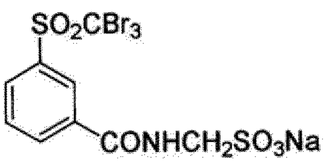
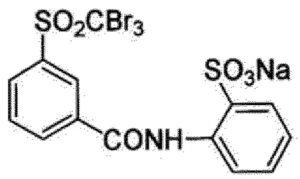
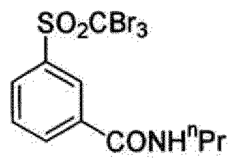

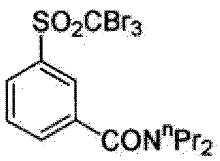
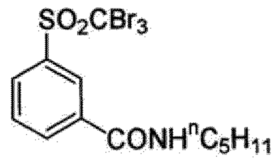
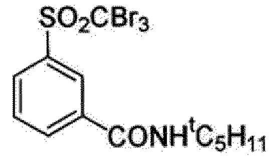

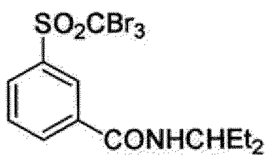
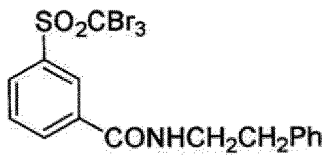
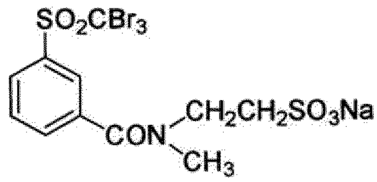

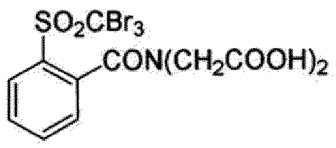
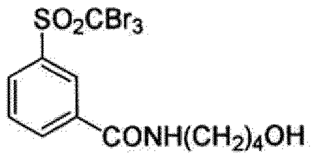

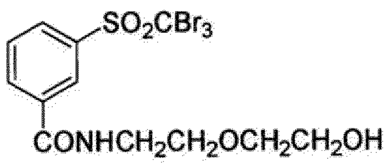
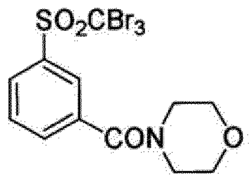
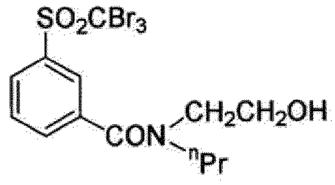

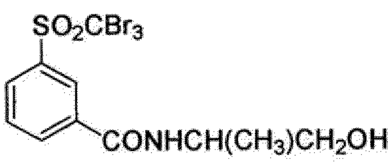
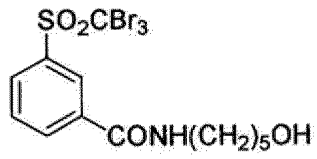

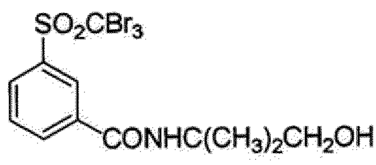
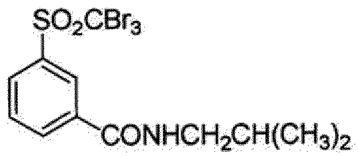

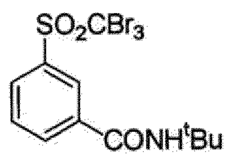
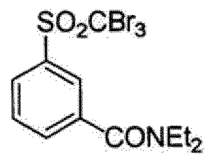
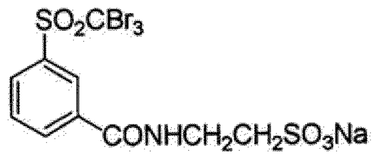

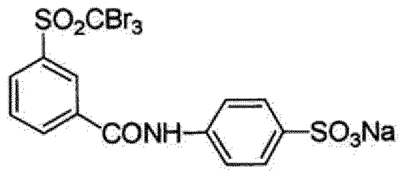
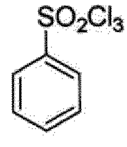
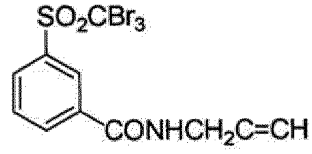

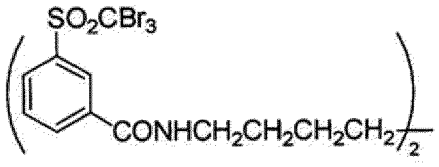 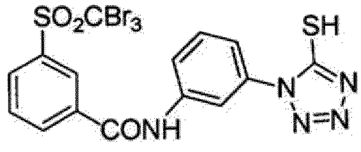

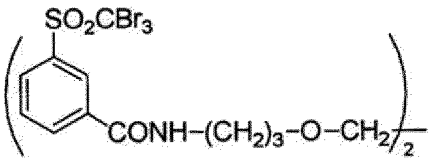 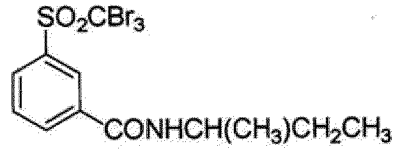

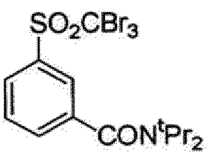 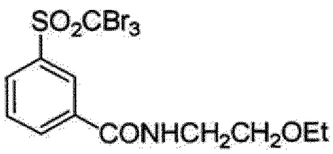 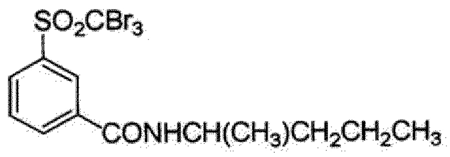

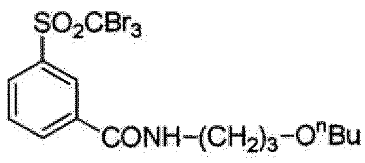 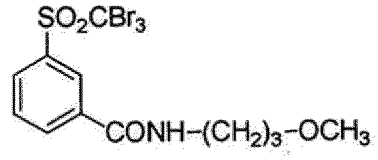

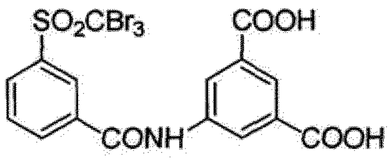 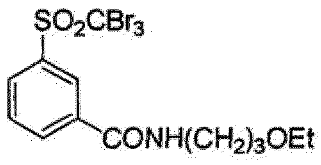

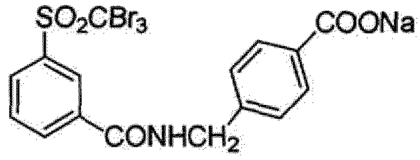 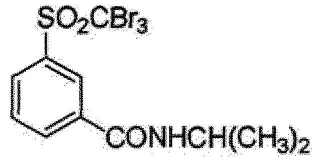

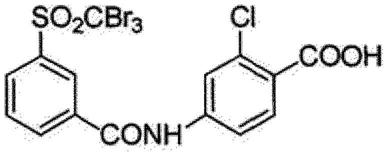 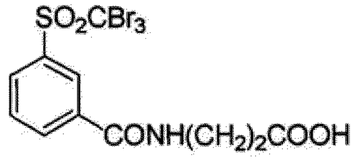

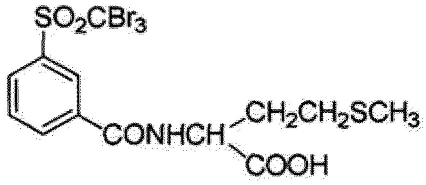 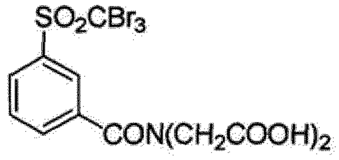

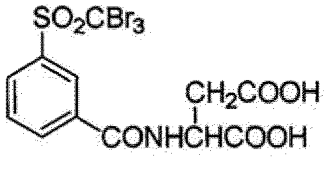
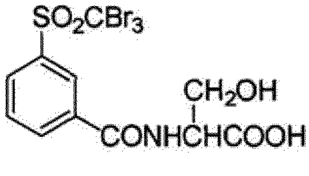
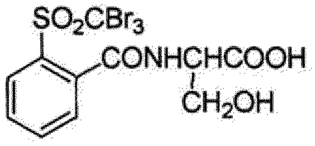

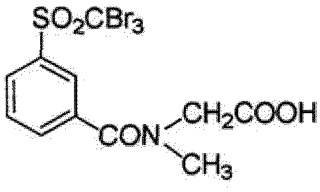
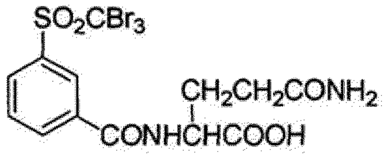
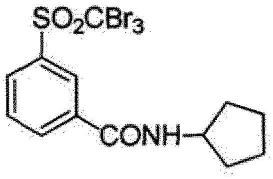

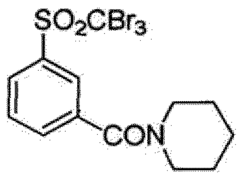
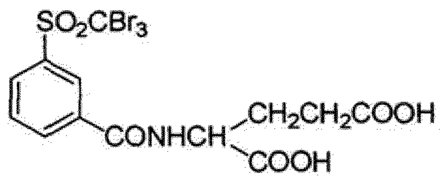

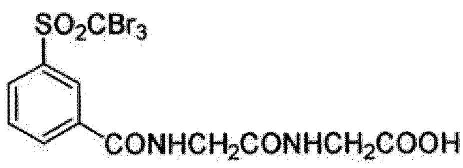
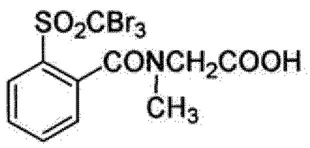

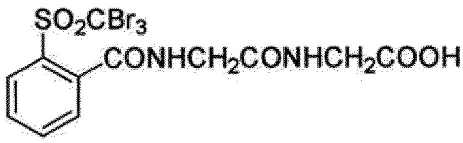
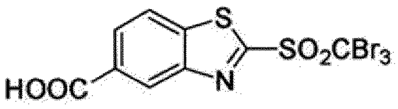

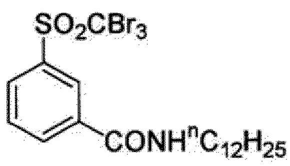
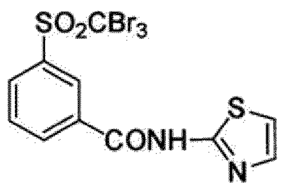
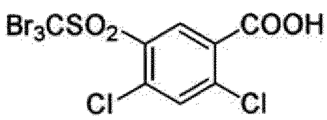

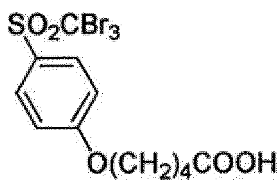
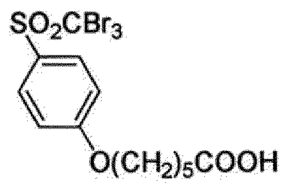

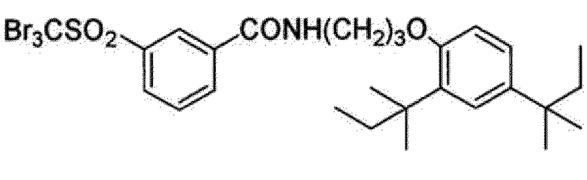
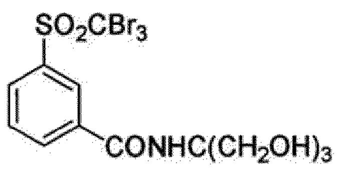

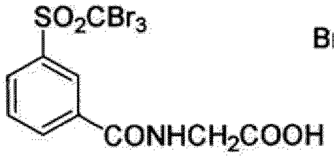

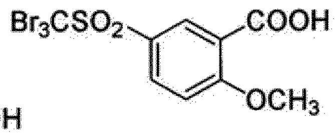

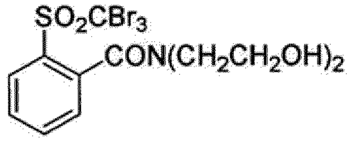

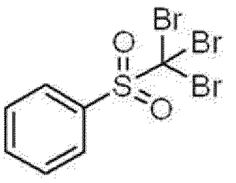

(IS-1)

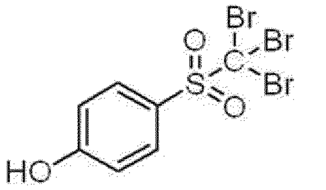

(IS-2)

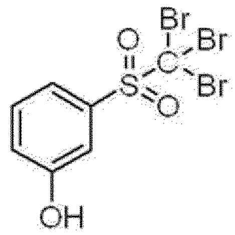

(IS-3)

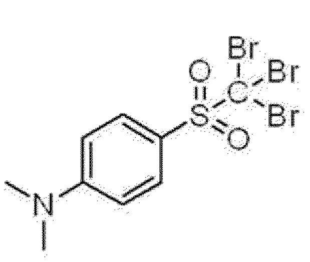

(IS-4)

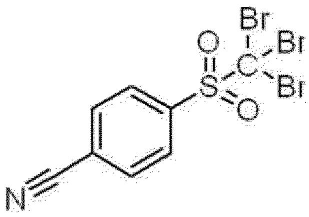

(IS-5)

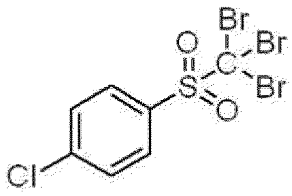

(IS-6)

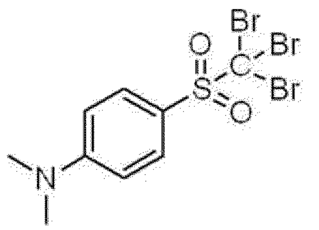

(IS-7)

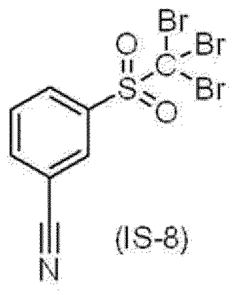

(IS-8)

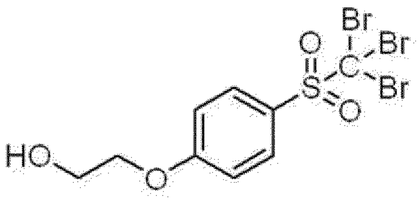

(IS-9)

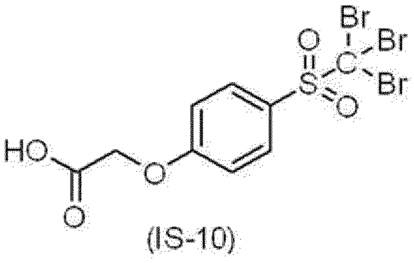

(IS-10)

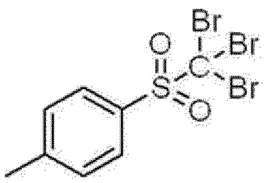

(IS-11)

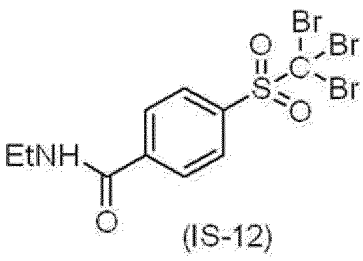

(IS-12)

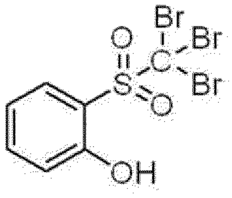

(IS-13)

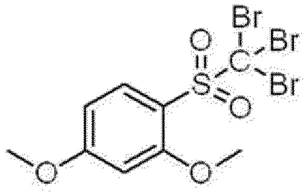

(IS-14)

From the viewpoint of improving sensitivity, the lowest unoccupied molecular orbital (LUMO) of the electron-accepting polymerization initiator is preferably -3.00 eV or less, and more preferably -3.02 eV or less.
The lower limit of LUMO is preferably -3.80 eV or more, and more preferably -3.50 eV or more.
One electron-accepting polymerization initiator may be used alone, or two or more electron-accepting polymerization initiators may be used in combination.
The content of the electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.
The image-recording layer of the on-press development type lithographic printing plate precursor further contains an infrared absorber and an electron-accepting polymerization initiator. From the viewpoint of sensitivity improvement and printing durability, LUMO of the electron-accepting polymerization initiator - LUMO of the infrared absorber is preferably 1.00 eV or less, more preferably 0.80 eV or less, even more preferably 0.70 eV or less, particularly preferably 0.70 eV to -0.10 eV or less, and most preferably 0.70 eV to 0.30 eV.
The negative sign means that LUMO of the infrared absorber is higher than LUMO of the electron-accepting polymerization initiator.

[Polymerizable compound]

In the present disclosure, a polymerizable compound refers to a compound having a polymerizable group.
The polymerizable group is not particularly limited and may be a known polymerizable group. As the polymerizable group, an ethylenically unsaturated group is preferable. The polymerizable group may be a radically polymerizable group or a cationically polymerizable group. The polymerizable group is preferably a radically polymerizable group.
Examples of the radically polymerizable group include a (meth)acryloyl group, an allyl group, a vinylphenyl group, a vinyl group, and the like. From the viewpoint of reactivity, a (meth)acryloyl group is preferable.
The molecular weight of the polymerizable compound (weight-average molecular weight in a case where the polymerizable compound has molecular weight distribution) is preferably 50 or more and less than 2,500.
The polymerizable compound used in the present disclosure may be, for example, a radically polymerizable compound or a cationically polymerizable compound. As the polymerizable compound, an addition polymerizable compound having at least one ethylenically unsaturated bond, that is, ethylenically unsaturated compound is preferable.
The ethylenically unsaturated compound is preferably a compound having at least one ethylenically unsaturated bond on a terminal, and more preferably a compound having two or more ethylenically unsaturated bonds on a terminal. The chemical form of the polymerizable compound is, for example, a monomer, a prepolymer which is in other words a dimer, a trimer, or an oligomer, a mixture of these, or the like.
Particularly, from the viewpoint of UV printing durability, the aforementioned polymerizable compound preferably includes a polymerizable compound having functionalities of 3 or more, more preferably includes a polymerizable compound having functionalities of 7 or more, and even more preferably includes a polymerizable compound having functionalities of 10 or more. Particularly, from the viewpoint of UV printing durability of the lithographic printing plate to be obtained, the aforementioned polymerizable compound preferably includes an ethylenically unsaturated compound having functionalities of 3 or more (preferably having functionalities of 7 or more and more preferably having functionalities of 10 or more), and more preferably includes a (meth)acrylate compound having functionalities of 3 or more (preferably having functionalities of 7 or more and more preferably having functionalities of 10 or more).
From the viewpoint of on-press developability and contamination suppressiveness, the aforementioned polymerizable compound preferably includes a polymerizable compound having functionalities of 2 or less, more preferably includes a difunctional polymerizable compound, and particularly preferably includes a difunctional (meth)acrylate compound.
From the viewpoint of printing durability, on-press developability, and contamination suppressiveness, the content of the polymerizable compound having functionalities of 2 or less (preferably a difunctional polymerizable compound) with respect to the total mass of polymerizable compounds in the image-recording layer is preferably 5%

by mass to 100% by mass, more preferably 10% by mass to 100% by mass, and even more preferably 50% to 100% by mass.

<<Oligomer>>

As the polymerizable compound to be incorporated into in the image-recording layer, a polymerizable compound which is an oligomer (hereinafter, also simply called "oligomer") is preferable.

In the present disclosure, an oligomer represents a polymerizable compound which has a molecular weight of 600 or more and 10,000 or less and at least one polymerizable group. Here, in a case where the oligomer has a molecular weight distribution, the molecular weight of the oligomer refers to a weight-average molecular weight.

From the viewpoint of excellent chemical resistance and excellent UV printing durability, the molecular weight of the oligomer is preferably 1,000 or more and 5,000 or less.

Furthermore, from the viewpoint of improving UV printing durability, the number of polymerizable groups in one molecule of the oligomer is preferably 2 or more, more preferably 3 or more, even more preferably 6 or more, and particularly preferably 10 or more.

The upper limit value of the number of polymerizable groups in the oligomer is not particularly limited. The number of polymerizable groups is preferably 20 or less.

From the viewpoint of UV printing durability and on-press developability, an oligomer having 7 or more polymerizable groups and a molecular weight of 1,000 or more and 10,000 or less is preferable, and an oligomer having 7 or more and 20 or less polymerizable groups and a molecular weight of 1,000 or more and 5,000 or less is more preferable.

The oligomer may contain a polymer component which may be generated in the process of producing the oligomer.

From the viewpoint of UV printing durability and on-press developability, the oligomer preferably has at least one kind of compound selected from the group consisting of a compound having a urethane bond, a compound having an ester bond, and a compound having an epoxy residue, and more preferably has a compound having a urethane bond.

**In** the present disclosure, an epoxy residue refers to a structure formed of an epoxy group. For example, the epoxy residue means a structure similar to a structure established by the reaction between an acid group (carboxylic acid group or the like) and an epoxy group.

As the compound having a urethane bond, which is an example of the oligomer, for example, a compound having at least a group represented by Formula (Ac-1) or Formula (Ac-2) is preferable, and a compound having at least a group represented by Formula (Ac-1) is more preferable.

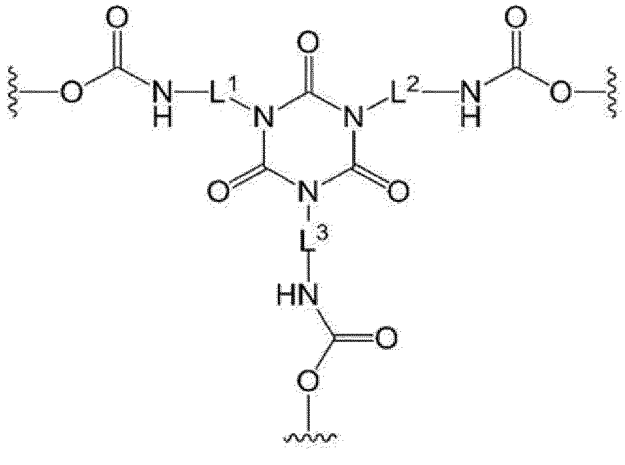

(Ac - 1)

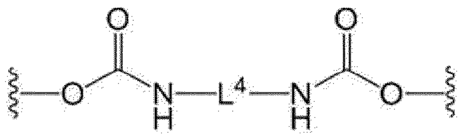

(Ac - 2)

In Formula (Ac-1) and Formula (Ac-2), $L^1$ to $L^4$ each independently represent a divalent hydrocarbon group having a carbon number of 2 to 20, and the portion of the wavy line represents a bonding position with other structures.

$L^1$ to $L^4$ preferably each independently represent an alkylene group having a carbon number of 2 to 20, more preferably each independently represent an alkylene group having a carbon number of 2 to 10, and even more preferably each independently represent an alkylene group having a carbon number of 4 to 8. The alkylene group may have a branched structure or a ring structure. The alkylene group is preferably a linear alkylene group.

The portion of the wavy line in Formula (Ac-1) or Formula (Ac-2) is preferably each independently directly bonded

to the portion of the wavy line in a group represented by Formula (Ae-1) or Formula (Ae-2).

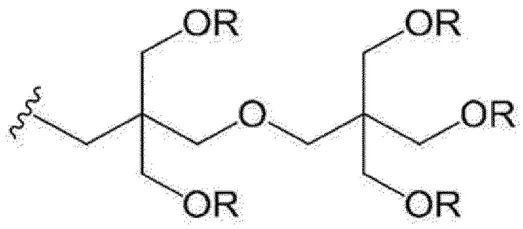

( Ae - 1 )

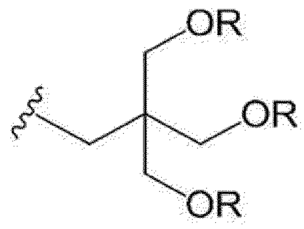

( Ae - 2 )

In Formula (Ae-1) and Formula (Ae-2), R each independently represent an acryloyloxy group or a methacryloyloxy group, and the portion of the wavy line represents a bonding position with portion of the wavy line in Formula (Ac-1) and Formula (Ac-2).

As the compound having a urethane bond, a compound may also be used which is prepared by obtaining polyurethane by a reaction between a polyisocyanate compound and a polyol compound and introducing a polymerizable group into the polyurethane by a polymer reaction.

For example, the compound having a urethane bond may be obtained by reacting a polyol compound having an acid group with a polyisocyanate compound to obtain a polyurethane oligomer and reacting this polyurethane oligomer with a compound having an epoxy group and a polymerizable group.

The number of polymerizable groups in the compound having an ester bond, which is an example of oligomer, is preferably 3 or more, and more preferably 6 or more.

As the compound having an epoxy residue, which is an example of oligomer, a compound containing a hydroxy group is preferable.

The number of polymerizable groups in the compound having an epoxy residue is preferably 2 to 6, and more preferably 2 or 3.

The compound having an epoxy residue can be obtained, for example, by reacting a compound having an epoxy group with an acrylic acid.

Specific examples of oligomers will be shown in the following tables, but the oligomer used in the present disclosure is not limited thereto.

As the oligomer, commercially available products may also be used. Examples thereof include UA510H, UA-306H, UA-306I, and UA-306T (manufactured by KYOEISHA CHEMICAL Co., LTD.), UV-1700B, UV-6300B, and UV7620EA (manufactured by The Nippon Synthetic Chemical Industry Co., Ltd.), U-15HA (manufactured by SHIN-NAKAMURA CHEMICAL Co., LTD.), EBECRYL450, EBECRYL657, EBECRYL885, EBECRYL800, EBECRYL3416, and EBECRYL860 (manufactured by DAICEL-ALLNEX LTD.), and the like. However, the oligomer is not limited to these.

From the viewpoint of improving chemical resistance and UV printing durability and suppressiveness of the residues of on-press development, the content of the oligomer with respect to the total mass of polymerizable compounds in the image-recording layer is preferably 30% by mass to 100% by mass, more preferably 50% by mass to 100% by mass, and even more preferably 80% by mass to 100% by mass.

<<Low-molecular-weight polymerizable compound>>

The polymerizable compound may further include a polymerizable compound other than the oligomer described above.

From the viewpoint of chemical resistance, the polymerizable compound other than the oligomer is preferably a low-molecular-weight polymerizable compound. The low-molecular-weight polymerizable compound may take a chemical form such as a monomer, a dimer, a trimer, or a mixture of these.

From the viewpoint of chemical resistance, the low-molecular-weight polymerizable compound is preferably at least a polymerizable compound selected from the group consisting of a polymerizable compound having three or more ethylenically unsaturated groups and a polymerizable compound having an isocyanuric ring structure.

In the present disclosure, the low-molecular-weight polymerizable compound represents a polymerizable compound having a molecular weight of 50 or more and less than 600. Here, in a case where the low-molecular-weight polymerizable compound has a molecular weight distribution, the molecular weight of the low-molecular-weight polymerizable compound refers to a weight-average molecular weight.

From the viewpoint of excellent chemical resistance, excellent UV printing durability, and excellently suppressing the residues of on-press development, the molecular weight of the low-molecular-weight polymerizable compound is

preferably 100 or more and less than 600, more preferably 300 or more and less than 600, and even more preferably 400 or more and less than 600.

In a case where the polymerizable compound includes a low-molecular-weight polymerizable compound as the polymerizable compound other than an oligomer (total amount in a case where the polymerizable compound includes two or more low-molecular-weight polymerizable compounds), from the viewpoint of chemical resistance and UV printing durability and suppressing the residues of on-press development, the ratio of the oligomer to the low-molecular-weight polymerizable compound (oligomer/low-molecular-weight polymerizable compound) is preferably 10/1 to 1/10, more preferably 10/1 to 3/7, and even more preferably 10/1 to 7/3, based on mass.

As the low-molecular-weight polymerizable compound, the polymerizable compounds described in paragraphs "0082" to "0086" of WO2019/013268A can also be suitably used.

The details of how to use the polymerizable compound, such as the structure of the compound, whether the compound is used alone or used in combination with other compounds, and the amount of the compound to be added, can be randomly set.

Particularly, from the viewpoint of UV printing durability, the image-recording layer preferably contains two or more polymerizable compounds.

The content of the polymerizable compound (total content of polymerizable compounds in a case where the image-recording layer contains two or more polymerizable compounds) with respect to the total mass of the image-recording layer is preferably 5% by mass to 75% by mass, more preferably 10% by mass to 70% by mass, and even more preferably 15% by mass to 60% by mass.

[Color developing agent]

The image-recording layer in the on-press development type lithographic printing plate precursor preferably further contains a color developing agent, and more preferably further contains an acid color developing agent. Furthermore, the color developing agent preferably includes a leuco compound.

"Color developing agent" used in the present disclosure means a compound that develops or removes color by a stimulus such as light or acid and thus changes the color of the image-recording layer. Furthermore, "acid color developing agent" means a compound that develops or removes color by being heated in a state of accepting an electron accepting compound (for example, a proton of an acid or the like) and thus changes the color of the image-recording layer. The acid color developing agent is particularly preferably a colorless compound which has a partial skeleton such as lactone, lactam, sultone, spiropyran, an ester, or an amide and allows such a partial skeleton to rapidly open the ring or to be cleaved when coming into contact with an electron accepting compound.

Examples of such an acid color developing agent include the compounds described in paragraphs "0184" to "0191" of JP2019-18412A.

Particularly, from the viewpoint of visibility, the color developing agent used in the present disclosure is preferably at least one compound selected from the group consisting of a spiropyran compound, a spirooxazine compound, a spirolactone compound, and a spirolactam compound.

From the viewpoint of visibility, the color of a colorant after color development preferably has maximum absorption in the range of 450 to 650 nm. The tint is preferably red, purple, blue, or dark green.

From the viewpoint of visibility and visibility of exposed portions, the acid color developing agent is preferably a leuco colorant.

The aforementioned leuco colorant is not particularly limited as long as it has a leuco structure. The leuco colorant preferably has a spiro structure, and more preferably has a spirolactone ring structure.

From the viewpoint of visibility and visibility of exposed portions, the leuco colorant is preferably a leuco colorant having a phthalide structure or a fluoran structure.

Furthermore, from the viewpoint of visibility and visibility of exposed portions, the leuco colorant having a phthalide structure or a fluoran structure is preferably a compound represented by any of Formula (Le-1) to Formula (Le-3), and more preferably a compound represented by Formula (Le-2).

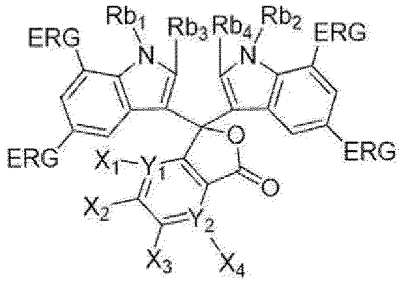

(Le-1)

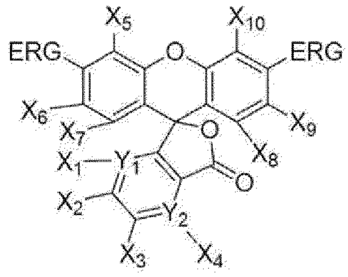

(Le-2)

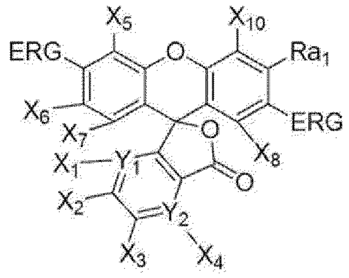

(Le-3)

In Formula (Le-1) to Formula (Le-3), ERG's each independently represent an electron-donating group, $X_1$ to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

From the viewpoint of color developability and visibility of exposed portions, the electron-donating group represented by ERG in Formula (Le-1) to Formula (Le-3) is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, or an aryloxy group, even more preferably a monoalkyl monoarylamino group, a diarylamino group, a diheteroarylamino group, or a monoaryl monoheteroarylamino group, and particularly preferably a monoalkyl monoarylamino group.

From the viewpoint of color developability and visibility of exposed portions, the electron-donating group represented by ERG is preferably a disubstituted amino group having an aryl group that has a substituent on at least one ortho position or a heteroaryl group that has a substituent on at least one ortho position, more preferably a disubstituted amino group having a substituent on at least one ortho position and a phenyl group having an electron-donating group at a para position, even more preferably an amino group having a substituent on at least one ortho position and a phenyl group having an electron-donating group at a para position and an aryl group or a heteroaryl group, and particularly preferably an amino group having a substituent on at least one ortho position, a phenyl group having an electron-donating group at a para position, and an aryl group having an electron-donating group or a heteroaryl group having an electron-donating group.

**In** the present disclosure, in a case where a bonding position of an aryl group or a heteroaryl group with other structures is defined as 1-position, the ortho position in the aryl group or heteroaryl group other than a phenyl group is called a bonding position (for example, 2-position or the like) adjacent to the 1-position.

From the viewpoint of color developability and visibility of exposed portions, the electron-donating group that the aforementioned aryl group or heteroaryl group has is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

From the viewpoints of color formability and visibility of exposed portions, $X_1$ to $X_4$ in Formula (Le-1) to Formula (Le-3) each independently are preferably a hydrogen atom or a chlorine atom, and more preferably each independently represent a hydrogen atom.

From the viewpoint of color developability and visibility of exposed portions, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, or a cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoint of color developability and visibility of exposed portions, it is preferable that at least one of $Y_1$

or $Y_2$ in Formula (Le-1) to Formula (Le-3) be C, and it is more preferable that both of $Y_1$ and $Y_2$ be C.

From the viewpoint of color developability and visibility of exposed portions, $Ra_1$ in Formula (Le-1) to Formula (Le-3) is preferably an alkyl group or an alkoxy group, more preferably an alkoxy group, and particularly preferably a methoxy group.

From the viewpoint of color developability and visibility of exposed portions, $Rb_1$ to $Rb_4$ in Formula (Le-1) to Formula (Le-3) preferably each independently represent a hydrogen atom or an alkyl group, more preferably each independently represent an alkyl group, and particularly preferably each independently represent a methyl group.

Furthermore, from the viewpoint of color developability and visibility of exposed portions, the leuco colorant having a phthalide structure or a fluoran structure is more preferably a compound represented by any of Formula (Le-4) to Formula (Le-6), and even more preferably a compound represented by Formula (Le-5).

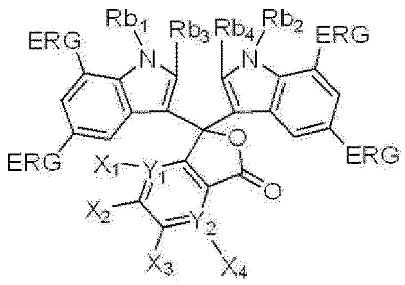
(Le-4)

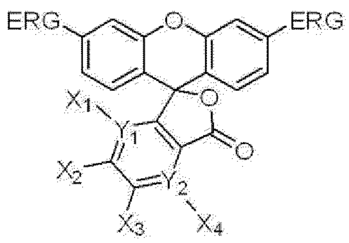
(Le-5)

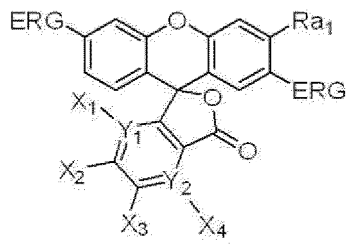
(Le-6)

In Formula (Le-4) to Formula (Le-6), ERG's each independently represent an electron-donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

ERG, $X_1$ to $X_4$, $Y_1$, $Y_2$, $Ra_1$, and $Rb_1$ to $Rb_4$ in Formula (Le-4) to Formula (Le-6) have the same definitions as ERG, $X_1$ to $X_4$, $Y_1$, $Y_2$, $Ra_1$, and $Rb_1$ to $Rb_4$ in Formula (Le-1) to Formula (Le-3) respectively, and preferred aspects thereof are also the same.

Furthermore, from the viewpoint of color developability and visibility of exposed portions, the leuco colorant having a phthalide structure or a fluoran structure is more preferably a compound represented by any of Formula (Le-7) to Formula (Le-9), and particularly preferably a compound represented by Formula (Le-8).

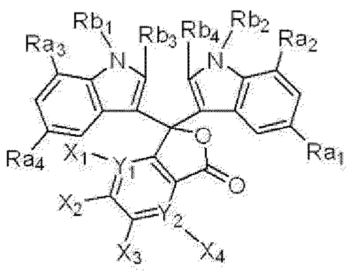
(Le-7)

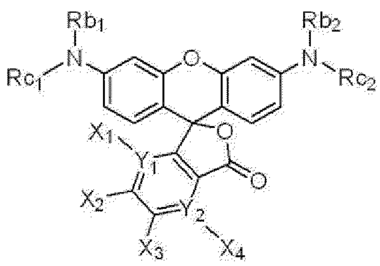
(Le-8)

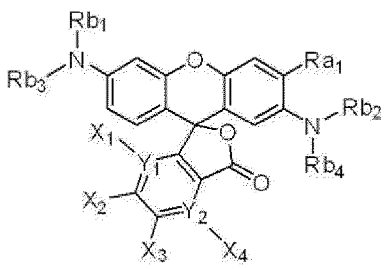
(Le-9)

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent a hydrogen atom, an alkyl group, an aryl group, or a heteroaryl group, and $Rc_1$ and $Rc_2$ each independently represent an aryl group or a heteroaryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoints of color formability and visibility of exposed portions, $Ra_1$ to $Ra_4$ in Formula (Le-7) or Formula (Le-9) each independently are preferably an alkyl group or an alkoxy group, more preferably an alkoxy group, and particularly preferably represent a methoxy group.

From the viewpoints of color formability and visibility of exposed portions, $Rb_1$ to $Rb_4$ in Formula (Le-7) to Formula (Le-9) each independently are preferably a hydrogen atom, an alkyl group, or an aryl group substituted with an alkoxy

group, more preferably an alkyl group, and particularly preferably a methyl group.

From the viewpoint of color developability and visibility of exposed portions, $Rc_1$ and $Rc_2$ in Formula (Le-8) preferably each independently represent a phenyl group or an alkylphenyl group, and more preferably each independently represent a phenyl group.

From the viewpoint of color developability and visibility of exposed portions, $Rc_1$ and $Rc_2$ in Formula (Le-8) preferably each independently represent an aryl group having a substituent on at least one ortho position or a heteroaryl group having a substituent on at least one ortho position, more preferably each independently represent an aryl group having a substituent on at least one ortho position, even more preferably each independently represent a phenyl group having a substituent on at least one ortho position, and particularly preferably each independently represent a phenyl group having a substituent on at least one ortho position and having an electron-donating group at the para position. Examples of the substituent in $Rc_1$ and $Rc_2$ include substituents that will be described later.

In Formula (Le-8), from the viewpoint of color developability and visibility of exposed portions, $X_1$ to $X_4$ preferably each represent a hydrogen atom, and $Y_1$ and $Y_2$ preferably each represent C.

Furthermore, from the viewpoint of color developability and visibility of exposed portions, in Formula (Le-8), $Rb_1$ and $Rb_2$ preferably each independently represent an alkyl group or an aryl group substituted with an alkoxy group.

From the viewpoint of color developability and visibility of exposed portions, $Rb_1$ and $Rb_2$ in Formula (Le-8) preferably each independently represent an aryl group or a heteroaryl group, more preferably each independently represent an aryl group, even more preferably each independently represent an aryl group having an electron-donating group, and particularly preferably each independently represent a phenyl group having an electron-donating group at the para position.

From the viewpoint of color developability and visibility of exposed portions, the electron-donating group in $Rb_1$, $Rb_2$, $Rc_1$, and $Rc_2$ is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

From the viewpoint of color developability and visibility of exposed portions, the acid color developing agent preferably includes a compound represented by Formula (Le-10).

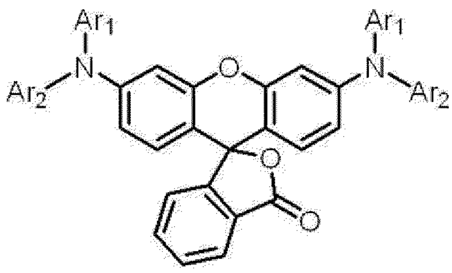

( Le - 10 )

In Formula (Le-10), $Ar_1$ each independently represent an aryl group or a heteroaryl group, and $Ar_2$ each independently represent an aryl group having a substituent on at least one ortho position or a heteroaryl group having a substituent on at least one ortho position.

$Ar_1$ in Formula (Le-10) has the same definition as $Rb_1$ and $Rb_2$ in Formula (Le-7) to Formula (Le-9), and preferred aspects thereof are also the same.

$Ar_2$ in Formula (Le-10) has the same definition as $Rc_1$ and $Rc_2$ in Formula (Le-7) to Formula (Le-9), and preferred aspects thereof are also the same.

The alkyl group in Formula (Le-1) to Formula (Le-9) may be linear or branched or may have a ring structure.

The carbon number of the alkyl group in Formula (Le-1) to Formula (Le-9) is preferably 1 to 20, more preferably 1 to 8, even more preferably 1 to 4, and particularly preferably 1 or 2.

The carbon number of the aryl group in Formula (Le-1) to Formula (Le-10) is preferably 6 to 20, more preferably 6 to 10, and particularly preferably 6 to 8.

Specific examples of the aryl group in Formula (Le-1) to Formula (Le-10) include a phenyl group, a naphthyl group, an anthracenyl group, a phenanthrenyl group, and the like which may have a substituent.

Specific examples of the heteroaryl group in Formula (Le-1) to Formula (Le-10) include a furyl group, a pyridyl group, a pyrimidyl group, a pyrazoyl group, a thiophenyl group, and the like which may have a substituent.

Each of the groups in Formula (Le-1) to Formula (Le-10), such as a monovalent organic group, an alkyl group, an

aryl group, a heteroaryl group, a dialkylanilino group, an alkylamino group, and an alkoxy group, may have a substituent. Examples of the substituent include an alkyl group, an aryl group, a heteroaryl group, a halogen atom, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, a cyano group, and the like. These substituents may be further substituted with these substituents.

Examples of the leuco colorant having the phthalide structure or the fluoran structure that are suitably used include the following compounds.

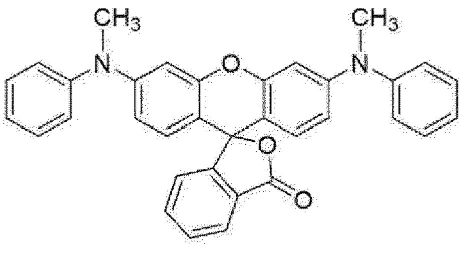

S - 1

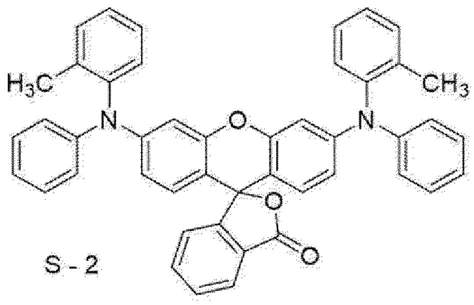

S - 2

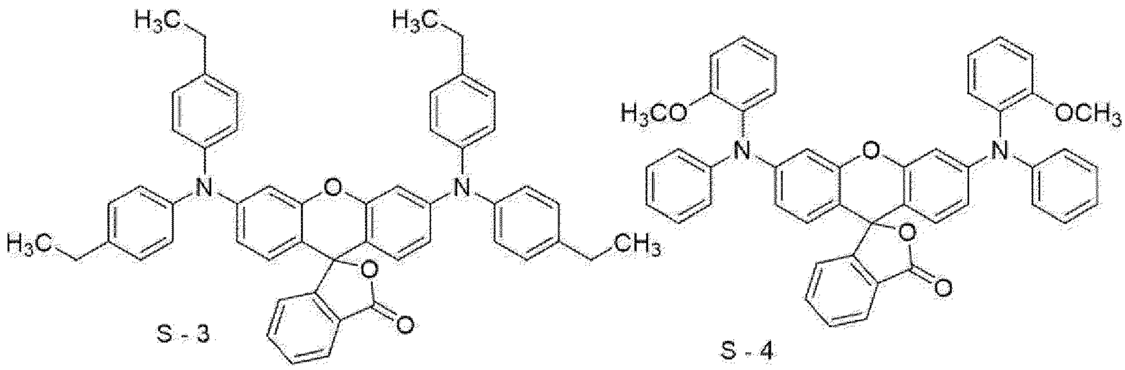

S - 3

S - 4

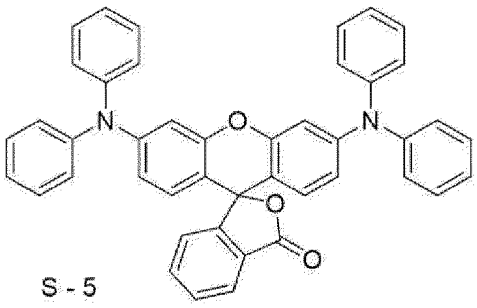

S - 5

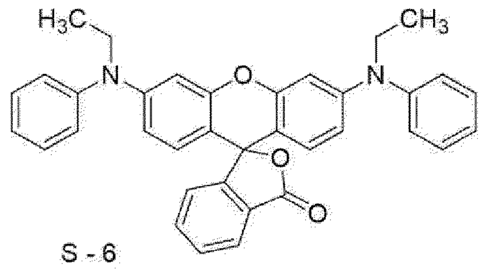

S - 6

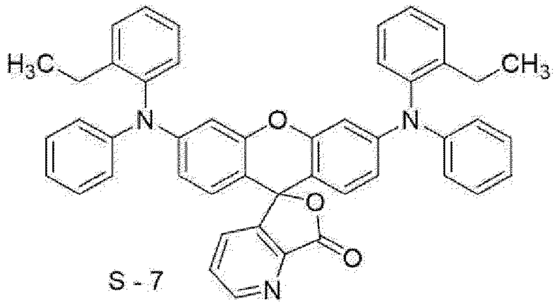

S - 7

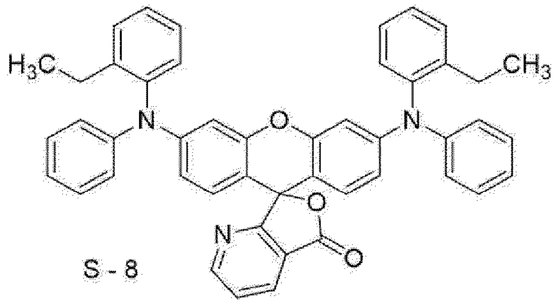

S - 8

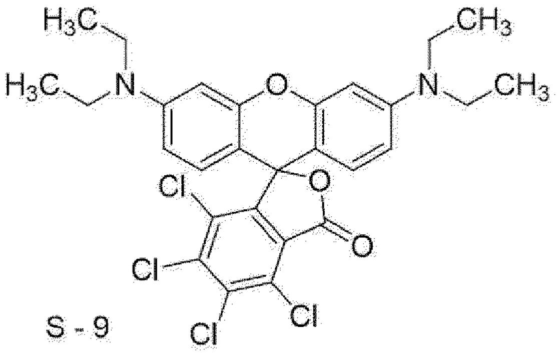

S - 9

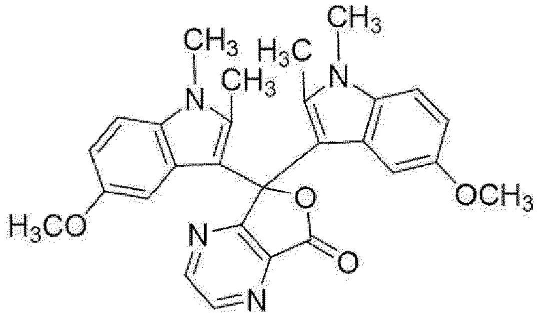

S - 10

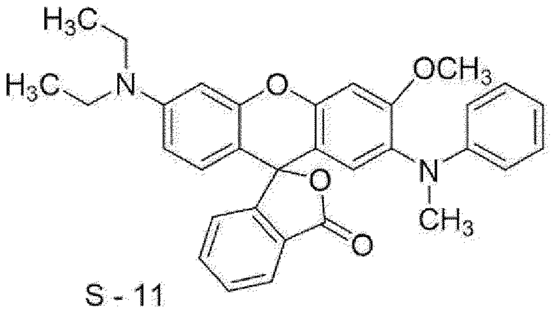

S - 11

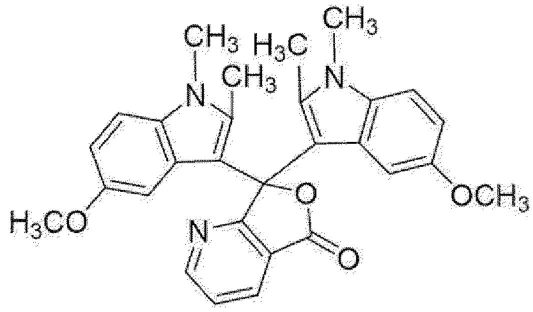

S - 12

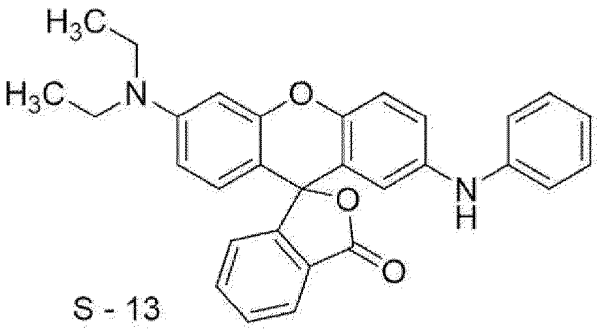

S - 13

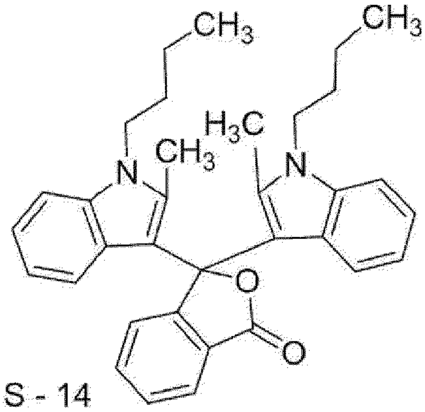

S - 14

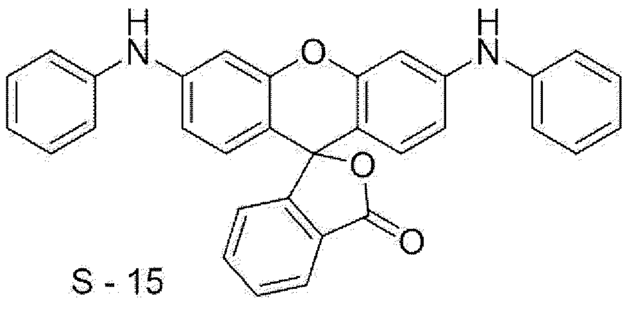

S - 15

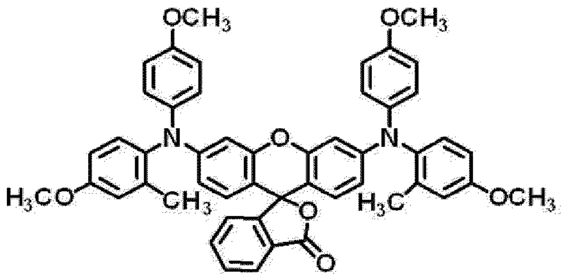

S - 16

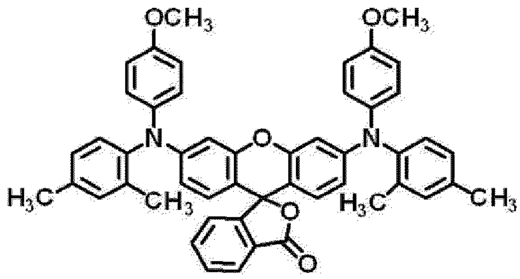

S - 17

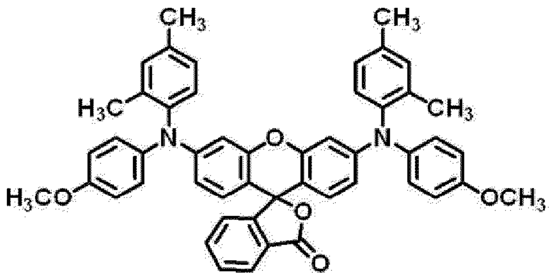

S - 18

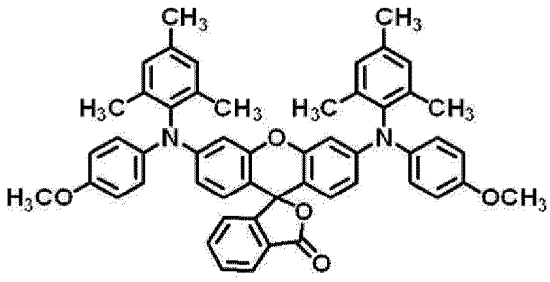

S - 19

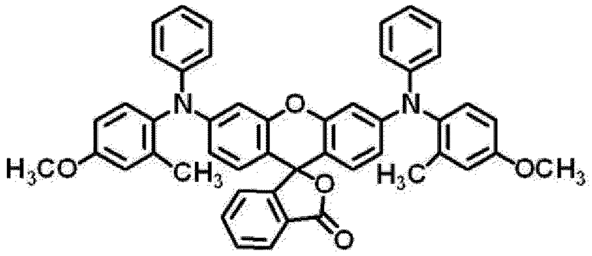

S - 20

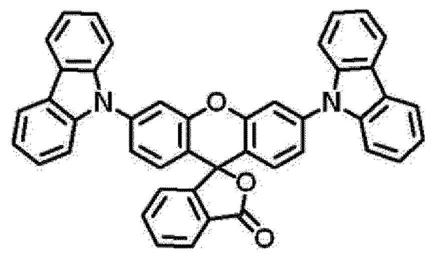

S - 21

As the acid color developing agent, commercially available products can be used. Examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), crystal violet lactone (manufactured by Tokyo Chemical Industry Co., Ltd.), and the like. Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these form a film having excellent visible light absorbance.

From the viewpoint of visibility and visibility of exposed portions, examples of suitably used a leuco colorant include the following compounds.

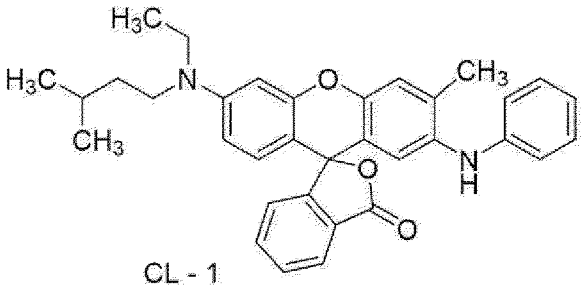

CL - 1

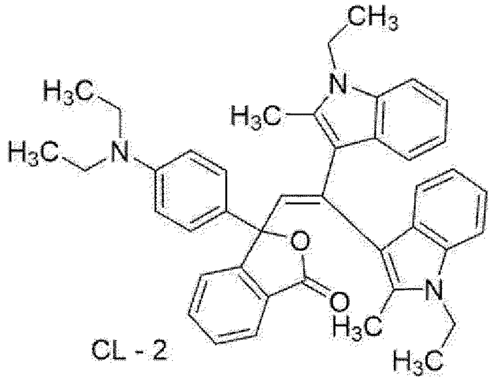

CL - 2

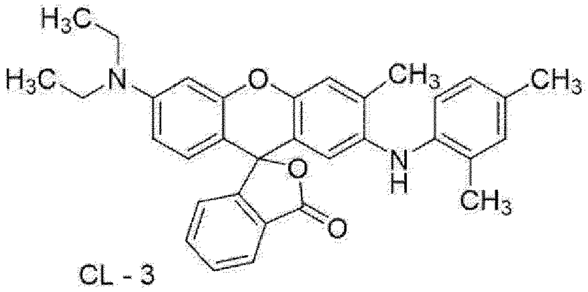

CL - 3

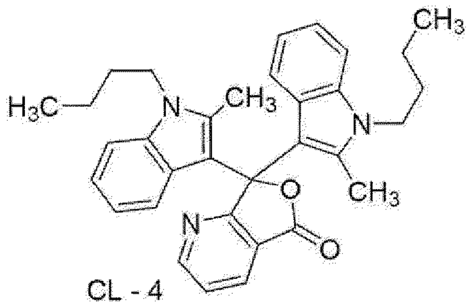

CL - 4

Each of these color developing agents may be used alone. Alternatively, two or more components can be used in combination.

The content of the color developing agent with respect to the total mass of the image-recording layer is preferably 0.5% by mass to 10% by mass, and more preferably 1% by mass to 5% by mass.

[Particles]

From the viewpoint of on-press developability and UV printing durability, it is preferable that the image-recording layer in the on-press development type lithographic printing plate precursor further contain particles. The particles may be inorganic particles or organic particles.

From the viewpoint of on-press developability, the image-recording layer preferably contains organic particles, and more preferably contains resin particles.

Known inorganic particles can be used as inorganic particles, and metal oxide particles such as silica particles and titania particles can be suitably used.

<<Resin particles>>

Examples of the resin particles include particles containing an addition polymerization-type resin (that is, addition polymerization-type resin particles), particles containing a polyaddition-type resin (that is, polyaddition-type resin particles), particles containing a polycondensation-type resin (that is, polycondensation-type resin particles), and the like. Among these, addition polymerization-type resin particles or polyaddition-type resin particles are preferable.

From the viewpoint of enabling thermal fusion, the resin particles may also be particles containing a thermoplastic resin (that is, thermoplastic resin particles).

The resin particles may be in the form of microcapsules, microgel (that is, crosslinked resin particles), or the like.

The resin particles are preferably selected from the group consisting of thermoplastic resin particles, thermal reactive resin particles, resin particles having a polymerizable group, microcapsules encapsulating a hydrophobic compound, and microgel (crosslinked resin particles). Among these, resin particles having a polymerizable group are preferable.

In a particularly preferable embodiment, the resin particles have at least one ethylenically unsaturated group. The presence of such resin particles brings about effects of improving the printing durability of an exposed portion and improving the on-press developability of a non-exposed portion.

As the thermoplastic resin particles, the thermoplastic resin particles described in Research Disclosure No. 33303 published in January 1992, JP1997-123387A (JP-H09-123387A), JP1997-131850A (JP-H09-131850A),

JP1997-171249A (JP-H09-171249A), JP1997-171250A (JP-H09-171250A), EP931647B, and the like are preferable.

Specific examples of resins constituting the thermoplastic resin particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and the like and mixtures of these.

From the viewpoint of ink receptivity and UV printing durability, the thermoplastic resin particles preferably contain a resin that has a constitutional unit formed of an aromatic vinyl compound and a nitrile group-containing constitutional unit.

The aforementioned aromatic vinyl compound may have a structure composed of an aromatic ring and a vinyl group bonded thereto. Examples of the compound include a styrene compound, a vinylnaphthalene compound, and the like. Among these, a styrene compound is preferable, and styrene is more preferable.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, for example, styrene is preferable.

From the viewpoint of ink receptivity, the content of the constitutional unit formed of an aromatic vinyl compound is preferably higher than the content of the nitrile group-containing constitutional unit which will be described later. The content of the constitutional unit formed of an aromatic vinyl compound with respect to the total mass of the resin is more preferably 15% by mass to 85% by mass, and even more preferably 30% by mass to 70% by mass.

The nitrile group-containing constitutional unit is preferably introduced using a monomer having a nitrile group.

Examples of the monomer having a nitrile group include an acrylonitrile compound. As the monomer having a nitrile group, for example, (meth)acrylonitrile is suitable.

As the nitrile group-containing constitutional unit, a constitutional unit formed of (meth)acrylonitrile is preferable.

From the viewpoint of ink receptivity, the content of the nitrile group-containing constitutional unit is preferably lower than the content of the aforementioned constitutional unit formed of an aromatic vinyl compound. The content of the nitrile group-containing constitutional unit with respect to the total mass of the resin is more preferably 55% by mass to 90% by mass, and even more preferably 60% by mass to 85% by mass.

In a case where the resin contained in the thermoplastic resin particles has the constitutional unit formed of an aromatic vinyl compound and the nitrile group-containing constitutional unit, the content ratio between the constitutional unit formed of an aromatic vinyl compound and the nitrile group-containing constitutional unit (constitutional unit formed of aromatic vinyl compound:nitrile group-containing constitutional unit) is preferably 5:5 to 9: 1, and more preferably 6:4 to 8:2, based on mass.

From the viewpoint of UV printing durability and chemical resistance, the resin contained in the thermoplastic resin particles preferably further has a constitutional unit formed of an N-vinyl heterocyclic compound.

Examples of the N-vinyl heterocyclic compound include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. Among these, N-vinylpyrrolidone is preferable.

The content of the constitutional unit formed of an N-vinyl heterocyclic compound with respect to the total mass of the thermoplastic resin is preferably 5% by mass to 50% by mass, and more preferably 10% by mass to 40% by mass.

The resin contained in the thermoplastic resin particles may contain an acidic group-containing constitutional unit. From the viewpoint of on-press developability and ink receptivity, it is preferable that the resin do not contain an acidic group-containing constitutional unit.

Specifically, in the thermoplastic resin, the content of the acidic group-containing constitutional unit is preferably 20% by mass or less, more preferably 10% by mass or less, and even more preferably 5% by mass or less. The lower limit of the content is not particularly limited, and may be 0% by mass.

The acid value of the thermoplastic resin is preferably 160 mg KOH/g or less, more preferably 80 mg KOH/g or less, and even more preferably 40 mg KOH/g or less. The lower limit of the acid value is not particularly limited, and may be 0 mg KOH/g.

In the present disclosure, the acid value is determined by the measurement method based on JIS K0070:1992.

From the viewpoint of ink receptivity, the resin contained in the thermoplastic resin particles may contain a hydrophobic group-containing constitutional unit.

Examples of the hydrophobic group include an alkyl group, an aryl group, an aralkyl group, and the like.

As the hydrophobic group-containing constitutional unit, a constitutional unit formed of an alkyl (meth)acrylate compound, an aryl (meth)acrylate compound, or an aralkyl (meth)acrylate compound is preferable, and a constitutional unit formed of an alkyl (meth)acrylate compound is more preferable.

In the resin contained in the thermoplastic resin particles, the content of the hydrophobic group-containing constitutional unit with respect to the total mass of the resin is preferably 5% by mass to 50% by mass, and more preferably 10% by mass to 30% by mass.

From the viewpoint of UV printing durability and on-press developability, the thermoplastic resin contained in the

thermoplastic resin particles preferably has a hydrophilic group.

The hydrophilic group is not particularly limited as long as it has a hydrophilic structure, and examples thereof include an acid group such as a carboxy group, a hydroxy group, an amino group, a nitrile group, a polyalkylene oxide structure, and the like.

From the viewpoint of UV printing durability and on-press developability, the hydrophilic group is preferably a group having a polyalkylene oxide structure, a group having a polyester structure, or a sulfonic acid group, more preferably a group having a polyalkylene oxide structure or a sulfonic acid group, and even more preferably a group having a polyalkylene oxide structure.

From the viewpoint of on-press developability, the polyalkylene oxide structure is preferably a polyethylene oxide structure, a polypropylene oxide structure, or a poly(ethylene oxide/propylene oxide) structure.

From the viewpoint of on-press developability, among the above hydrophilic groups, groups having a polypropylene oxide structure as a polyalkylene oxide structure are preferable, and groups having a polyethylene oxide structure and a polypropylene oxide structure are more preferable.

From the viewpoint of on-press developability, the number of alkylene oxide structures in the polyalkylene oxide structure is preferably 2 or more, more preferably 5 or more, even more preferably 5 to 200, and particularly preferably 8 to 150.

From the viewpoint of on-press developability, as the aforementioned hydrophilic group, a group represented by Formula Z, which will be described later, is preferable.

Among the hydrophilic groups that the thermoplastic resin has, a group represented by Formula PO is preferable.

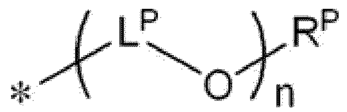

Formula PO

In Formula PO, $L^P$ each independently represent an alkylene group, $R^P$ represents a hydrogen atom or an alkyl group, and n represents an integer of 1 to 100.

In Formula PO, $L^P$ preferably each independently represent an ethylene group, a 1-methylethylene group, or a 2-methylethylene group, and more preferably each independently represent an ethylene group.

In Formula PO, $R^P$ is preferably a hydrogen atom or an alkyl group having a carbon number of 1 to 18, more preferably a hydrogen atom or an alkyl group having a carbon number of 1 to 10, even more preferably a hydrogen atom or an alkyl group having a carbon number of 1 to 4, and particularly preferably a hydrogen atom or a methyl group.

In Formula PO, n is preferably an integer of 1 to 10, and more preferably an integer of 1 to 4.

The content of the hydrophilic group-containing constitutional unit with respect to the total mass of the resin is preferably 5% by mass to 60% by mass, and more preferably 10% by mass to 30% by mass.

The resin contained in the thermoplastic resin particles may further contain other constitutional units. The resin can contain, as those other constitutional units, constitutional units other than the constitutional units described above without particular limitations. Examples thereof include constitutional units formed of an acrylamide compound, a vinyl ether compound, and the like.

In the resin contained in the thermoplastic resin particles, the content of other constitutional units with respect to the total mass of the resin is preferably 5% by mass to 50% by mass, and more preferably 10% by mass to 30% by mass.

Examples of the thermal reactive resin particles include resin particles having a thermal reactive group. The thermal reactive resin particles form a hydrophobic region through crosslinking by a thermal reaction and the accompanying change in functional groups.

The thermal reactive group in the resin particles having a thermal reactive group may be a functional group that causes any reaction as long as chemical bonds are formed. The thermal reactive group is preferably a polymerizable group. Preferred examples of the polymerizable group include an ethylenically unsaturated group that causes a radical polymerization reaction (for example, an acryloyl group, a methacryloyl group, a vinyl group, an allyl group, and the like), a cationically polymerizable group (for example, a vinyl group, a vinyloxy group, an epoxy group, an oxetanyl group, and the like), an isocyanato group or a blocked isocyanato group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

The resin having a thermal reactive group may be an addition polymerization-type resin, a polyaddition-type resin, or a polycondensation-type resin or may be a thermoplastic resin.

As the microcapsules, for example, microcapsules are preferable which encapsulate at least some of the constituent components (preferably a hydrophobic compound) of the image-recording layer as described in JP2001-277740A and JP2001-277742A. In a preferred aspect of the image-recording layer containing microcapsules as resin particles, the image-recording layer is composed of microcapsules that encapsulate a hydrophobic component (that is, a hydrophobic compound) among the constituent components of the image-recording layer and a hydrophilic component (that is, a hydrophilic compound) that is on the outside of the microcapsules.

The microgel (crosslinked resin particles) can contain some of the constituent components of the image-recording layer, in at least one of the surface or the interior of the microgel. From the viewpoint of sensitivity of the lithographic printing plate precursor and printing durability of the lithographic printing plate to be obtained, reactive microgel having a polymerizable group on the surface thereof is particularly preferable.

In order to obtain microcapsules containing a constituent component of the image-recording layer, known synthesis methods can be used.

The microgel (crosslinked resin particles) can contain some of the constituent components of the image-recording layer, in at least one of the surface or the interior of the microgel. From the viewpoint of sensitivity of the lithographic printing plate precursor and printing durability of the lithographic printing plate to be obtained, reactive microgel having a polymerizable group on the surface thereof is particularly preferable.

In order to obtain microgel containing a constituent component of the image-recording layer, known synthesis methods can be used.

As the resin particles, from the viewpoint of printing durability, antifouling properties, and storage stability of the lithographic printing plate to be obtained, polyaddition-type resin particles are preferable which are obtained by a reaction between a polyvalent isocyanate compound that is an adduct of a polyhydric phenol compound having two or more hydroxy groups in a molecule and isophorone diisocyanate and a compound having active hydrogen.

As the polyhydric phenol compound, a compound having a plurality of benzene rings having a phenolic hydroxyl group is preferable.

As the compound having active hydrogen, a polyol compound or a polyamine compound is preferable, a polyol compound is more preferable, and at least one compound selected from the group consisting of propylene glycol, glycerin, and trimethylolpropane is even more preferable. As the aforementioned active hydrogen compound, water can also be used. In a case where water is used, the amine generated by the reaction between an isocyanato group and water can form a urea bond to form particles.

Preferred examples of the resin particles obtained by the reaction between a polyvalent isocyanate compound that is an adduct of a polyhydric phenol compound having two or more hydroxy groups in a molecule and isophorone diisocyanate and a compound having active hydrogen include the resin particles described in paragraphs "0230" to "0234" of WO2018/043259A.

As the resin particles, from the viewpoint of printing durability and solvent resistance of the lithographic printing plate to be obtained, addition polymerization-type resin particles are preferable which have a hydrophobic main chain and include both i) constitutional unit having a nitrile group directly bonded to the hydrophobic main chain and ii) constitutional unit having a pendant group including a hydrophilic polyalkylene oxide segment. Specifically, the particles described in paragraph "0156" of JP2019-64269A are preferable.

<<Group represented by Formula Z>>

It is preferable that the resin particles in the present disclosure have a group represented by Formula Z as a hydrophilic group.

*-Q-W-Y    Formula Z

In Formula Z, Q represents a divalent linking group, W represents a divalent group having a hydrophilic structure or a divalent group having a hydrophobic structure, and Y represents a monovalent group having a hydrophilic structure or a monovalent group having a hydrophobic structure, either W or Y has a hydrophilic structure, and * represents a bonding site with another structure.

Furthermore, it is preferable that any of the hydrophilic structures included in Formula Z include a polyalkylene oxide structure.

Q in Formula Z is preferably a divalent linking group having a carbon number of 1 to 20, and more preferably a divalent linking group having a carbon number of 1 to 10.

Furthermore, Q in Formula Z is preferably an alkylene group, an arylene group, an ester bond, an amide bond, or a group formed by combining two or more of these, and more preferably a phenylene group, an ester bond, or an amide bond.

The divalent group having a hydrophilic structure represented by W in Formula Z is preferably a group having a polyalkylene oxide structure, and more preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^{W}N-R^{WA}-NR^{W}-$, $-OC(=O)-R^{WA}-O-$, or $-OC(=O)-R^{WA}-O-$. $R^{WA}$'s each independently represent a linear, branched, or cyclic alkylene group having a carbon number of 6 to 120, a haloalkylene group having a carbon number of 6 to 120, an arylene group having a carbon number of 6 to 120, an alkarylene group having a carbon number of 6 to 120 (divalent group formed by removing one hydrogen atom from an alkylaryl group), or an aralkylene group having a carbon number of 6 to 120.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal. Particularly, the monovalent group having a hydrophilic structure is preferably a group having a polyalkylene oxide structure, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having a carbon number of 6 to 120, a haloalkyl group having a carbon number of 6 to 120, an aryl group having a carbon number of 6 to 120, an alkaryl group having a carbon number of 6 to 120 (alkylaryl group), an aralkyl group having a carbon number of 6 to 120, $-OR^{WB}$, $-C(=O)OR^{WB}$, or $-OC(=O)R^{WB}$. $R^{WB}$ represents an alkyl group having a carbon number of 6 to 20.

From the viewpoint of printing durability, receptivity, and on-press developability, in the resin particles having a group represented by formula Z, W is more preferably a divalent group having a hydrophilic structure, Q is more preferably a phenylene group, an ester bond, or an amide bond, W is more preferably a polyalkyleneoxy group, and Y is more preferably a polyalkyleneoxy group having a hydrogen atom or an alkyl group on a terminal.

The group represented by Formula Z may function as a dispersible group for improving the dispersibility of the resin particles.

From the viewpoint of printing durability and on-press developability, the resin particles in the present disclosure preferably have a polymerizable group (preferably an ethylenically unsaturated group). Particularly, the resin particles more preferably include resin particles having a polymerizable group on the surface thereof. In a case where the resin particles having a polymerizable group are used, printing durability (preferably UV printing durability) is improved.

From the viewpoint of printing durability, it is preferable that the resin particles in the present disclosure be resin particles having a hydrophilic group and a polymerizable group.

The polymerizable group may be a cationically polymerizable group or a radically polymerizable group. From the viewpoint of reactivity, the polymerizable group is preferably a radically polymerizable group.

The aforementioned polymerizable group is not particularly limited as long as it is a polymerizable group. From the viewpoint of reactivity, an ethylenically unsaturated group is preferable, a vinylphenyl group (styryl group), a (meth)acryloxy group, or a (meth)acrylamide group is more preferable, and a (meth)acryloxy group is particularly preferable.

In addition, it is preferable that the resin constituting the resin particles having a polymerizable group have a polymerizable group-containing constitutional unit.

The polymerizable group may be introduced into the surface of the resin particles by a polymer reaction.

Furthermore, from the viewpoint of printing durability, receptivity, on-press developability, and suppressiveness of the occurrence of development residues during on-press development, the resin particles preferably contain a polyaddition-type resin having a urea bond, more preferably contain a polyaddition-type resin having a structure obtained by reacting at least an isocyanate compound represented by Formula (Iso) with water, and particularly preferably contain a polyaddition-type resin that has a structure obtained by reacting at least an isocyanate compound represented by Formula (Iso) with water and has a polyethylene oxide structure and a polypropylene oxide structure as polyoxyalkylene structures. Furthermore, the particles containing the polyaddition-type resin having a urea bond are preferably microgel.

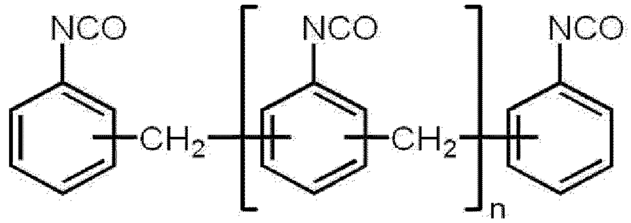

(Iso)

In Formula (Iso), n represents an integer of 0 to 10.

An example of the reaction between the isocyanate compound represented by Formula (Iso) and water is the reaction shown below. In the following example, a 4,4-isomer in which n = 0 is used.

As shown below, in a case where the isocyanate compound represented by Formula (Iso) is reacted with water,

the isocyanate group is partially hydrolyzed by water and generates an amino group. The generated amino group reacts with the isocyanate group and generates a urea bond, and a dimer is consequently formed. Furthermore, the following reaction is repeated to form a polyaddition-type resin having a urea bond.

In the following reaction, by adding a compound (compound having active hydrogen) such as an alcohol compound or an amine compound reactive with an isocyanate group, it is possible to introduce the structure of an alcohol compound, an amine compound, or the like to the polyaddition-type resin having a urea bond.

Preferred examples of the compound having active hydrogen include the aforementioned compound having active hydrogen.

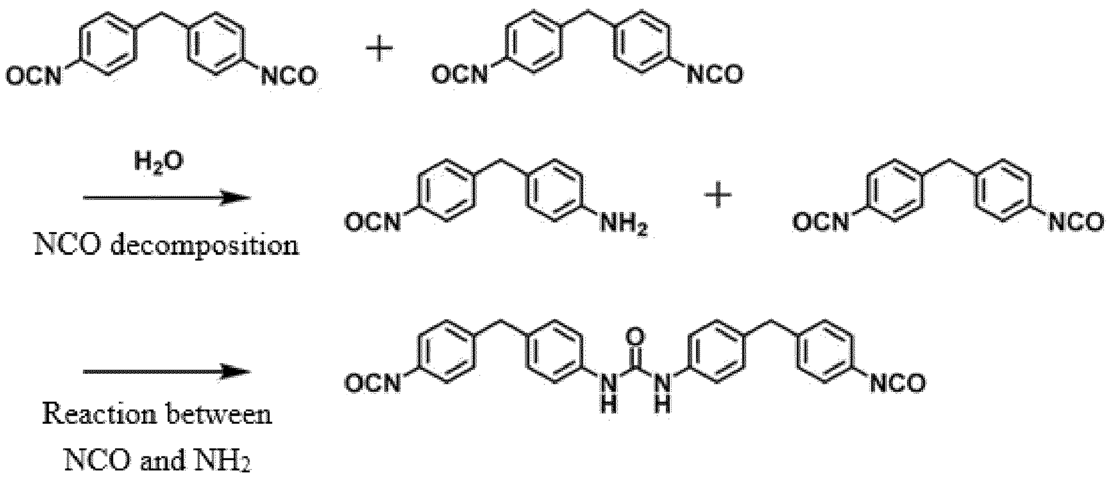


The polyaddition-type resin having a urea bond preferably has an ethylenically unsaturated group, and more preferably has a group represented by Formula (PETA).

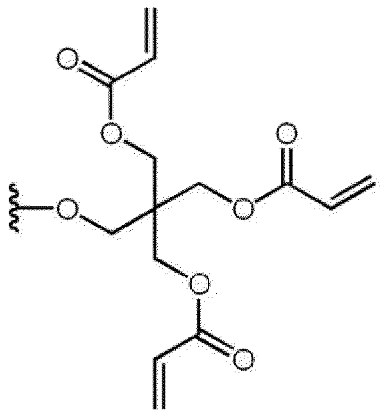

( PETA )

In Formula (PETA), the portion of the wavy line represents a binding position with other structures.

<<Synthesis of resin particles>>

The synthesis method of the resin particles is not particularly limited, and may be a method that makes it possible to synthesize particles with various resins described above. Examples of the synthesis method of the resin particles include known synthesis methods of resin particles, such as an emulsion polymerization method, a suspension polymerization method, a dispersion polymerization method, a soap-free polymerization method, and a microemulsion polymerization method.

In addition, for the synthesis of the resin particles, a known microcapsule synthesis method, a known microgel (crosslinked resin particle) synthesis method, and the like may be used.

<<Average particle diameter of particles>>

The average particle diameter of the particles is preferably 0.01 μm to 3.0 μm, more preferably 0.03 μm to 2.0 μm, and even more preferably 0.10 μm to 1.0 μm. In a case where the average particle diameter is in this range, excellent

resolution and temporal stability are obtained.

The average particle diameter of the particles is measured using a light scattering method or by capturing an electron micrograph of the particles, measuring the particle diameter of a total of 5,000 particles in the photograph, and calculating the average thereof. For nonspherical particles, the equivalent circular diameter of the particles in a photograph is adopted.

Note that unless otherwise specified, the average particle diameter of the particles in the present disclosure means a volume average particle diameter.

As the particles (preferably resin particles), only one kind of particles may be used, or two or more kinds of particles may be used in combination.

From the viewpoint of developability and printing durability, the content of the particles (preferably resin particles) with respect to the total mass of the image-recording layer is preferably 5% by mass to 90% by mass, more preferably 10% by mass to 90% by mass, even more preferably 20% by mass to 90% by mass, and particularly preferably 50% by mass to 90% by mass.

[Other components]

The image-recording layer in the on-press development type lithographic printing plate precursor may contain other components in addition to the components described above.

Examples of those other components include a binder polymer, a color developing agent, a chain transfer agent, a low-molecular-weight hydrophilic compound, an oil sensitizing agent, other additives, and the like.

Examples of those other components include a colorant, a bakeout agent, a polymerization inhibitor, a higher fatty acid derivative, a plasticizer, inorganic particles, and a low-molecular-weight hydrophilic compound disclosed in paragraphs "0181" to "0190" of JP2009-255434A, and the like.

Examples of other compounds also include a hydrophobic precursor (fine particles capable of converting the image-recording layer into a hydrophobic image-recording layer in a case where heat is applied thereto), a low-molecular-weight hydrophilic compound, an oil sensitizing agent (for example, a phosphonium compound, a nitrogen-containing low-molecular-weight compound, or an ammonium group-containing polymer), and a chain transfer agent disclosed in paragraphs "0191" to "0217" of JP2012-187907A.

-Binder polymer-

As necessary, the image-recording layer may contain a binder polymer.

The binder polymer refers to a polymer other than resin particles, that is, a polymer that is not in the form of particles.

In addition, the binder polymer excludes an ammonium salt-containing polymer in an oil sensitizing agent and a polymer used as a surfactant.

As the binder polymer, known binder polymers (for example, a (meth) acrylic resin, polyvinyl acetal, a polyurethane resin, and the like) used for the image-recording layer of a lithographic printing plate precursor can be suitably used.

As an example, a binder polymer that is used for an on-press development type lithographic printing plate precursor (hereinafter, also called binder polymer for on-press development) will be specifically described.

As the binder polymer for on-press development, a binder polymer having an alkylene oxide chain is preferable. The binder polymer having an alkylene oxide chain may have a poly(alkylene oxide) moiety in a main chain or side chain. In addition, the binder polymer may be a graft polymer having poly(alkylene oxide) in a side chain or a block copolymer of a block composed of a poly(alkylene oxide)-containing repeating unit and a block composed of an (alkylene oxide)-free repeating unit.

As a binder polymer having a poly(alkylene oxide) moiety in the main chain, a polyurethane resin is preferable.

In a case where the binder polymer has a poly(alkylene oxide) moiety in the side chain, examples of polymers as the main chain include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber. Among these, a (meth)acrylic resin is particularly preferable.

In addition, as the binder polymer, for example, a polymer compound is also preferable which has a polyfunctional thiol having functionalities of 6 or more and 10 or less as a nucleus and a polymer chain that is bonded to the nucleus by a sulfide bond and has a polymerizable group (hereinafter, this compound will be also called star-shaped polymer compound).

As the star-shaped polymer compound, for example, the compounds described in JP2012-148555A can be preferably used.

Examples of the star-shaped polymer compound include the compound described in JP2008-195018A that has

a polymerizable group such as an ethylenically unsaturated bond for improving the film hardness of an image area in a main chain or side chain and preferably in a side chain. Crosslinking is formed between molecules of the star polymer compound by the polymerizable group contained in the star-shaped polymer compound, and the curing is promoted.

As the polymerizable group, an ethylenically unsaturated group such as a (meth)acryloyl group, a vinyl group, an allyl group, or a vinylphenyl group (styryl group), an epoxy group, or the like is preferable, a (meth)acryloyl group, a vinyl group, or a vinyl phenyl group (styryl group) is more preferable from the viewpoint of polymerization reactivity, and a (meth) acryloyl group is particularly preferable. These groups can be introduced into the polymer by a polymer reaction or copolymerization. Specifically, for example, it is possible to use a reaction between a polymer having a carboxy group in a side chain and glycidyl methacrylate or a reaction between a polymer having an epoxy group and an ethylenically unsaturated group-containing carboxylic acid such as methacrylic acid.

The molecular weight of the binder polymer that is a polystyrene-equivalent weight-average molecular weight (Mw) determined by GPC method is preferably 2,000 or more, more preferably 5,000 or more, and even more preferably 10,000 to 300,000.

As the binder polymer, as necessary, a hydrophilic polymer, such as polyacrylic acid, polyvinyl alcohol, or polyvinyl acetal described in JP2008-195018A, can be used in combination. In addition, a lipophilic polymer and a hydrophilic polymer can be used in combination.

Particularly, from the viewpoint of on-press developability, the image-recording layer preferably contains polyvinyl acetal. Suitable examples of the polyvinyl acetal include polyvinyl butyral and the like.

One binder polymer may be used alone, or two or more binder polymers may be used in combination.

The content of the binder polymer to be incorporated into the image-recording layer can be randomly set. The content of the binder polymer with respect to the total mass of the image-recording layer is preferably 1% by mass to 90% by mass, and more preferably 5% by mass to 80% by mass.

[Formation of image-recording layer]

The image-recording layer in the lithographic printing plate precursor according to the present disclosure can be formed, for example, by preparing a coating liquid by dispersing or dissolving the necessary components described above in a known solvent, coating a support with the coating liquid by a known method such as bar coating, and drying the coating liquid, as described in paragraphs "0142" and "0143" of JP2008-195018A. The coating amount (solid content) of the image-recording layer after coating and drying varies with uses, but is preferably 0.3 $g/m^2$ to 3.0 $g/m^2$. In a case where the coating amount is in this range, excellent sensitivity and excellent film forming characteristics of the image-recording layer are obtained.

As the solvent, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, ethyl lactate, and the like. One solvent may be used alone, or two or more solvents may be used in combination. The concentration of solid contents in the coating liquid is preferably 1% by mass to 50% by mass.

The coating amount (solid content) of the image-recording layer after coating and drying varies with uses. However, from the viewpoint of obtaining excellent sensitivity and excellent film forming characteristics of the image-recording layer, the coating amount is preferably 0.3 $g/m^2$ to 3.0 $g/m^2$.

The film thickness of the image-recording layer in the lithographic printing plate precursor according to the present disclosure is preferably 0.1 μm to 3.0 μm, and more preferably 0.3 μm to 2.0 μm.

In the present disclosure, the film thickness of each layer in the lithographic printing plate precursor is checked by preparing a slice by cutting the lithographic printing plate precursor in a direction perpendicular to the surface of the precursor and observing the cross section of the slice with a scanning electron microscope (SEM).

<Outermost layer>

It is preferable that the lithographic printing plate precursor according to the embodiment of the present disclosure has an outermost layer on the image-recording layer.

In addition, the outermost layer is the outermost layer on the image-recording layer side in the support in the lithographic printing plate precursor.

The outermost layer may have a function of suppressing the reaction inhibiting image formation by blocking oxygen, a function of preventing the damage of the image-recording layer, a function of preventing ablation during exposure to high-illuminance lasers, and the like.
The outermost layer is also referred to as a protective layer.

-Water-soluble polymer-

From the viewpoint of development removability (more preferably on-press developability), the outermost layer preferably contains a water-soluble polymer.
In the present disclosure, a water-soluble polymer refers to a polymer that dissolves 1 g or more in 100 g of pure water at 70°C and is not precipitated even though a solution of 1 g of the polymer in 100 g of pure water at 70°C is cooled to 25°C.
Examples of the water-soluble polymer used in the outermost layer include polyvinyl alcohol, modified polyvinyl alcohol, polyvinylpyrrolidone, a water-soluble cellulose derivative, polyethylene glycol, poly(meth)acrylonitrile, and the like.
As the modified polyvinyl alcohol, acid-modified polyvinyl alcohol having a carboxy group or a sulfo group is preferably used. Specific examples thereof include modified polyvinyl alcohols described in JP2005-250216A and JP2006-259137A.
Preferred examples of the water-soluble polymer include polyvinyl alcohol. Particularly, as the water-soluble polymer to be used, polyvinyl alcohol having a saponification degree of 50% or more is more preferable.
The saponification degree is preferably 60% or higher, more preferably 70% or higher, and even more preferably 85% or higher. The upper limit thereof of the saponification degree is not particularly limited, and may be 100% or less.
The saponification degree is measured according to the method described in JIS K 6726: 1994.
Preferred examples of the water-soluble polymer also include polyvinylpyrrolidone.
As the hydrophilic polymer, it is also preferable to use polyvinyl alcohol and polyvinylpyrrolidone in combination.
One water-soluble polymer may be used alone, or two or more water-soluble polymers may be used in combination.
In a case where the outermost layer contains a water-soluble polymer, the content of the water-soluble polymer with respect to the total mass of the outermost layer is preferably 1% by mass to 99% by mass, more preferably 3% by mass to 97% by mass, and even more preferably 5% by mass to 95% by mass.
In order to improve oxygen barrier property, the outermost layer may contain an inorganic lamellar compound.
The inorganic lamellar compound refers to particles in the form of a thin flat plate, and examples thereof include mica groups such as natural mica and synthetic mica, talc represented by Formula $3MgO \cdot 4SiO \cdot H_2O$, taeniolite, montmorillonite, saponite, hectorite, zirconium phosphate, and the like.
The mica compound is preferably used as the inorganic lamellar compound. Examples of the mica compound include mica groups such as natural mica and synthetic mica represented by Formula: $A(B,C)_{2-5}D_4O_{10}(OH,F,O)_2$ [here, A is any one of K, Na, or Ca, B and C are any one of Fe(II), Fe(III), Mn, Al, Mg, or V, and D is Si or Al].
In the mica group, examples of the natural mica include muscovite, soda mica, phlogopite, biotite, and lepidolite. Examples of synthetic mica include non-swelling mica such as fluorine phlogopite $KMg_3(AlSi_3O_{10})F_2$, potassium tetrasilic mica $KMg_{2.5}Si_4O_{10})F_2$, and, Na tetrasilylic mica $NaMg_{2.5}(Si_4O_{10})F_2$, swelling mica such as Na or Li taeniolite (Na, Li) $Mg_2Li(Si_4O_{10})F_2$, montmorillonite-based Na or Li hectorite $(Na, Li)_{1/8}Mg_{2/5}Li_{1/8}(Si_4O_{10})F_2$. Furthermore, synthetic smectite is also useful.
Among the mica compounds, fluorine-based swelling mica is particularly useful. That is, swelling synthetic mica has a laminated structure consisting of unit crystal lattice layers having a thickness in a range of about 10Å to 15Å (1Å is equal to 0.1 nm), and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are absorbed between the layers in order to compensate for the deficiency. Positive ions interposed between the layers are referred to as exchangeable positive ions and are exchangeable with various positive ions. Particularly, in a case where the positive ions between the layers are $Li^+$ and $Na^+$, the ionic radii are small, and thus the bonds between lamellar crystal lattices are weak, and mica is significantly swollen by water. In a case where the sol is sheared in a swollen state, the sol is easily cleaved and forms a stable sol in water. Swelling synthetic mica is particularly preferably used because it clearly exhibits such a tendency.
From the viewpoint of diffusion control, regarding the shapes of the mica compounds, the thickness is preferably thin, and the planar size is preferably large as long as the smoothness and actinic ray-transmitting property of coated surfaces are not impaired. As a result, the aspect ratio is preferably 20 or more, more preferably 100 or more, and particularly preferably 200 or more. The aspect ratio is a ratio of the major axis to the thickness of a particle, and can be measured from projection views obtained from the microphotograph of the particles.
The larger the aspect ratio of the mica compound, the larger the obtained oxygen blocking effect.

Regarding the particle diameter of the mica compound, the average major diameter thereof is preferably 0.3 μm to 20 μm, more preferably 0.5 μm to 10 μm, and particularly preferably 1 μm to 5 μm. The average thickness of the particles is preferably 0.1 μm or less, more preferably 0.05 μm or less, and particularly preferably 0.01 μm or less. Specifically, for example, as a preferable aspect of swelling synthetic mica which is a representative compound, the thickness thereof is in a range of about 1 nm to 50 nm and the surface size (major diameter) is in a range of about 1 μm to 20 μm.
The content of the inorganic layered compound is preferably in a range of 1% by mass to 60% by mass and more preferably in a range of 3% by mass to 50% by mass with respect to the total solid content of the overcoat layer. Even in a case where plurality of types of inorganic lamellar compounds are used in combination, the total amount of the inorganic lamellar compounds is preferably equal to the content described above.
In a case where the content is within the above range, the oxygen barrier property is improved, and excellent sensitivity is obtained. In addition, the deterioration of receptivity can be prevented.

-Other components-

The outermost layer may include other components such as a hydrophobic polymer, a discoloring compound, an acid generator, and an additive.
Hereinafter, those other components will be described.

· Hydrophobic polymer

The outermost layer preferably contains a hydrophobic polymer.
The hydrophobic polymer refers to a polymer that dissolves less than 1 g or does not dissolve in 100 g of pure water at 70°C.
Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these polymers, and the like.
The hydrophobic polymer preferably includes a polyvinylidene chloride resin.
Furthermore, the hydrophobic polymer preferably includes a styrene-acrylic copolymer.
In addition, from the viewpoint of on-press developability, the hydrophobic polymer is preferably hydrophobic polymer particles.
One hydrophobic polymer may be used alone, or two or more hydrophobic polymers may be used in combination.
In a case where the outermost layer contains a hydrophobic polymer, the content of the hydrophobic polymer with respect to the total mass of the outermost layer is preferably 1% by mass to 80% by mass, and more preferably 5% by mass to 50% by mass.

· Discoloring compound

The outermost layer may contain a discoloring compound.
In the present disclosure, "discoloring compound" refers to a compound which undergoes change in absorption in the visible light region (wavelength: 400 nm or more and less than 750 nm) due to the exposure to infrared. That is, in the present disclosure, "discoloring" means that the absorption in the visible light region (wavelength: 400 nm or more and less than 750 nm) changes due to the exposure to infrared.
Specifically, examples of the discoloring compound in the present disclosure include (1) compound that absorbs more light in the visible light region due to the exposure to infrared than before the exposure to infrared, (2) compound that is made capable of absorbing light in the visible light region due to the exposure to infrared, and (3) compound that is made incapable of absorbing light in the visible light region due to the exposure to infrared.
The infrared in the present disclosure is a ray having a wavelength of 750 nm to 1 mm, and preferably a ray having a wavelength of 750 nm to 1,400 nm.
The discoloring compound preferably includes a compound that develops color due to the exposure to infrared.
Furthermore, the discoloring compound preferably includes a decomposable compound that decomposes due to the exposure to infrared, and particularly preferably includes a decomposable compound that decomposes by either or both of heat and electron migration due to the exposure to infrared.
More specifically, the discoloring compound in the present disclosure is preferably a compound that decomposes due to the exposure to infrared (more preferably, decomposes by either or both of heat or electron migration due to the exposure to infrared) and absorbs more light in the visible light region than before the exposure to infrared or is made capable of absorbing light of shorter wavelengths and thus capable of absorbing light in the visible light region.
"Decomposes by electron migration" mentioned herein means that electrons excited to the lowest unoccupied molecular orbital (LUMO) from the highest occupied molecular orbital (HOMO) of the discoloring compound by exposure

to infrared move to electron accepting groups (groups having potential close to LUMO) in a molecule by means of intramolecular electron migration and thus result in decomposition.

Hereinafter, as an example of the discoloring compound, a decomposable compound will be described.

There are no limitations on the decomposable compound as long as it absorbs at least a part of light in the infrared wavelength region (wavelength region of 750 nm to 1 mm, preferably a wavelength region of 750 nm to 1,400 nm) and decomposes. The decomposable compound is preferably a compound having maximum absorption in a wavelength region of 750 nm to 1,400 nm.

More specifically, the decomposable compound is preferably a compound that decomposes due to the exposure to infrared and generates a compound having maximum absorption wavelength in a wavelength region of 500 nm to 600 nm.

From the viewpoint of improving visibility of exposed portions, the decomposable compound is preferably a cyanine dye having a group that decomposes by exposure to infrared.

Furthermore, as the cyanine dye which is a decomposable compound, the infrared absorbing compound described in WO2019/219560A can be suitably used.

The discoloring compound may include an acid color developing agent.

As the acid color developing agent, it is possible to use the compounds described above as acid color developing agents in the image-recording layer, and preferred aspects thereof are also the same.

One discoloring compound may be used alone, or two or more components may be combined and used as the discoloring compound.

As the discoloring compound, the decomposable compound described above and the acid generator that will be described later may be used in combination.

From the viewpoint of visibility, the content of the discoloring compound in the outermost layer with respect to the total mass of the outermost layer is preferably 0.10% by mass to 50% by mass, more preferably 0.50% by mass to 30% by mass, and even more preferably 1.0% by mass to 20% by mass.

From the viewpoint of visibility, $M^X/M^Y$ which is a ratio of a content $M^X$ of the discoloring compound in the outermost layer to a content $M^Y$ of the infrared absorber in the image-recording layer is preferably 0.1 or more, more preferably 0.2 or more, and particularly preferably 0.3 or more and 3.0 or less.

· Acid generator

In a case where an acid color developing agent is used as a discoloring compound, the outermost layer preferably contains an acid generator.

"Acid generator" in the present disclosure is a compound that generates an acid by light or heat. Specifically, the acid generator refers to a compound that generates an acid by being decomposed by exposure to infrared.

The acid to be generated is preferably a strong acid having a pKa of 2 or less, such as sulfonic acid or hydrochloric acid. The acid generated from the acid generator enables the acid color developing agent to discolor.

Specifically, as the acid generator, from the viewpoint of sensitivity and stability, an onium salt compound is preferable.

Specific examples of onium salts suitable as the acid generator include the compounds described in paragraphs "0121" to "0124" of WO2016/047392A.

Particularly, sulfonate, carboxylate, $BPh_4^-$, $BF_4^-$, $PF_6^-$, $ClO_4^-$ of triarylsulfonium or diaryliodonium, and the like are preferable. Ph represents a phenyl group.

One acid generator may be used alone, or two or more acid generators may be used in combination.

In a case where the outermost layer contains an acid generator, the content of the acid generator with respect to the total mass of the outermost layer is preferably 0.5% by mass to 30% by mass, and more preferably 1% by mass to 20% by mass.

· Additive

The outermost layer may contain known additives such as an oil sensitizing agent (for example, the oil sensitizing agent described in the image-recording layer), a plasticizer, and a surfactant, in addition to the above-described components.

The outermost layer is formed by coating and drying by a known method.

The coating amount of the outermost layer (solid content) is preferably 0.01 g/m$^2$ to 10 g/m$^2$, more preferably 0.02 g/m$^2$ to 3 g/m$^2$, and particularly preferably 0.1 g/m$^2$ to 2.0 g/m$^2$.

The film thickness of the outermost layer is preferably 0.1 $\mu$m to 5.0 $\mu$m, and more preferably 0.3 $\mu$m to 4.0 $\mu$m.

The film thickness of the outermost layer is preferably 0.1 times to 5.0 times the film thickness of the image-recording layer which will be described later, and more preferably 0.2 times to 3.0 times the film thickness of the image-recording layer which will be described later.

<Support>

The lithographic printing plate precursor according to the present disclosure has a support.
The support to be used can be appropriately selected from known supports for a lithographic printing plate precursor.
As the support, a support having a hydrophilic surface (hereinafter, also called "hydrophilic support") is preferable.
As the support in the present disclosure, an aluminum plate is preferable of which the surface has been roughened using a known method and has undergone an anodization treatment. That is, the support in the present disclosure preferably has an aluminum plate and an anodic oxide film of aluminum disposed on the aluminum plate.
The aforementioned support preferably has an aluminum plate and an anodic oxide film of aluminum disposed on the aluminum plate, the anodic oxide film is preferably at a position closer to a side of the image-recording layer than the aluminum plate and preferably has micropores extending in a depth direction from the surface of the anodic oxide film on the side of the image-recording layer, and the average diameter of the micropores within the surface of the anodic oxide film is preferably more than 10 nm and 100 nm or less.
Furthermore, the micropores are preferably each composed of a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communicate position, an average diameter of the large diameter portion within the surface of the anodic oxide film is preferably 15 nm to 100 nm, and an average diameter of the small diameter portion at the communicate position is preferably 13 nm or less.
Fig. 1 is a schematic cross-sectional view of an embodiment of an aluminum support 12a.
The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned such that the anodic oxide film 20a is closer to the image-recording layer side than the aluminum plate 18. That is, it is preferable that the lithographic printing plate precursor according to the present disclosure have at least an anodic oxide film, an image-recording layer, and a water-soluble resin layer in this order on an aluminum plate.

-Anodic oxide film-

Hereinafter, preferred aspects of the anodic oxide film 20a will be described.
The anodic oxide film 20a is a film prepared on a surface of the aluminum plate 18 by an anodization treatment. This film has uniformly distributed ultrafine micropores 22a approximately perpendicular to the surface of the film. The micropores 22a extend from a surface of the anodic oxide film 20a on the image-recording layer side (a surface of the anodic oxide film 20a opposite to the aluminum plate 18) along the thickness direction (toward the aluminum plate 18).
The average diameter (average opening diameter) of the micropores 22a on the surface of the anodic oxide film 20a is preferably more than 10 nm and 100 nm or less. Particularly, from the viewpoint of balance between printing durability, antifouling properties, and image visibility, the average diameter of the micropores 22a is more preferably 15 nm to 60 nm, even more preferably 20 nm to 50 nm, and particularly preferably 25 nm to 40 nm. The internal diameter of the pores may be larger or smaller than the pore diameter within the surface layer.
In a case where the average diameter is more than 10 nm, printing durability and image visibility are excellent. Furthermore, in a case where the average diameter is 100 nm or less, printing durability is excellent.
The average diameter of the micropores 22a is a value determined by observing the surface of the anodic oxide film 20a with a field emission scanning electron microscope (FE-SEM) at 150,000X magnification (N = 4), measuring the size (diameter) of 50 micropores existing in a range of 400 nm $\times$ 600 nm in the obtained 4 images, and calculating the arithmetic mean thereof.
In a case where the shape of the micropores 22a is not circular, the equivalent circular diameter is used. "Equivalent circular diameter" is a diameter determined on an assumption that the opening portion is in the form of a circle having the same projected area as the projected area of the opening portion.
The shape of the micropores 22a is not particularly limited. In Fig. 1, the micropores 22a have a substantially straight tubular shape (substantially cylindrical shape). However, the micropores 22a may have a conical shape that tapers along the depth direction (thickness direction). The shape of the bottom portion of the micropores 22a is not particularly limited, and may be a curved (convex) or flat surface shape.
In the support, the micropores may be each composed of a large diameter portion that extends to a position at a certain depth from the surface of the anodic oxide film and a small diameter portion that is in communication with a bottom

portion of the large diameter portion and extends to a position at a certain depth from the communicate position.

For example, as shown in Fig. 2, an aspect may be adopted in which an aluminum support 12b includes an aluminum plate 18 and an anodic oxide film 20b having micropores 22b each composed of a large diameter portion 24 and a small diameter portion 26.

For example, the micropores 22b in the anodic oxide film 20b are each composed of the large diameter portion 24 that extends to a position at a depth of 10 nm to 1,000 nm (depth D: see Fig. 2) from the surface of the anodic oxide film and the small diameter portion 26 that is in communication with the bottom portion of the large diameter portion 24 and further extends from the communicate position to a position at a depth of 20 nm to 2,000 nm. Specifically, for example, it is possible to use the aspect described in paragraphs "0107" to "0114" of JP2019-162855A.

-Manufacturing method of support-

As a manufacturing method of the support used in the present disclosure, for example, a manufacturing method is preferable in which the following steps are sequentially performed.

· Roughening treatment step: step of performing roughening treatment on aluminum plate
· Anodization treatment step: step of subjecting aluminum plate having undergone roughening treatment to anodic oxidation
· Pore widening treatment step: aluminum having an anodic oxide film obtained in the anodization treatment step

A step of bringing the plate into contact with an aqueous acid solution or an aqueous alkali solution to enlarge the diameter of the micropores in the anodic oxide film.

Hereinafter, the procedure of each step will be specifically described.

<<Roughening treatment step>>

The roughening treatment step is a step of performing a roughening treatment including an electrochemical roughening treatment on the surface of the aluminum plate. This step is preferably performed before the anodization treatment step which will be described later. However, in a case where the surface of the aluminum plate already has a preferable shape, the roughening treatment step may not be performed. This step can be carried out by the method described in paragraphs "0086" to "0101" of JP2019-162855A.

<<Anodization treatment step>>

The procedure of the anodization treatment step is not particularly limited as long as the aforementioned micropores can be obtained. Examples thereof include known methods.

In the anodization treatment step, an aqueous solution of sulfuric acid, phosphoric acid, oxalic acid, or the like can be used as an electrolytic cell. For example, the concentration of sulfuric acid is 100 g/L to 300 g/L.

The conditions of the anodization treatment are appropriately set depending on the electrolytic solution used. For example, the liquid temperature is 5°C to 70°C (preferably 10°C to 60°C), the current density is 0.5 A/dm$^2$ to 60 A/dm$^2$ (preferably 1 A/dm$^2$ to 60 A/dm$^2$), the voltage is 1 V to 100 V (preferably 5 V to 50 V), the electrolysis time is 1 second to 100 seconds (preferably 5 seconds to 60 seconds), and the film amount is 0.1 g/m$^2$ to 5 g/m$^2$ (preferably 0.2 g/m$^2$ to 3 g/m$^2$).

<<Pore widening treatment>>

The pore widening treatment is a treatment of enlarging the diameter of micropores (pore diameter) present in the anodic oxide film formed by the aforementioned anodization treatment step (pore diameter enlarging treatment).

The pore widening treatment can be carried out by bringing the aluminum plate obtained by the anodization treatment step into contact with an aqueous acid solution or an aqueous alkali solution. The contact method is not particularly limited, and examples thereof include a dipping method and a spraying method.

As necessary, the support may have a backcoat layer on the side opposite to the image-recording layer, the backcoat layer containing the organic polymer compound described in JP1993-045885A (JP-H5-45885A) or the alkoxy compound of silicon described in JP1994-035174A (JP-H6-35174A).

<Undercoat layer>

The lithographic printing plate precursor according to the embodiment of the present disclosure preferably has an undercoat layer between the image-recording layer and the support. The undercoat layer is also referred to as an

interlayer. The undercoat layer enhances the adhesion between the support and the image-recording layer in an exposed portion, and enables the image-recording layer to be easily peeled from the support in a non-exposed portion. Therefore, the undercoat layer contributes to the improvement of developability without deteriorating printing durability. Furthermore, in the case of exposure to infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent groups that can be adsorbed onto the surface of the support and hydrophilic groups. In order to improve adhesiveness to the image-recording layer, polymers having adsorbent groups and hydrophilic groups and crosslinking groups are preferable. The compounds that are used in the undercoat layer may be low-molecular-weight compounds or polymers. As necessary, as the compounds that are used in the undercoat layer, two or more compounds may be used by being mixed together.

In a case where the compound used in the undercoat layer is a polymer, a copolymer of a monomer having an adsorbent group, a monomer having a hydrophilic group, and a monomer having a crosslinking group is preferable.

As the adsorbent group that can be adsorbed onto the surface of the support, a phenolic hydroxyl group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinking groups, an acryloyl group, a methacryloyl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bonding groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinking groups described in JP2005-125749A and JP2006-188038A are more preferable.

The content of ethylenically unsaturated bonding group in the polymer used in the undercoat layer is preferably 0.1 mmol to 10.0 mmol per gram of the polymer, and more preferably 0.2 mmol to 5.5 mmol per gram of the polymer.

The weight-average molecular weight (Mw) of the polymer used in the undercoat layer is preferably 5,000 or more, and more preferably 10,000 to 300,000.

-Hydrophilic compound-

From the viewpoint of developability, it is preferable that the undercoat layer contain a hydrophilic compound.

The hydrophilic compound is not particularly limited, and known hydrophilic compounds used for the undercoat layer can be used.

Preferred examples of the hydrophilic compound include phosphonic acids having an amino group such as carboxymethyl cellulose and dextrin, an organic phosphonic acid, an organic phosphoric acid, an organic phosphinic acid, amino acids, a hydrochloride of an amine having a hydroxy group, and the like.

In addition, examples of preferable hydrophilic compounds include a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, ethylenediaminetetraacetic acid (EDTA) or a salt thereof, hydroxyethyl ethylenediaminetriacetic acid or a salt thereof, dihydroxyethyl ethylenediaminediacetic acid or a salt thereof, hydroxyethyl iminodiacetic acid or a salt thereof, and the like).

From the viewpoint of scratch and contamination suppressiveness, it is preferable that the hydrophilic compound include hydroxycarboxylic acid or a salt thereof.

Furthermore, from the viewpoint of scratch and contamination suppressiveness, it is preferable that the hydrophilic compound (preferably hydroxycarboxylic acid or a salt thereof) be contained in a layer on the aluminum support. The layer on the aluminum support is preferably a layer on the side where the image-recording layer is formed or a layer in contact with the aluminum support.

Preferred examples of the layer on the aluminum support include a layer in contact with the aluminum support, such as the undercoat layer or the image-recording layer. Furthermore, a layer other than the layer in contact with the aluminum support, for example, the outermost layer or the image-recording layer may contain a hydrophilic compound (preferably hydroxycarboxylic acid or a salt thereof).

In the lithographic printing plate precursor according to the present disclosure, from the viewpoint of scratch and

contamination suppressiveness, it is preferable that the image-recording layer contain hydroxycarboxylic acid or a salt thereof.

Moreover, regarding the lithographic printing plate precursor according to the present disclosure, for example, an aspect is also preferable in which the surface of the aluminum support on the image-recording layer side is treated with a composition (for example, an aqueous solution or the like) containing at least hydroxycarboxylic acid or a salt thereof. In a case where the above aspect is adopted, at least some of the hydroxycarboxylic acid or a salt thereof used for treatment can be detected in a state of being contained in the layer on the image-recording layer side (for example, the image-recording layer or the undercoat layer) that is in contact with the aluminum support.

In a case where the layer on the side of the image-recording layer that is in contact with the aluminum support, such as the undercoat layer, contains hydroxycarboxylic acid or a salt thereof, the surface of the aluminum support on the image-recording layer side can be hydrophilized, and it is easy for the surface of the aluminum support on the image-recording layer side to have a water contact angle of 110° or less measured by an airborne water droplet method, which result in excellent scratch and contamination suppressiveness.

"Hydroxycarboxylic acid" is the generic term for organic compounds having one or more carboxy groups and one or more hydroxy groups in one molecule. These compounds are also called hydroxy acid, oxy acid, oxycarboxylic acid, or alcoholic acid (see Iwanami Dictionary of Physics and Chemistry, 5th Edition, published by Iwanami Shoten, Publishers. (1998)).

The hydroxycarboxylic acid or a salt thereof is preferably represented by Formula (HC).

$$R^{HC}(OH)_{mhc}(COOM^{HC})_{nhc} \qquad \text{Formula (HC)}$$

In Formula (HC), $R^{HC}$ represents an (mhc + nhc)-valent organic group, $M^{HC}$ each independently represent a hydrogen atom, an alkali metal, or an onium, and mhc and nhc each independently represent an integer of 1 or more. In a case where n is 2 or more, $M^{HC}$ may be the same as or different from each other.

Examples of the (mhc + nhc)-valent organic group represented by $R^{HC}$ in Formula (HC) include an (mhc + nhc)-valent hydrocarbon group and the like. The hydrocarbon group may have a substituent and/or a linking group.

Examples of the hydrocarbon group include an (mhc + nhc)-valent group derived from aliphatic hydrocarbon, such as an alkylene group, an alkanetriyl group, an alkanetetrayl group, an alkanepentayl group, an alkenylene group, an alkenetriyl group, an alkenetetrayl group, and alkenepentayl group, an alkynylene group, an alkynetriyl group, alkynetetrayl group, or an alkynepentayl group, an (mhc + nhc)-valent group derived from aromatic hydrocarbon, such as an arylene group, an arenetriyl group, an arenetetrayl group, or an arenepentayl group, and the like. Examples of the substituent include an alkyl group, an alkenyl group, an alkynyl group, an aralkyl group, an aryl group, and the like. Specific examples of the substituent include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, eicosyl group, isopropyl group, isobutyl group, s-butyl group, t-butyl group, isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a methoxymethyl group, a methoxyethoxyethyl group, an allyloxymethyl group, a phenoxymethyl group, an acetyloxymethyl group, a benzoyloxymethyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, a 3-butynyl group, a phenyl group, a biphenyl group, a naphthyl group, a tolyl group, a xylyl group, a mesityl group, a cumenyl group, a methoxyphenyl group, an ethoxyphenyl group, a phenoxyphenyl group, an acetoxyphenyl group, a benzoyloxyphenyl group, a methoxycarbonylphenyl group, an ethoxycarbonylphenyl group, a phenoxycarbonylphenyl group, and the like. Furthermore, the linking group is composed of at least one atom selected from the group consisting of a hydrogen atom, a carbon atom, an oxygen atom, a nitrogen atom, a sulfur atom, and a halogen atom, and the carbon number is preferably 1 to 50. Specific examples thereof include an alkylene group, a substituted alkylene group, an arylene group, a substituted arylene group, and the like. The linking group may have a structure in which a plurality of these divalent groups is linked through any of an amide bond, an ether bond, a urethane bond, a urea bond, and an ester bond.

Examples of the alkali metal represented by $M^{HC}$ include lithium, sodium, potassium, and the like. Among these, sodium is particularly preferable. Examples of the onium include ammonium, phosphonium, sulfonium, and the like. Among these, ammonium is particularly preferable.

From the viewpoint of scratch and contamination suppressiveness, $M^{HC}$ is preferably an alkali metal or an onium, and more preferably an alkali metal.

The sum of mhc and nhc is preferably 3 or more, more preferably 3 to 8, and even more preferably 4 to 6.

The molecular weight of the hydroxycarboxylic acid or a salt thereof is preferably 600 or less, more preferably 500 or less, and particularly preferably 300 or less. The molecular weight is preferably 76 or more.

Specifically, examples of the hydroxycarboxylic acid constituting the hydroxycarboxylic acid or a salt of the

hydroxycarboxylic acid include gluconic acid, glycolic acid, lactic acid, tartronic acid, hydroxybutyrate (such as 2-hydroxybutyrate, 3-hydroxybutyrate, or γ-hydroxybutyrate), malic acid, tartaric acid, citramalic acid, citric acid, isocitric acid, leucine acid, mevalonic acid, pantoic acid, ricinoleic acid, ricineraidic acid, cerebronic acid, quinic acid, shikimic acid, a monohydroxybenzoic acid derivative (such as salicylic acid, creosotic acid (homosalicylic acid, hydroxy(methyl) benzoate), vanillic acid, or syringic acid), a dihydroxybenzoic acid derivative (such as pyrocatechuic acid, resorcylic acid, protocatechuic acid, gentisic acid, or orsellinic acid), a trihydroxybenzoic acid derivative (such as gallic acid), a phenyl acetate derivative (such as mandelic acid, benzilic acid, or atrolactic acid), a hydrocinnamic acid derivative (such as melilotic acid, phloretic acid, coumaric acid, umbellic acid, caffeic acid, ferulic acid, sinapic acid, cerebronic acid, or carminic acid), and the like.

Among these, as the aforementioned hydroxycarboxylic acid or a hydroxycarboxylic acid constituting a salt of the hydroxycarboxylic acid, from the viewpoint of scratch and contamination suppressiveness, a compound having two or more hydroxy groups is preferable, a compound having 3 or more hydroxy groups is more preferable, a compound having 5 or more hydroxy groups is even more preferable, and a compound having 5 to 8 hydroxy groups is particularly preferable.

Furthermore, as a hydroxycarboxylic acid having one carboxy group and two or more hydroxy groups, gluconic acid or shikimic acid is preferable.

As hydroxycarboxylic acid having two or more carboxy groups and one hydroxy group, citric acid or malic acid is preferable.

As hydroxycarboxylic acid having two or more carboxy groups and two or more hydroxy groups, tartaric acid is preferable.

Among these, gluconic acid is particularly preferable as the aforementioned hydroxycarboxylic acid.

One hydrophilic compound may be used alone, or two or more hydrophilic compounds may be used in combination.

In a case where the undercoat layer contains a hydrophilic compound (preferably hydroxycarboxylic acid or a salt thereof), the content of the hydrophilic compound (preferably hydroxycarboxylic acid or a salt thereof) with respect to the total mass of the undercoat layer is preferably 0.01% by mass to 50% by mass, more preferably 0.1% by mass to 40% by mass, and even more preferably 1.0% by mass to 30% by mass.

In order to prevent contamination over time, the undercoat layer may contain a chelating agent, a secondary or tertiary amine, a polymerization inhibitor, and the like, in addition to the following compounds for an undercoat layer.

The undercoat layer is formed by known coating methods.

The coating amount (solid content) of the undercoat layer is preferably 0.1 mg/$m^2$ to 300 mg/$m^2$, and more preferably 5 mg/$m^2$ to 200 mg/$m^2$.

The lithographic printing plate precursor according to the present disclosure may have other layers aside from those described above.

Known layers can be adopted as those other layers without particular limitations. For example, as necessary, a backcoat layer may be provided on a side of the support that is opposite to the image-recording layer side.

(Method of preparing lithographic printing plate and lithographic printing method)

The method of preparing a lithographic printing plate according to the present disclosure preferably includes a step of exposing the lithographic printing plate precursor according to the present disclosure in the shape of an image (exposure step) and a step of removing the image-recording layer having undergone exposure in a non-image area by supplying at least one material selected from the group consisting of a printing ink and dampening water on a printer (on-press development step).

The lithographic printing method according to the present disclosure preferably includes a step of exposing the lithographic printing plate precursor according to the present disclosure in the shape of an image (exposure step), a step of removing the image-recording layer in a non-image area by supplying at least one material selected from the group consisting of a printing ink and dampening water on a printer such that a lithographic printing plate is prepared (on-press development step), and a step of performing printing by using the obtained lithographic printing plate (hereinafter, also called "printing step").

<Exposure step>

The method of preparing a lithographic printing plate according to the present disclosure preferably includes an exposure step of exposing the lithographic printing plate precursor according to the present disclosure in the shape of an image such that an exposed portion and a non-exposed portion are formed. The lithographic printing plate precursor according to the present disclosure is preferably exposed to a laser through a transparent original picture having a linear image, a halftone dot image, or the like or exposed in the shape of an image by laser light scanning according to digital data or the like.

The wavelength of a light source to be used is preferably 750 nm to 1,400 nm. As the light source having a wavelength of 750 nm to 1,400 nm, a solid-state laser or a semiconductor laser that radiates infrared is suitable. In a case where an infrared laser is used, the output is preferably 100 mW or higher, the exposure time per pixel is preferably 20 microseconds or less, and the amount of irradiation energy is preferably 10 $mJ/cm^2$ to 300 $mJ/cm^2$. In addition, in order to shorten the exposure time, a multibeam laser device is preferably used. The exposure mechanism may be any one of an in-plane drum method, an external surface drum method, a flat head method, or the like.
The image exposure can be carried out by a common method using a platesetter or the like. In the case of on-press development, image exposure may be carried out on a printer after the lithographic printing plate precursor is mounted on the printer.
In addition, the setting of each parameter such as SD (focal depth), Slop (the linear slope of a laser), and Curve (the arrangement curvature of a laser) at the time of exposure may be performed separately.
In the parameter setting, development may be performed using an ink and dampening water described later, exposure in an image form may be performed for parameter setting, or development may be performed using a liquid other than the ink and the dampening water. The liquid other than the ink and the dampening water may be a liquid that can be developed on the machine, and examples thereof include a developer, a finisher liquid, and a finisher gum liquid.
In addition, in a case where development is performed using a liquid other than the ink and the dampening water, after the development, the plate surface may be washed with water or the like, or in order to further improve the visibility of the image area, an acidic aqueous solution may be brought into contact with the plate surface. The acid contained in the acidic aqueous solution is not particularly limited, and suitable examples thereof include carboxylic acids such as acetic acid, hydroxycarboxylic acids such as citric acid, and salts thereof, and citric acid is particularly preferable. In addition, at least one selected from water or a solvent in which an acid is dissolved may be used for the preparation of the acidic aqueous solution.
The solvent used for the preparation of the acidic aqueous solution is not particularly limited, but from the viewpoint of acid solubility and on-press developability, a mixed solvent consisting of water and ethanol is suitably exemplified. A kitchen alcohol disinfectant solution may be used as the solvent. The method of bringing the above-described development solution, washing solution, and acidic aqueous solution into contact with each other is not particularly limited, and the development solution, washing solution, and acidic aqueous solution can be brought into contact with each other by a known method. Examples thereof suitably include a method of coating a plate surface with a sponge, a waste cloth, or the like.

<On-press development step>

The method of preparing a lithographic printing plate according to the present disclosure preferably includes an on-press development step of removing the image-recording layer in a non-image area by supplying at least one selected from the group consisting of printing ink and dampening water on a printer.
Hereinafter, the on-press development method will be described.

[On-press development method]

In the on-press development method, the lithographic printing plate precursor having undergone image exposure is preferably supplied with an oil-based ink and an aqueous component on a printer, such that the image-recording layer in a non-image area is removed and a lithographic printing plate is prepared.
That is, in a case where the lithographic printing plate precursor is subjected to image exposure and then directly mounted on a printer without being subjected to any development treatment, or in a case where the lithographic printing plate precursor is mounted on a printer, subjected to image exposure on the printer, and then supplied with an oil-based ink and an aqueous component for printing, at the initial stage in the middle of printing, in a non-image area, a non-cured image-recording layer is removed by either or both of the supplied oil-based ink and the aqueous component by means of dissolution or dispersion, and the hydrophilic surface is exposed in the non-image area. On the other hand, in an exposed portion, the image-recording layer cured by exposure forms an oil-based ink-receiving portion having a lipophilic surface. What is supplied first to the plate surface may be any of the oil-based ink or the aqueous component. However, in view of preventing the plate from being contaminated by the components of the image-recording layer from which aqueous components are removed, it is preferable that the oil-based ink be supplied first. In the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.
As the laser used for performing image exposure on the lithographic printing plate precursor according to the present disclosure, a light source having a wavelength of 750 nm to 1,400 nm is preferably used. As the light source having a wavelength of 750 nm to 1,400 nm, the light sources described above are preferably used.

<Printing step>

The lithographic printing method according to the present disclosure includes a printing step of printing a recording medium by supplying a printing ink to the lithographic printing plate.
The printing ink is not particularly limited, and various known inks can be used as desired. In addition, preferred examples of the printing ink include oil-based ink or ultraviolet-curable ink (UV ink).
In the printing step, as necessary, dampening water may be supplied.
Furthermore, the printing step may be successively carried out after the on-press development step or the development step using a developer, without stopping the printer.
The recording medium is not particularly limited, and known recording media can be used as desired.
In the method of preparing a lithographic printing plate from the lithographic printing plate precursor according to the present disclosure and in the lithographic printing method according to the present disclosure, as necessary, the entire surface of the lithographic printing plate precursor may be heated as necessary before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

<Other aspects>

Another aspect of the method of preparing a lithographic printing plate according to the present disclosure includes a step of exposing the lithographic printing plate precursor according to the present disclosure (also referred to as an "image exposure step") and a step of supplying developer to remove a non-image area (also referred to as a "developer development step").
The plate-making method is also referred to as a "developer treatment system".
Another aspect of the lithographic printing method according to the present disclosure preferably is a method of printing by preparing a lithographic printing plate by using the lithographic printing plate precursor according to the present disclosure, and includes a step of exposing the lithographic printing plate precursor according to the present disclosure (also referred to as an "image exposure step"), and a step of supplying developer to remove a non-image area (also referred to as a "developer development step"), and a step of performing printing by the lithographic printing plate (also referred to as a "printing step").
In all of the "image exposure step", the "developer development step", and the "printing step", a known method may be applied according to the lithographic printing plate precursor to be applied.

Examples

Hereinafter, the present disclosure will be specifically described based on examples, but the present disclosure is not limited thereto. In the present examples, unless otherwise specified, "%" and "part" mean "% by mass" and "part by mass" respectively.

<Synthesis example of polymer P-1>

10.0 g of monomethyl propylene glycol (manufactured by FUJIFILM Wako Pure Chemical Corporation) was placed in a 200 mL triangular flask equipped with a stirrer, a cooling pipe, a nitrogen introduction pipe, and a thermometer, the internal temperature was set to 80°C, and the flask was purged with nitrogen. A solution obtained by mixing 7.2 g of a monomer K-1 (product name: SILAPLANE TM-0701T, manufactured by JNC Corporation), 10.8 g of a monomer H-23 (2-hydroxyethyl methacrylate, manufactured by FUJIFILM Wako Pure Chemical Corporation), 0.72 g of dimethyl 2,2'-azobis(isobutyrate) (manufactured by FUJIFILM Wako Pure Chemical Corporation), and 28.8 g of monomethyl propylene glycol was added dropwise thereto over 2 hours. A mixed solution of 0.07 g of dimethyl 2,2'-azobis(isobutyrate) and 3.3 g of monomethyl propylene glycol was added thereto, the mixture was stirred at an internal temperature of 80°C for 1 hour, the internal temperature was raised to 100°C, and the mixture was further heated for 2 hours, thereby obtaining a polymer P-1.
The obtained polymer P-1 had a weight-average molecular weight of 21,600 and a molecular weight distribution of 6.1 (calculated in terms of polystyrene under the measurement conditions of an eluent of THF, a flow rate of 0.35 ml/min, and a temperature of 40°C, and columns used of TSKgel SuperHZM-H, TSKgel SuperHZ4000, and TSKgel SuperHZ200

(manufactured by Tosoh Corporation), using gel permeation chromatography (EcoSEC HLC-8320GPC (manufactured by Tosoh Corporation)).

<Synthesis example of polymer P-2>

A polymer P-2 was synthesized in the same manner as in the synthesis example of the polymer P-1, except that the monomer H-23 was replaced with a monomer H-24 (2-hydroxyethyl acrylamide, manufactured by Tokyo Chemical Industry Co., Ltd.).

<Synthesis example of polymer P-3>

A polymer P-3 was synthesized in the same manner as in the synthesis example of the polymer P-1, except that the monomer H-23 was changed to the monomer H-7 (n = 9) (trade name: BLEMMER PP-500, manufactured by NOF Corporation).

<Synthesis example of polymer P-4>

A polymer P-4 was synthesized in the same manner as in the synthesis example of the polymer P-1, except that the amount of the monomer K-1 was changed to 9.0 g, the monomer H-23 was changed to a monomer H-7 (n = 9) (product name: BLEMMER PP-500, manufactured by NOF Corporation), and the amount of the monomer H-7 was changed to 9.0 g.

<Synthesis example of polymer P-5>

A polymer P-5 was synthesized in the same manner as in the synthesis example of the polymer P-1, except that the amount of the monomer K-1 was changed to 10.8 g, the monomer H-23 was changed to the monomer H-7 (n = 9) (product name: BLEMMER PP-500, manufactured by NOF Corporation), and the amount of the monomer H-7 was changed to 7.2 g.

<Synthesis example of polymer P-6>

A polymer P-6 was synthesized in the same manner as in the synthesis example of the polymer P-1, except that the amount of the monomer K-1 was changed to 5.4 g, the monomer H-23 was changed to a monomer H-7 (n = 9) (product name: BLEMMER PP-500, manufactured by NOF Corporation), and the amount of the monomer H-7 was changed to 12.6 g.

<Synthesis example of polymer P-7>

A polymer P-7 was synthesized in the same manner as in the synthesis example of the polymer P-1, except that the monomer H-23 was replaced with the monomer H-3 (n = 8) (product name: BLEMMER PE-350, manufactured by NOF Corporation) and the amount of the monomer H-3 was changed to 10.8 g.

<Synthesis example of polymer P-8>

A polymer P-8 was synthesized in the same manner as in the synthesis example of the polymer P-1, except that the monomer H-23 was replaced with the monomer H-3 (n = 8) (product name: BLEMMER PE-350, manufactured by NOF Corporation) and the amount of the monomer H-3 was changed to 0.8 g.

<Synthesis example of polymer P-9>

A polymer P-9 was synthesized in the same manner as in the synthesis example of the polymer P-1, except that the monomer H-23 was replaced with the monomer H-25 (n = 6) (product name: BLEMMER 10PPB-500B, manufactured by NOF Corporation) and the amount of the monomer H-25 was changed to 10.8 g.

<Synthesis example of polymer P-10>

A polymer P-10 was synthesized in the same manner as in the synthesis example of the polymer P-1, except that the monomer H-23 was replaced with the monomer H-14 (m = 3.5, n = 2.5) (product name: BLEMMER 50PEP-300,

manufactured by NOF Corporation) and the amount of the monomer H-14 was changed to 10.8 g.

<Synthesis example of polymer P-14>

A polymer P-14 was synthesized in the same manner as in the synthesis example of the polymer P-1, except that the monomer H-23 was replaced with the monomer H-4 (n = 4) (product name: BLEMMER PME-200, manufactured by NOF Corporation) and the amount of the monomer H-4 was changed to 10.8 g.

<Synthesis example of polymer P-16>

A polymer P-16 was synthesized in the same manner as in the synthesis example of the polymer P-1, except that the monomer H-23 was replaced with the monomer H-4 (n = 4) (trade name: BLEMMER PME-200, manufactured by NOF Corporation), the amount of the monomer K-1 was changed to 5.4 g, and the amount of the monomer H-4 was changed to 12.6 g.

The structures of the polymers P-1 to P-10, P-14, and P-16 synthesized as described above are shown below. In addition, a polymer P-11 having the structure shown below was prepared.

The weight-average molecular weights of the polymers P-1 to P-11, P-14, and P-16 are shown in Table 3.

P-1

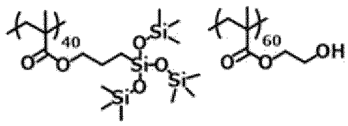

P-2

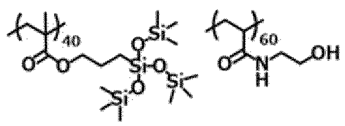

P-3

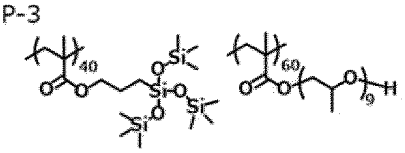

P-4

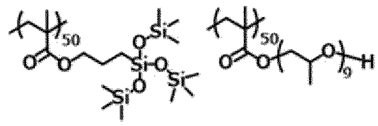

P-5

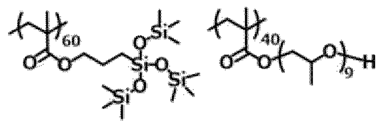

P-6

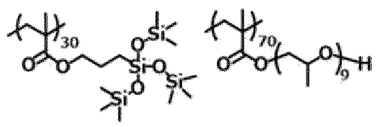

P-7

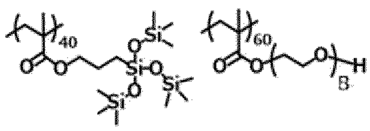

P-8

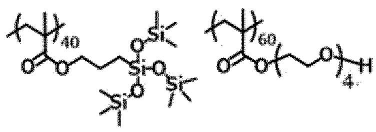

P-9

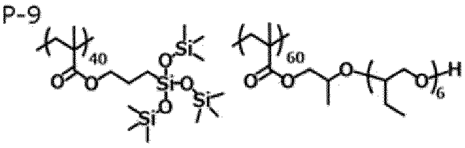

P-10

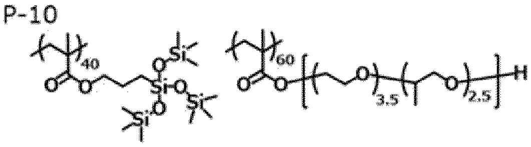

P-11

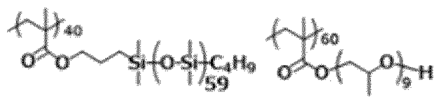

P-14

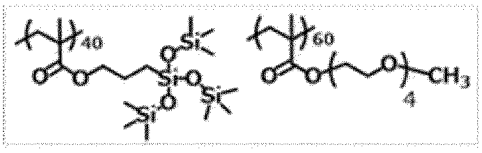

P-16

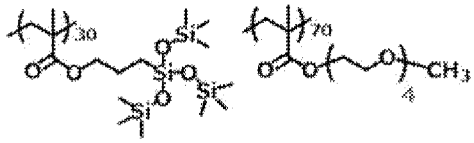

In addition, as a polymer for comparison, a polymer P-12 (manufactured by DIC Corporation, MEGAFACE (registered trademark: F-176PF), a polymer P-13 having the following structure, and a polymer P-15 were prepared.

The weight-average molecular weights of the polymers P-12, P-13, and P-15 are shown in Table 3.

P-12

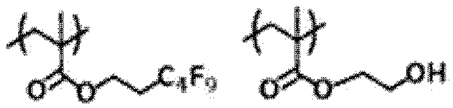

P-13

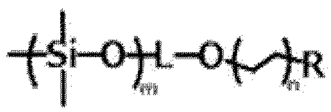

P-15

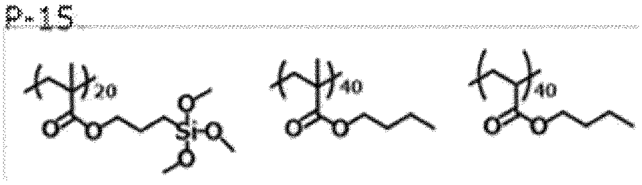

(Examples 1 to 16, 19, 25, 29, 30, Comparative Examples 1 to 3, 9: on-press development type lithographic printing plate precursor)

<Preparation of support A>

(Mechanical roughening treatment (brush graining method))

By using the device shown in Fig. 5, a pumice suspension (specific gravity: 1.1 g/$cm^3$) as an abrasive slurry was supplied to the surface of an aluminum plate, and in this state, a mechanical roughening treatment was performed using a rotating bundled brush. In Fig. 5, 1 represents an aluminum plate, 2 and 4 represent roller-shaped brushes (bundled brushes in the present example), 3 represents an abrasive slurry, and 5, 6, 7, and 8 represent support rollers.

In the mechanical roughening treatment, the median diameter (μm) of the abrasive was set to 30 μm, the number of brushes was set to 4, and the rotation speed per minute (rpm, the same applies hereinafter) of the brush was set to 250 rpm. The bundle brush was made of 6·10 nylon and consisted of bristles having a diameter of 0.3 mm and a bristle length of 50 mm. The brush was prepared by making holes in a φ 300 mm stainless steel cylinder and densely implanting bristles therein. The distance between two support rollers (φ 200 mm) under the bundle brush was 300 mm. The bundle brush was pressed until the load of the drive motor for rotating the brush was 10 kW or higher than the load applied before the bundle brush was pressed on the aluminum plate. The rotation direction of the brush was the same as the movement direction of the aluminum plate.

(Alkaline etching treatment)

An aqueous solution of caustic soda having a caustic soda concentration of 26% by mass and an aluminum ion concentration of 6.5% by mass was sprayed from a spray tube onto the aluminum plate obtained above at a temperature of 70°C, thereby performing an etching treatment. Then, rinsing was performed by means of spraying. The amount of dissolved aluminum was 10 g/$m^2$.

(Desmutting treatment in acidic aqueous solution)

Next, a desmutting treatment was performed in an aqueous nitric acid solution. As the aqueous nitric acid solution used in the desmutting treatment, the waste liquid of nitric acid used in the next step, electrochemical roughening, was used. The liquid temperature was 35°C. The desmutting treatment was performed for 3 seconds by spraying the desmutting liquid.

(Electrochemical roughening treatment)

An electrochemical roughening treatment was continuously performed using nitric acid as an electrolyte at an alternating current voltage of 60 Hz. In this treatment, an electrolytic solution was used which was prepared by adding aluminum nitrate to 10.4 g/L aqueous nitric acid aqueous solution at a temperature of 35°C such that the aluminum ion concentration was adjusted to 4.5 g/L. By using an alternating current power source having the waveform shown in Fig. 3, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 4 was used. The current density was 30 $A/dm^2$ in terms of the peak value of current, and 5% of the current coming from the power source was allowed to flow into the auxiliary anode. The quantity of electricity ($C/dm^2$) was 185 $C/dm^2$, which is the total quantity of electricity used during the anodization of the aluminum plate. Then, rinsing was performed by means of spraying.

(Alkaline etching treatment)

From a spray tube, an aqueous solution of caustic soda having a caustic soda concentration of 5% by mass and an aluminum ion concentration of 0.5% by mass was sprayed onto the aluminum plate obtained above at a temperature of 50°C, thereby performing an etching treatment. Then, rinsing was performed by means of spraying. The amount of dissolved aluminum was 0.5 $g/m^2$.

(Desmutting treatment in acidic aqueous solution)

Next, a desmutting treatment was performed in an aqueous sulfuric acid solution. In the desmutting treatment, an aqueous sulfuric acid solution having a sulfuric acid concentration of 170 g/L and an aluminum ion concentration of 5 g/L was used. The liquid temperature was 30°C. The desmutting treatment was performed for 3 seconds by spraying the desmutting liquid.

(Electrochemical roughening treatment)

An electrochemical roughening treatment was continuously performed using hydrochloric acid as an electrolyte at an alternating current voltage of 60 Hz. An electrolytic solution was used which was prepared by adding aluminum chloride to 6.2 g/L aqueous hydrochloric acid solution at a liquid temperature of 35°C such that the aluminum ion concentration was adjusted to 4.5 g/L. By using an alternating current power source having the waveform shown in Fig. 3, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 4 was used.

The current density was 25 $A/dm^2$ in terms of the peak value of current, and the quantity of electricity ($C/dm^2$) during the hydrochloric acid electrolysis was 63 $C/dm^2$ which is the total quantity of electricity used during the anodic reaction of the aluminum plate. Then, rinsing was performed by means of spraying.

(Alkaline etching treatment)

From a spray tube, an aqueous solution of caustic soda having a caustic soda concentration of 5% by mass and an aluminum ion concentration of 0.5% by mass was sprayed onto the aluminum plate obtained above at a temperature of 50°C, thereby performing an etching treatment. Then, rinsing was performed by means of spraying. The amount of dissolved aluminum was 0.1 $g/m^2$.

(Desmutting treatment in acidic aqueous solution)

Next, a desmutting treatment was performed in an aqueous sulfuric acid solution. Specifically, by using a waste liquid generated in the anodization treatment step (170 g/L aqueous sulfuric acid solution containing dissolved aluminum ions at 5 g/L), the desmutting treatment was performed for 4 seconds at a liquid temperature of 35°C. The desmutting treatment was performed for 3 seconds by spraying the desmutting liquid.

(First-stage anodization treatment)

By using the anodization device for direct current electrolysis having the structure shown in Fig. 6, a first-stage anodization treatment was performed. An anodic oxide film having a predetermined film thickness was formed by performing an anodization treatment under conditions listed in Table 1.

In the anodization treatment device 610, an aluminum plate 616 is transported as indicated by the arrow in Fig. 6. In a power supply tank 612 containing an electrolytic solution 618, the aluminum plate 616 is positively (+) charged by a power supply electrode 620. Further, the aluminum plate 616 is transported upward by a roller 622 in the power supply tank 612, redirected downward by a nip roller 624, transported toward an electrolytic treatment tank 614 in which an electrolytic solution 626 is stored, and redirected to the horizontal direction by a roller 628. Subsequently, the aluminum plate 616 is negatively (-) charged by an electrolysis electrode 630. As a result, an anodic oxide film is formed on the surface of the aluminum plate 616. The aluminum plate 616 exits from the electrolytic treatment tank 614 and is then transported for the next step. In the anodization treatment device 610, the roller 622, the nip roller 624, and the roller 628 constitute a direction change unit. Furthermore, in the inter-tank portion between the power supply tank 612 and the electrolytic treatment tank 614, the aluminum plate 616 is transported in a ridge shape and an inverted U shape by the rollers 622, 624, and 628. The power supply electrode 620 and the electrolysis electrode 630 are connected to a direct current power source 634. A cell wall 632 is disposed between the power supply tank 612 and the electrolytic treatment tank 614.

(Pore widening treatment)

Under the conditions shown in Table 1, the aluminum plate having undergone the above anodization treatment was immersed in an aqueous solution of caustic soda at a temperature of 35°C and having a caustic soda concentration of 5% by mass and an aluminum ion concentration of 0.5% by mass, thereby performing a pore widening treatment. Then, rinsing was performed by means of spraying.

(Second-stage anodization treatment)

By using the anodization device for direct current electrolysis having the structure shown in Fig. 6, a second-stage anodization treatment was performed. An anodic oxide film having a predetermined film thickness was formed by performing an anodization treatment under conditions listed in Table 1.

(Third-stage anodization treatment)

By using the anodization device for direct current electrolysis having the structure shown in Fig. 6, a third-stage anodization treatment was performed. An anodic oxide film having a predetermined film thickness was formed by performing an anodization treatment under conditions listed in Table 1.

By the above surface treatment, the supports A shown in Tables 1 and 2 were obtained.

Table 2 shows the average diameter (nm) of the large diameter portion in the anodic oxide film within the surface of the anodic oxide film having micropores obtained after the second anodization treatment step, the average diameter (nm) of the small diameter portion at a communicate position, the depth (nm) of the large diameter portion and the small diameter portion, the pit density (micropore density, unit; number of micropores/$\mu m^2$), and the thickness (nm) of the anodic oxide film from the bottom portion of the small diameter portion to the surface of the aluminum plate.

The average diameter of the micropores (average diameter of the large diameter portion and the small diameter portion) is a value obtained by observing the surface of the large diameter portion and the surface of the small diameter portion with FE-SEM at 150,000X magnification (N= 4), and measuring the diameters of micropores (large diameter portion and small diameter portion) in a range of 400 nm x 600 nm in the obtained 4 images, and calculating the average thereof. In a case where the large diameter portion was deep and it was difficult to measure the diameter of the small diameter portion, and in a case where an enlarged diameter portion in the small diameter portion was measured, the upper portion of the anodic oxide film was cut, and then various diameters were calculated.

The depth of the micropores (depth of the large diameter portion and the small diameter portion) is a value obtained by observing the cross section of the support (anodic oxide film) with FE-SEM (observation of the depth of the large diameter portion: 150,000X magnification, observation of the depth of the small diameter portion: 50,000X magnification), measuring the depths of 25 random micropores in the obtained image, and calculating the average thereof.

In Table 1, film amount (AD) in the column of first anodization treatment and film amount (AD) in the column of second anodization treatment represent the amount of film obtained by each treatment. As electrolytic solutions, the aqueous solutions containing the components in Table 1 were used.

[Table 1]

| Support | Surface treatment | First anodization treatment | | | | | | | Pore widening treatment | | | Second anodization treatment | | | | | | |
|---|---|---|---|---|---|---|---|---|---|---|---|---|---|---|---|---|---|---|
| | | Type of liquid | Liquid component | Component concentration | Temperature | Current density | Time | Coated film amount | Liquid component | Temperature | Time | Type of liquid | Liquid component | Component concentration | Temperature | Current density | Time | Coated film amount |
| Support A | A | Sulfuric acid | $H_2SO_4$/Al | 170/5 | 40 | 30 | 1.6 | 0.25 | NaOH 5%/Al 0.5% | 35 | 5 | Sulfuric acid | $H_2SO_4$/Al | 170/5 | 50 | 13 | 17 | 2.25 |

[Table 2]

| Support | Large diameter portion | | | | Small diameter portion | | | Thickness of anodic oxide film (nm) |
|---|---|---|---|---|---|---|---|---|
| | Average diameter (nm) | Shape | Micropore density (number/μm2) | Depth (nm) | Pore diameter of linking position (nm) | Shape | Depth (nm) | |
| Support A | 35 | Straight tubular shape | *500* | 100 | 10 | Straight tubular shape | 900 | 1,000 |

<Formation of undercoat layer A>

The support A was coated with the undercoat layer coating liquid having the following composition such that the dry coating amount was 0.1 g/m$^2$, to form an undercoat layer A.

-Undercoat layer coating liquid-

· Compound for undercoat layer (the above U-1, 11% aqueous solution): 0.10502 parts

· Sodium gluconate: 0.0700 parts

Surfactant (EMALEX (registered trademark) 710, manufactured by NIHON EMULSION Co., Ltd.): 0.00159 parts

· Preservative (BIOHOPE L, manufactured by K·I Chemical Industry Co., LTD.): 0.00149 parts

· Water: 2.8719 parts

(U-1)

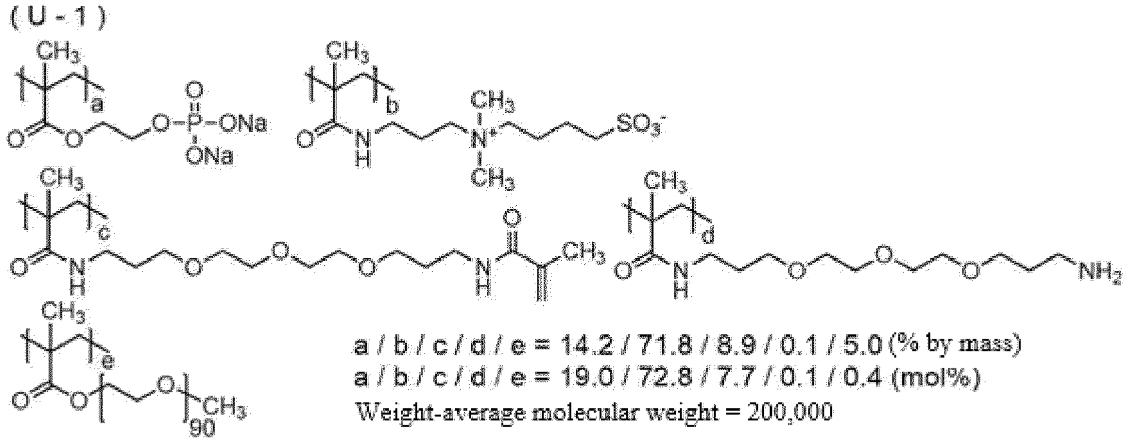

a / b / c / d / e = 14.2 / 71.8 / 8.9 / 0.1 / 5.0 (% by mass)
a / b / c / d / e = 19.0 / 72.8 / 7.7 / 0.1 / 0.4 (mol%)
Weight-average molecular weight = 200,000

<Formation of image-recording layer A>

The undercoat layer A was bar-coated with the following coating liquid for an image-recording layer A and dried in an oven at 120°C for 40 seconds, thereby forming an image-recording layer A having a dry coating amount of 1.0 g/m$^2$.

-Coating liquid for image-recording layer A-

Infrared absorber (the following IR-1): 0.0270 parts
Infrared absorber (the following IR-2): 0.0080 parts
Color developing agent (the following S-1): 0.0300 parts

Color developing agent (the following S-2): 0.0120 parts
Onium-based polymerization initiator (the following I-1): 0.1000 parts
Borate compound (sodium tetraphenylborate (TPB)): 0.0200 parts
Polymerizable compound (the following M-4): 0.2726 parts
Anionic surfactant (the following A-1): 0.0200 parts
Polymer shown in Table 3 below: amount (addition amount) shown in Table 3
2-Butanone: 4.9839 parts
1-Methoxy-2-propanol: 3.1009 parts
Methanol: 3.1239 parts

The following microgel liquid 1: 2.3256 parts

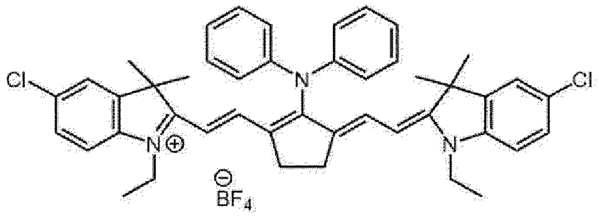

IR-1

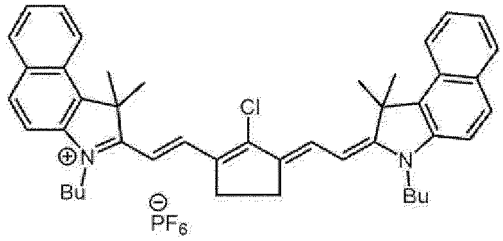

IR-2

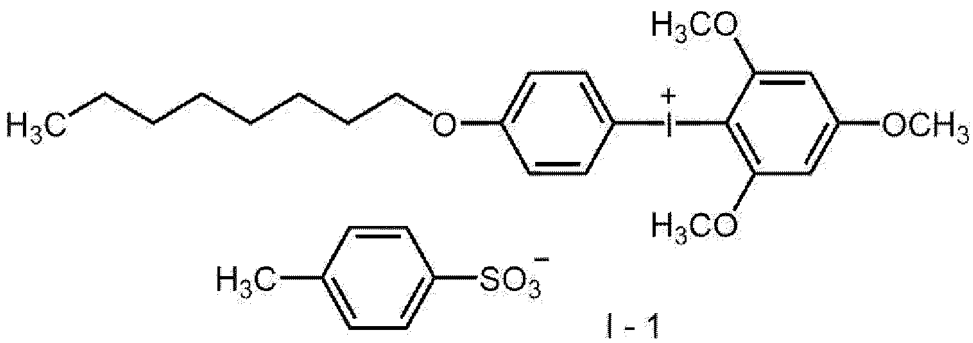

I - 1

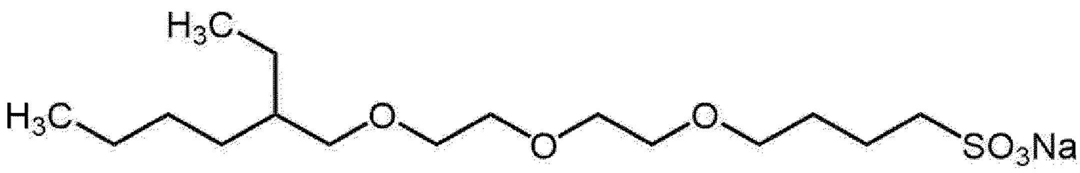

A - 1

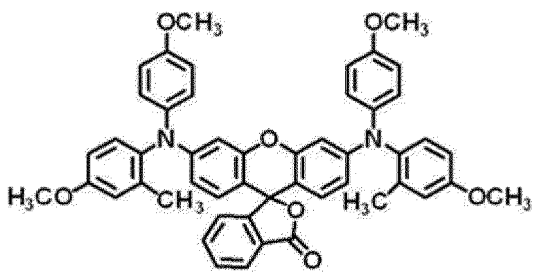

S-1

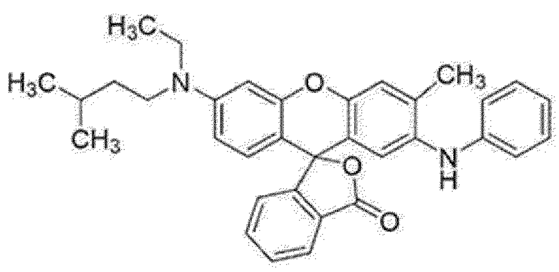

S-2

[Method of synthesizing polymerizable compound M-4]

A mixed solution of TAKENATE D-160N (polyisocyanate trimethylolpropane adduct, manufactured by Mitsui Chemicals, Inc., 4.7 parts), ARONIX M-403 (manufactured by TOAGOSEI CO., LTD., amount yielding the ratio of NCO value of TAKENATE D-160N:hydroxyl number of ARONIX M-403 = 1:1), t-butylbenzoquinone (0.02 parts), and methyl ethyl ketone (11.5 parts) was heated at 65°C. NEOSTANN U-600 (bismuth-based polycondensation catalyst, manufactured by NITTO KASEI Co., Ltd., 0.11 parts) was added to the reaction solution, and the reaction solution was heated at 65°C for 4 hours. The reaction solution was cooled to room temperature (25°C), and methyl ethyl ketone was added thereto, thereby synthesizing a urethane acrylate (polymerizable M-4) solution having a solid content of 50% by mass. By using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed. The weight-average molecular weight was 20,000.

[Synthesis method of microgel liquid 1]

-Preparation of oil-phase component-

A polyfunctional isocyanate compound (PM-200: manufactured by Wanhua Chemical Group Co., Ltd.): 6.66 g, a 50% by mass ethyl acetate solution of "TAKENATE (registered trademark) D-116N (adduct of trimethylolpropane (TMP)), m-xylylene diisocyanate (XDI), and polyethylene glycol monomethyl ether (EO90) (following structure)" manufactured by Mitsui Chemicals, Inc.: 5.46 g, a 65% by mass ethyl acetate solution of dipentaerythritol pentaacrylate (SR-399, manufactured by Sartomer Company Inc.): 11.24 g, ethyl acetate: 14.47 g, and PIONIN (registered trademark) A-41-C manufactured by TAKEMOTO OIL & FAT Co., Ltd.: 0.45 g were mixed together and stirred at room temperature (25°C) for 15 minutes, thereby obtaining an oil-phase component.

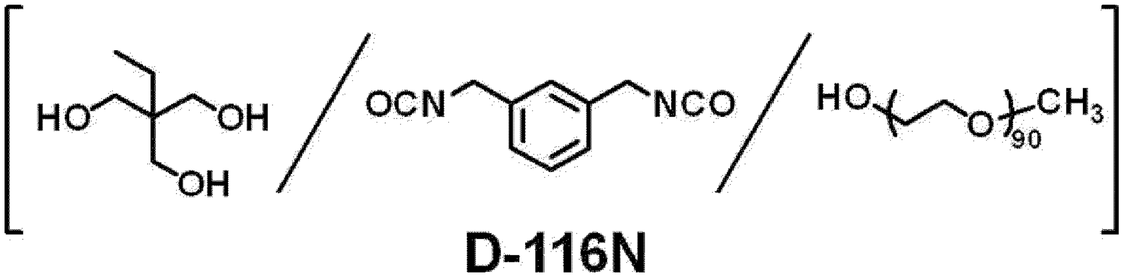

D-116N

-Preparation of water-phase component-

As a water-phase component, 47.2 g of distilled water was prepared.

-Microcapsule forming step-

The oil-phase component and the water-phase component were mixed together, and the obtained mixture was emulsified at 12,000 rpm for 16 minutes by using a homogenizer, thereby obtaining an emulsion.

16.8 g of distilled water was added to the obtained emulsion, and the obtained liquid was stirred at room temperature for 10 minutes.

After stirring, the liquid was heated at 45°C, and stirred for 4 hours in a state of being kept at 45°C such that ethyl acetate was distilled away from the liquid. Then, a 10% by mass aqueous solution of 5.12 g of 1,8-diazabicyclo[5.4.0]undeca-7-ene-octylate (U-CAT SA102, manufactured by San-Apro Ltd.) was added thereto, and the solution was stirred at room temperature for 30 minutes and left to stand at 45°C for 24 hours. Distilled water was added thereto such that the concentration of solid contents was adjusted to 20% by mass, thereby obtaining an aqueous dispersion of microgel 1. Microgel 1 had a volume average particle diameter of 165 nm that was measured using a laser diffraction/scattering-type particle diameter distribution analyzer LA-920 (manufactured by Horiba Ltd.).

<Formation of outermost layer (protective layer) A>

The image-recording layer was bar-coated with the following coating liquid for a protective layer and dried in an oven at 120°C for 60 seconds to form an outermost layer (protective layer) A having a dry coating amount of 0.1 g/m$^2$, thereby preparing a lithographic printing plate precursor.

-Coating solution for protective layer-

Inorganic lamellar compound dispersion (1): 0.5625 parts
Hydrophilic polymer (1) (20% aqueous solution of the following compound): 0.0825 parts
METOLOSE SM04 (methyl cellulose, manufactured by Shin-Etsu Chemical Co., Ltd., methoxy substitution degree = 1.8): 0.0250 parts
RAPISOL A-80 (anionic surfactant, manufactured by NOF CORPORATION, 80% aqueous solution): 0.0007 parts
Deionized water: 4.3300 parts

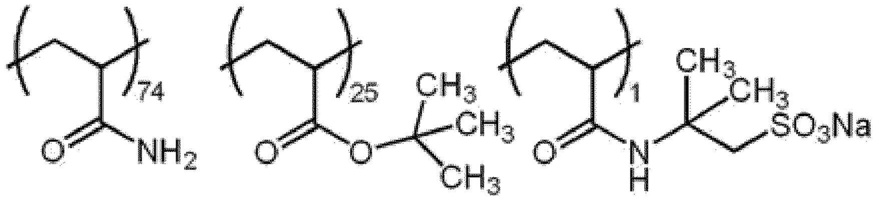

Hydrophilic polymer (1)

(Examples 17 to 18, 26, 31, and 32)

<Production of support B>

An aluminum plate (aluminum alloy plate) formed of a material 1S having a thickness of 0.3 mm was subjected to the following treatments to produce an aluminum support. A rinsing treatment was performed between all the treatment steps. After the rinsing treatment, water was drained using a nip roller.

(Alkaline etching treatment)

An aqueous solution of caustic soda having a caustic soda concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 5 g/$m^2$.

(Desmutting treatment using acidic aqueous solution)

Next, a desmutting treatment was performed using an acidic aqueous solution. Specifically, the desmutting treatment was performed for 3 seconds by spraying the aqueous acidic solution onto the aluminum plate. In the desmutting treatment, a 150 g/L aqueous sulfuric acid solution was used as the aqueous acidic solution. The liquid temperature was 30°C.

(Electrochemical roughening treatment)

Next, an electrochemical roughening treatment was performed using alternating current and an electrolytic solution having a hydrochloric acid concentration of 13 g/L, an aluminum ion concentration of 15 g/L, and a sulfuric acid concentration of 1.0 g/L. The liquid temperature of the electrolytic solution was 22°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1: 1, and the current density was 35 A/$dm^2$ in terms of the peak current value of the alternating current waveform. In addition, the quantity of electricity was 300 C/$dm^2$ which was the total quantity of electricity used for the aluminum plate to have an anodic reaction, and the electrolysis treatment was performed 4 times by conducting electricity of 75 C/$dm^2$ for 2.5 seconds at each treatment session. A carbon electrode was used as the counter electrode of the aluminum plate. Then, a rinsing treatment was performed.

(Alkaline etching treatment)

The aluminum plate after being subjected to the electrochemical roughening treatment was subjected to an etching treatment by spraying a caustic soda aqueous solution in which the concentration of caustic soda was 5% by mass and the concentration of aluminum ions was 0.5% by mass using a spray at a temperature of 45°C. The amount of dissolved aluminum within the surface having undergone the electrochemical roughening treatment was 0.2 g/$m^2$. Then, a rinsing treatment was performed.

(Desmutting treatment using acidic aqueous solution)

Next, a desmutting treatment was performed using an acidic aqueous solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 35°C.

(First-stage anodization treatment)

By using the anodization device for direct current electrolysis having the structure shown in Fig. 6, a first-stage anodization treatment was performed. An anodization treatment was performed under conditions of an electrolytic solution concentration of 150 g/L, a temperature of 50°C, and a current density of 15 A/dm2 to form an anodic oxide film having a predetermined film thickness.

(Pore widening treatment)

The aluminum plate after being subjected to the anodization treatment was subjected to a pore widening treatment by being immersed in a caustic soda aqueous solution having a caustic soda concentration of 5% by mass and an aluminum ion concentration of 0.5% by mass at a temperature of 40°C. Then, rinsing was performed by means of spraying.

(Second-stage anodization treatment)

By using the anodization device for direct current electrolysis having the structure shown in Fig. 6, a second-stage anodization treatment was performed. An anodization treatment was performed under conditions of an electrolytic solution concentration of 150 g/L, a temperature of 50°C, and a current density of 30 A/$dm^2$ to form an anodic oxide film having a predetermined film thickness thereby preparing an aluminum support.

<Formation of undercoat layer B>

The support B was coated with the undercoat layer coating liquid having the following composition such that the dry coating amount was 0.1 g/$m^2$, to form an undercoat layer B.

-Undercoat layer coating liquid-

· Compound for undercoat layer (following U-1, 11% aqueous solution): 0.0788 parts
· Chelest 400 (chelating agent; manufactured by Chelest Co., Ltd.): 0.0280 parts
· Chelest 3EAF (chelating agent; manufactured by Chelest Co., Ltd.): 0.0499 parts Surfactant (EMALEX (registered trademark) 710, manufactured by NIHON EMULSION Co., Ltd.): 0.00159 parts
· Preservative (BIOHOPE L, manufactured by K·I Chemical Industry Co., LTD.): 0.00149 parts
· Water: 2.8219 parts

<Formation of image-recording layer B>

The undercoat layer B was bar-coated with the following coating liquid for an image-recording layer B and dried in an oven at 120°C for 40 seconds, thereby forming an image-recording layer B having a dry coating amount of 1.0 g/$m^2$.

-Coating liquid for image-recording layer B-

Infrared absorber (IR-1 described above): 0.0200 parts
Infrared absorber (IR-2 described above): 0.0050 parts
Color developing agent (S-1 described above): 0.0300 parts
Color developing agent (S-2 described above): 0.0120 parts
Onium-based polymerization initiator (I-1 described above): 0.0981 parts
Borate compound (sodium tetraphenylborate (TPB)): 0.0270 parts
Polymerizable compound (M-4 described above, 70 %): 0.3536 parts
Polymer shown in Table 3 below: amount (addition amount) shown in Table 3
Anionic surfactant (A-1 described above, 30%): 0.1620 parts
2-Butanone: 5.3155 parts
1-Methoxy-2-propanol: 2.8825 parts
Methanol: 2.3391 parts

The above microgel liquid 1: 2.8779 parts

<Formation of outermost layer B (protective layer)>

The image-recording layer B was bar-coated with the following coating liquid for a protective layer and dried in an oven at 120°C for 60 seconds to form an outermost layer (protective layer) B having a dry coating amount of 0.41 g/m$^2$, thereby preparing a lithographic printing plate precursor.

-Coating solution for protective layer-

The following components were mixed to prepare a coating liquid for a protective layer.

Water: 1.0161 parts
METOLOSE SM04 (methyl cellulose, manufactured by Shin-Etsu Chemical Co., Ltd., methoxy substitution degree = 1.8): 0.0600 parts
FS-102 (styrene-acrylic resin, manufactured by Nippon paint Industrial Coatings Co., LTD., Tg = 103°C, 17% aqueous dispersion): 0.1177 parts
RAPISOL A-80 (anionic surfactant, manufactured by NOF CORPORATION, 80% aqueous solution): 0.0063 parts

(Evaluation)

1. Evaluation of surface state

<Evaluation of unevenness>

The prepared lithographic printing plate precursor was processed into a size of 40 cm × 62 cm. A surface of the obtained sample on the outermost layer side was visually observed under white lamp irradiation of 750 to 1,500 Lux, and the surface state was evaluated according to the following criteria. The results are shown in Table 3.

-Standard-

A: No unevenness is visually recognized on the entire surface.
B: Weak unevenness is visually recognized partially.
C: Weak unevenness is visually recognized partially in a region wider than a region of B.
D: Weak unevenness is visually recognized on the entire surface.
E: Strong unevenness is visually recognized on the entire surface.

<Evaluation of cissing>

For the lithographic printing plate precursors of Examples 17, 18, 26, 31, and 32 having the image-recording layer B among the produced lithographic printing plate precursors, in addition to the evaluation of unevenness, the evaluation of cissing was further performed as the evaluation of the surface state.

The lithographic printing plate precursors of Examples 17, 18, 26, 31, and 32 were processed into 15 cm × 62 cm. The surface of the obtained sample on the outermost layer side was visually observed 10 times under irradiation with a white lamp of 750 to 1500 Lux, and the total number of cissing occurring on the coated surface was evaluated.

The smaller the number of cissing, the better the coating surface state.

2. Evaluation of on-press developability

By using Magnus 800 Quantum manufactured by Kodak Japan Ltd. that was equipped with an infrared semiconductor laser, the prepared lithographic printing plate precursor was exposed (equivalent to irradiation energy of 110 mJ/$cm^2$) under the conditions of output of 27 W, an outer drum rotation speed of 450 rpm, and a resolution of 2,400 dots per inch (dpi, 1 inch is equal to 2.54 cm). The exposure image included a solid image and an amplitude modulation screen (AM screen) as a 50% halftone dot chart. The obtained exposed precursor was mounted on a Kikuban-sized cylinder of a printer SX-74 manufactured by Heidelberger Druckmaschinen AG without being developed. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and T&K UV OFS K-HS black GE-M (manufactured by T&K TOKA Co., Ltd.) was used as printing ink. The dampening water and ink were supplied by a standard automatic printing start method, and then printing was performed on 200 sheets of TOKUBISHI art paper (ream weight: 76.5 kg, manufactured by MITSUBISHI PAPER MILLS LIMITED.) at a printing speed of 10,000 sheets/hour. During the on-press development described above, the number of printing papers used until no ink was transferred to a non-image area was measured (hereinafter, also called number of sheets of on-press development). It can be said that the smaller the number of sheets of on-press development, the better the on-press developability. During the on-press development described above, the number of printing papers used until no ink was transferred to a non-image area was obtained as the on-press developability. It can be said that the smaller the number of printing papers, the better the on-press developability. The results thereof are shown in Tables 3 to 4.

[Table 3]

| | Support | Undercoat layer | Image-recording layer | | | | Protective layer | Evaluation | | |
|---|---|---|---|---|---|---|---|---|---|---|
| | | | | | | | | Coating surface state | | On-press developability [number] |
| | | | Type | Polymer | Addition amount | Molecular weight | | Unevenness | Cissing [number] | |
| Example 1 | A | A | A | P-1 | 0.0042 parts | 21600 | A | A | | 20 |
| Example 2 | A | A | A | P-2 | 0.0042 parts | 9700 | A | A | | 15 |
| Example 3 | A | A | A | P-3 | 0.0042 parts | 30900 | A | A | | 10 |
| Example 4 | A | A | A | P-3 | 0.0028 parts | 30900 | A | A | | 15 |
| Example 5 | A | A | A | P-3 | 0.0014 parts | 30900 | A | B | | 20 |
| Example 6 | A | A | A | P-3 | 0.0056 parts | 30900 | A | A | | 10 |
| Example 7 | A | A | A | P-3 | 0.0042 parts | 14700 | A | A | | 10 |
| Example 8 | A | A | A | P-3 | 0.0042 parts | 5600 | A | B | | 10 |
| Example 9 | A | A | A | P-3 | 0.0042 parts | 60000 | A | A | | 15 |
| Example 10 | A | A | A | P-4 | 0.0042 parts | 28300 | A | A | | 10 |
| Example 11 | A | A | A | P-5 | 0.0042 parts | 28300 | A | B | | 10 |
| Example 12 | A | A | A | P-6 | 0.0042 parts | 24600 | A | A | | 15 |
| Example 13 | A | A | A | P-7 | 0.0042 parts | 24100 | A | A | | 10 |
| Example 14 | A | A | A | P-8 | 0.0042 parts | 27100 | A | A | | 15 |
| Example 15 | A | A | A | P-9 | 0.0042 parts | 15800 | A | B | | 15 |

[Table 4]

| | Support | Undercoat layer | Image-recording layer | | | | Protective layer | Evaluation | | |
|---|---|---|---|---|---|---|---|---|---|---|
| | | | | | | | | Coating surface state | | On-press developability [number] |
| | | | Type | Polymer | Addition amount | Molecular weight | | Unevenness | Cissing [number] | |
| Example 16 | A | A | A | P-10 | 0.0042 parts | 34400 | A | A | | 10 |
| Example 17 | B | B | B | P-3 | 0.0042 parts | 30900 | B | A | 10 | 10 |
| Example 18 | B | B | B | P-7 | 0.0042 parts | 24100 | B | A | 5 | 10 |
| Example 19 | A | A | A | P-11 | 0.0042 parts | 30000 | A | C | | 20 |
| Example 25 | A | A | A | P-14 | 0.0028 parts | 18400 | A | A | | 10 |
| Example 26 | B | B | B | P-14 | 0.0028 parts | 18400 | B | A | 4 | 10 |
| Example 29 | A | A | A | P-2 | 0.0016 parts | 9700 | A | A | | 10 |
| Example 30 | A | A | A | P-16 | 0.0016 parts | 27300 | A | A | | 10 |
| Example 31 | B | B | B | P-2 | 0.0016 parts | 9700 | B | A | 0 | 10 |
| Example 32 | B | B | B | P-16 | 0.0016 parts | 27300 | B | A | 1 | 10 |
| Comparative Example 1 | A | A | A | P-12 | 0.0042 parts | 30000 | A | A | | 30 |
| Comparative Example 2 | A | A | A | P-13 | 0.0042 parts | 30000 | A | C | | 30 |
| Comparative Example 3 | A | A | A | Not added | | | A | D | | 50 |
| Comparative Example 9 | A | A | A | P-15 | 0.0042 parts | 40000 | A | D | | 50 |

(Examples 20 to 21 and Comparative Examples 4 to 5)

<Support C>

A molten metal was prepared using an aluminum alloy containing 0.06% by mass of Si, 0.30% by mass of Fe, 0.014% by mass of Cu, 0.001% by mass of Mn, 0.001% by mass of Mg, 0.001% by mass of Zn, and 0.03% by mass of Ti and, as the remainder, aluminum and unavoidable impurities, a molten metal treatment and filtration were performed, and an ingot having a thickness of 500 mm and a width of 1200 mm was prepared according to a DC casting method. The surface was scraped off using a surface grinder having an average thickness of 10 mm and heated at 550°C and maintained the state for approximately 5 hours. After the temperature was decreased to 400°C, a rolled sheet having a thickness of 2.7 mm was obtained using a hot rolling mill. Further, the aluminum alloy was subjected to a heat treatment at 500°C using a continuous annealing machine, and then cold-rolled to finish an aluminum plate having a thickness of 0.24 mm. This aluminum plate was set to a width of 1030 mm and then subjected to the surface treatment described below.

-Surface Treatment-

The surface treatment was performed by continuously performing various treatments of the following (a) to (j). After each treatment and the rinsing, the liquid was drained with a nip roller.

(a) Mechanical roughening treatment

A suspension of an abrasive (silica sand) having a specific gravity of 1.12 and water was supplied to the surface of the aluminum plate as an abrasive slurry liquid, and mechanical roughening was performed with a rotating roller-shaped nylon brush. The average particle diameter of the abrasive was 8 μm, and the maximum particle diameter thereof was 50 μm. The material of the nylon brush was 6.10 nylon, the bristle length was 50 mm, and the bristle diameter was 0.3 mm. A nylon brush was planted in a stainless steel cylinder having a diameter of φ 300 mm by drilling holes to be dense. Three rotary brushes were used. The distance between two support rollers (φ 200 mm) under the brush was 300 mm. The brush was pressed until the load of the drive motor for rotating the brush roller was 7 kW or higher than the load applied before the brush roller was pressed on the aluminum plate. The rotation direction of the brush was the same as the movement direction of the aluminum plate. The rotation speed of the brush was 200 rpm.

(b) Etching treatment with alkali agent

The aluminum plate obtained above was subjected to an etching treatment by spraying an aqueous solution in which the concentration of caustic soda was 2.6% by mass and the concentration of aluminum ions was 6.5% by mass at a temperature of 70°C so that 10 $g/m^2$ of the aluminum plate was dissolved. Then, rinsing was performed by means of spraying.

(c) Desmutting treatment

A desmutting treatment was performed by spraying an aqueous solution (containing 0.5% by mass of aluminum ions) having a nitric acid concentration of 1% by mass at a temperature of 30°C, and then the material was washed with water by spraying. As the aqueous nitric acid solution used for desmutting, waste liquid of a step of carrying out electrochemical roughening using alternating current in the aqueous nitric acid solution was used.

(d) Electrochemical roughening treatment

An electrochemical roughening treatment was continuously performed using an alternating current voltage of 60 Hz. As an electrolytic solution of this case, an aqueous solution containing 10.5 g/L of nitric acid (containing 5 g/L of aluminum ions and 0.007% by mass of ammonium ions) was used, and the liquid temperature was 80°C. By using an alternating current power source having the waveform shown in Fig. 3, alternating current having a trapezoidal rectangular waveform, and a carbon electrode as a counter electrode, an electrochemical roughening treatment was performed under the conditions of a time TP taken for the current value to reach the peak from zero of 0.8 msec and the duty ratio of 1:1. As an auxiliary anode, ferrite was used. The electrolytic cell shown in Fig. 4 was used. The current density was 30 $A/dm^2$ as the peak current value, and the electric quantity was 220 C/dm2 as the sum total of electric quantity in a case of anodization of the aluminum plate. 5% of the current from the power source was separately flowed to the auxiliary anode. Then, rinsing was performed by means of spraying.

(e) Alkaline etching treatment

The aluminum plate was subjected to an etching treatment by spraying an aqueous solution in which the concentration of caustic soda was 26% by mass and the concentration of aluminum ions was 6.5% by mass at a temperature of 32°C so that 0.20 g/$m^2$ of the aluminum plate was dissolved. Further, a smut component mainly containing aluminum hydroxide generated in a case of the electrochemical roughening treatment using the alternating current at the former step was removed, an edge portion of a generated pit was dissolved to smooth the edge portion. Then, rinsing was performed by means of spraying.

(f) Desmutting treatment

A desmutting treatment was performed by spraying an aqueous solution (containing 0.5% by mass of aluminum ions) having a nitric acid concentration of 25% by mass at a temperature of 30°C, and then the material was washed with water by spraying.

(g) Anodization treatment

An anodization treatment was performed using an anodization device for a two-stage power supply electrolytic treatment method (6 m of length of each for first and second electrolytic units, 3 m of length of each for first and second power supply units, and 2.4 m of length of each for first and second power supply electrodes). As the electrolytic solution supplied to the first and second electrolytic units, sulfuric acid was used. All the electrolytic solutions had a sulfuric acid concentration of 170 g/L (including 0.5% by mass of aluminum ions) and a temperature of 43°C. Then, rinsing was performed by means of spraying. The final amount of the oxide film was 2.7 g/$m^2$.

(h) The aluminum support obtained by the alkaline metal silicate treatment anodization treatment was immersed in a 1% by mass aqueous solution of soda silicate No. 3 at a temperature of 30°C for 10 seconds to perform an alkaline metal silicate treatment (silicate treatment). Then, rinsing was performed by means of spraying.

<Formation of undercoat layer C>

The support C was coated with a coating solution for an undercoat layer coating liquid having the following composition and dried at 80°C for 15 seconds to form an undercoat layer C. The coating amount of the undercoat layer after drying was 15 mg/$m^2$.

-Undercoat layer coating liquid-

- · The following polymer compound 1: 0.3 parts
- · Methanol: 100 parts
- · Water: 1 part

Polymer compound 1

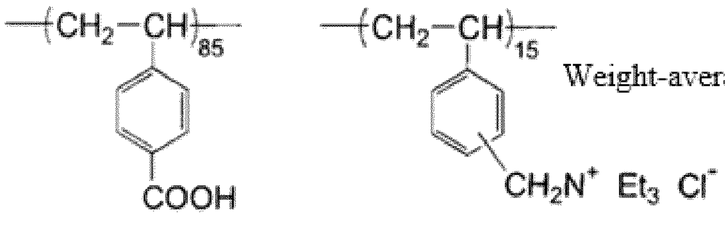

Weight-average molecular weight 28,000

<Formation of image-recording layer C1>

The undercoat layer C was coated with the following coating liquid for a lower image-recording layer such that the coating amount was 0.85 g/$m^2$, and then dried at 140°C for 50 seconds with Wind Control set to 7 using PERPECT OVEN PH200 manufactured by TABAI Corporation. Thereafter, the coating liquid for an upper image-recording layer was applied

such that the coating amount was 0.15 g/$m^2$, and then dried at 120°C for 1 minute, thereby forming an image-recording layer C1. In this manner, the lithographic printing plate precursors of Example 20 and Comparative Example 4 were obtained.

-Coating liquid for lower recording layer-

· N-(4-aminosulfonylphenyl) methacrylamide/acrylonitrile/methyl methacrylate copolymer (copolymerization ratio: 35/30/35: weight-average molecular weight: 50,000): 2.37 parts
· m,p-cresol novolac: 0.47 parts
· Cyanine dye A (the following structure): 0.13 parts
· 4,4'-bis hydroxyphenyl sulfone: 0.11 parts
· Tetrahydrophthalic anhydride: 0.15 parts
· p-toluenesulfonic acid: 0.01 parts
· 3-methoxy-4-diazodiphenylamine hexafluorophosphate: 0.03 parts · Crystal violet counteranion changed to naphthalene sulfonic acid: 0.10 parts
· Polymer shown in Table 4: 0.035 parts
· Methyl ethyl ketone: 24 parts
· 2-Methoxy-1-propanol: 13 parts
· γ-Butyrolactone: 14 parts

-Coating liquid for upper image-recording layer-

· m,p-cresol novolac: 0.285 parts
Ethyl methacrylate/isobutyl methacrylate/methacrylate copolymer (copolymerization ratio: 50/20/30: weight-average molecular weight: 42000): 0.06 parts
· Cyanine dye A (the following structure): 0.075 parts
· Sulfonate A (the following structure): 0.060 parts
· Polymer shown in Table 4: 0.035 parts
· Methyl ethyl ketone: 15.1 parts
· 1-Methoxy-2-propanol: 7.7 parts

Cyanine dye A

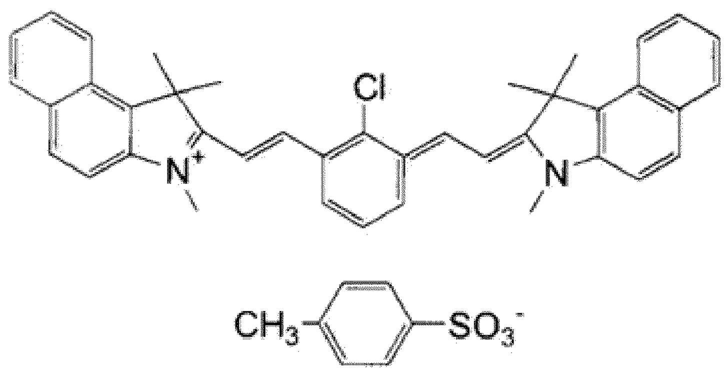

Sulfonate A

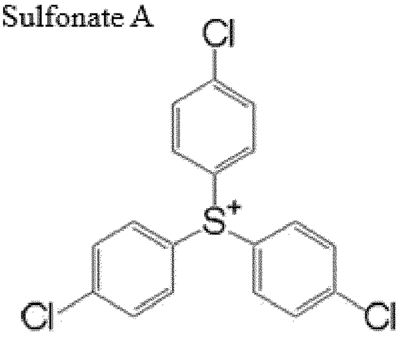
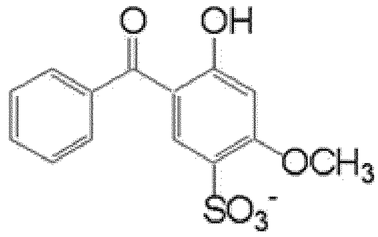

<Image recording layer C2>

The undercoat layer C was coated with the following coating liquid for an image-recording layer C2 such that the coating amount was 1.3 g/m$^2$, and then dried at 150°C for 40 seconds using a PERFECT OVEN PH200 manufactured by TABAI Corporation. with Wind Control set to 7 to form an image forming layer C2. In this manner, lithographic printing plate precursors of Example 21 and Comparative Example 5 were obtained.

-Coating liquid for image-recording layer C2-

· Novolac resin (m-cresol/p-cresol/phenol = 3/2/5, Mw 8,000): 3.5 parts
· Novolac resin having the following structure: 0.68 parts
· Infrared absorber (cyanine dye A): 0.045 parts
· Dye in which counter anion of ethyl violet is 6-hydroxy-β-naphthalenesulfonic acid: 0.15 parts
· Bisphenol sulfone: 0.3 parts
· Tetrahydrophthalic acid: 0.4 parts
· Polymer shown in Table 4: 0.02 parts
· Methyl ethyl ketone: 30 parts
· Propylene glycol monomethyl ether: 15 parts
· γ-Butyrolactone: 15 parts

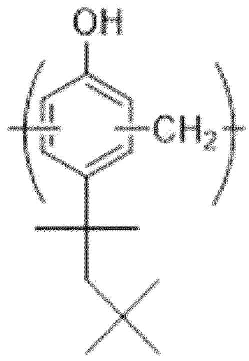

(Example 22 and Comparative Example 6)

<Production of support D>

Various treatments of the following (a) to (e) were continuously performed using an aluminum plate (material 1050) having a thickness of 0.3 mm. After each treatment and the rinsing, the liquid was drained with a nip roller.

(Treatment (a))

In order to remove the rolling oil on the surface of an aluminum plate (material 1050) having a thickness of 0.3 mm, the aluminum plate was subjected to a degreasing treatment at 50°C for 30 seconds by using a 10% by mass aqueous

sodium aluminate solution. Then, by using three bundled nylon brushes having a bristle diameter of 0.3 mm and a water suspension of pumice having a median diameter of 30 μm (specific gravity: 1.1 g/$cm^3$), graining was performed on the surface of the aluminum at brush rotation speed of 250 rpm, and then the aluminum plate was thoroughly rinsed with water.

(Treatment (b))

This plate was immersed in a 25% sodium hydroxide aqueous solution at 45°C for 9 seconds to perform etching, washed with water, further immersed in 20% nitric acid at 60°C for 20 seconds, and washed with water. The etching amount of the grained surface during this process was approximately 3 g/$m^2$.

(Treatment (c))

Next, the plate was continuously subjected to an electrochemical roughening treatment using an alternating current voltage of 60 Hz. At this time, a 1% by mass aqueous nitric acid solution was used as an electrolytic solution (containing 0.5% by mass of aluminum ions), and the liquid temperature was 50°C. By using a light source of alternating current power source having a trapezoidal rectangular waveform and a carbon electrode as a counter electrode, an electrochemical roughening treatment was performed under the conditions of a time TP taken for the current value to reach the peak from zero of 0.8 msec and the duty ratio of 1:1. As an auxiliary anode, ferrite was used. The current density was 30 A/$dm^2$ in terms of the peak value of current, and 5% of the current coming from the power source was allowed to flow into the auxiliary anode. The amount of electricity in the nitric acid electrolysis was 175 C/$dm^2$ in a case where the aluminum plate was an anode. Then, rinsing was performed by means of spraying.

(Treatment (d))

Subsequently, by using a 0.5% by mass aqueous solution of hydrochloric acid (containing 0.5% by mass of aluminum ions) at a liquid temperature of 50°C as an electrolytic solution, an electrochemical roughening treatment was performed by the same method as the nitric acid electrolysis under the condition of a quantity of electricity of 50 C/$dm^2$ that was used when the aluminum plate was an anode. Then, the aluminum plate was rinsed with water by spraying.

(Treatment (e))

This plate was provided with a direct current anodic oxide film of 2.5 g/m2 at a current density of 15 A/$dm^2$ using 15% sulfuric acid (containing 0.5% by mass of aluminum ions) as an electrolytic solution, and then washed with water and dried to obtain a support A. The center line average roughness (Ra) of the substrate was measured using a needle having a diameter of 2 μm, and the value was 0.51 μm.
The support D was prepared as described above.

<Formation of undercoat layer D>

The following undercoat layer coating liquid was applied onto the support D so that the coating amount after drying was 5 mg/$m^2$, and dried at 100°C for 10 seconds to form an undercoat layer D.

-Undercoat layer coating liquid-

· Polymer compound a-1 of following structure (Mw: 35,000): 0.05 g
· Methanol: 27 g
· Ion exchanged water: 3 g

Polymer compound a-1

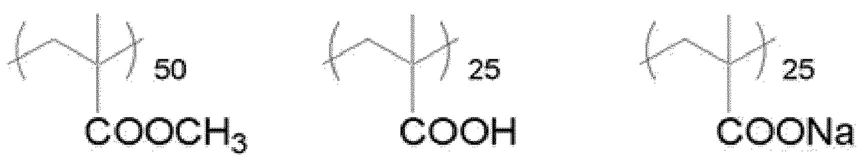

<Image recording layer D>

A coating liquid for an image-recording layer D having the following composition was prepared and applied onto the undercoat layer D such that the coating amount after drying was 1.0 g/m$^2$, and the coating layer was dried at 115°C for 34 seconds using a hot air drying device to form an image-recording layer D.

-Coating liquid for image-recording layer D-

· Infrared absorber (the following IR-1): 0.040 parts
· Polymerization initiator A (the following S-1): 0.104 parts
· Polymerization initiator B (the following I-1): 0.153 parts
· Mercapto compound (the following SH-1): 0.038 parts
· Sensitizing assistant (the following T-1): 0.121 parts
· Polymerizable compound (the following M-1): 0.535 parts
· Urethane-based binder polymer A (the following polyurethane resin (P-1), Mw: 100,000): 0.107 parts
. Acrylic binder polymer B (the following acrylic resin B-1, Mw: 100,000): 0.267 parts
· Acrylic binder polymer C (the following acrylic resin C-1, Mw: 100,000): 0.160 parts
· Copper phthalocyanine pigment dispersion: 0.775 parts
(C. I. Pigment Blue 15:6, dispersion solvent: MEK/MF ratio of MA = 2/2/1, pigment solid content: 15 wt%)
· Polymerization inhibitor (the following Q-1): 0.0015 parts
· Polymer shown in Table 5: 0.02 parts
· Methyl ethyl ketone: 6.481 parts
· Methanol: 2.738 parts
· 1-Methoxy-2-propanol: 5.119 parts

IR-1

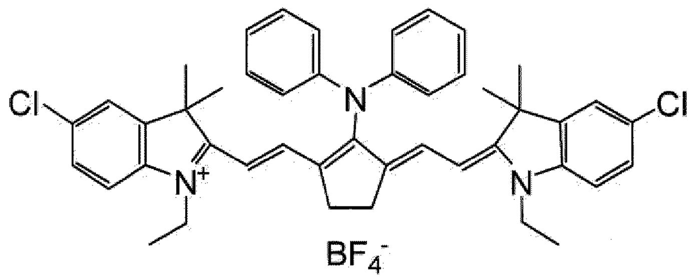

S-1

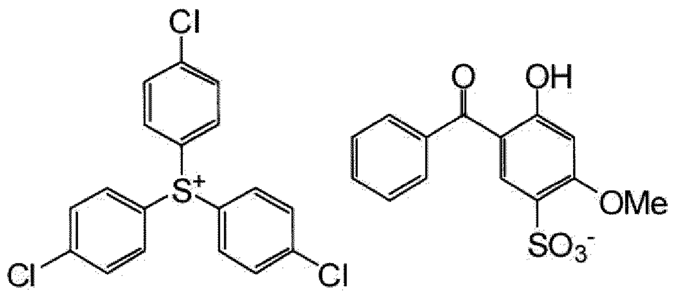

I-1

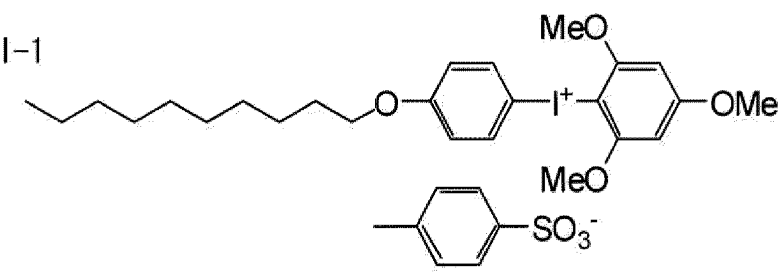

SH-1

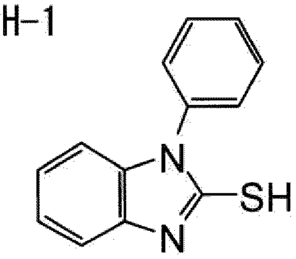

T-1

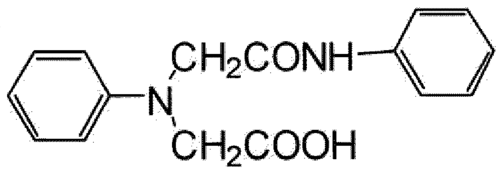

M-1

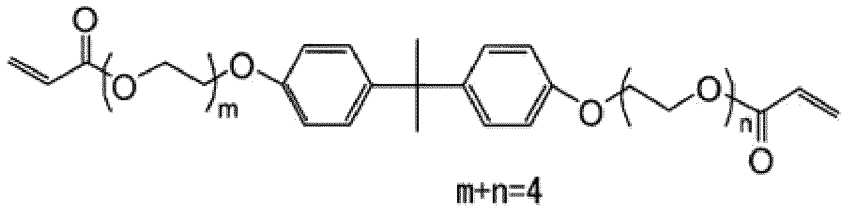

m+n=4

Polyurethane resin (P-1)

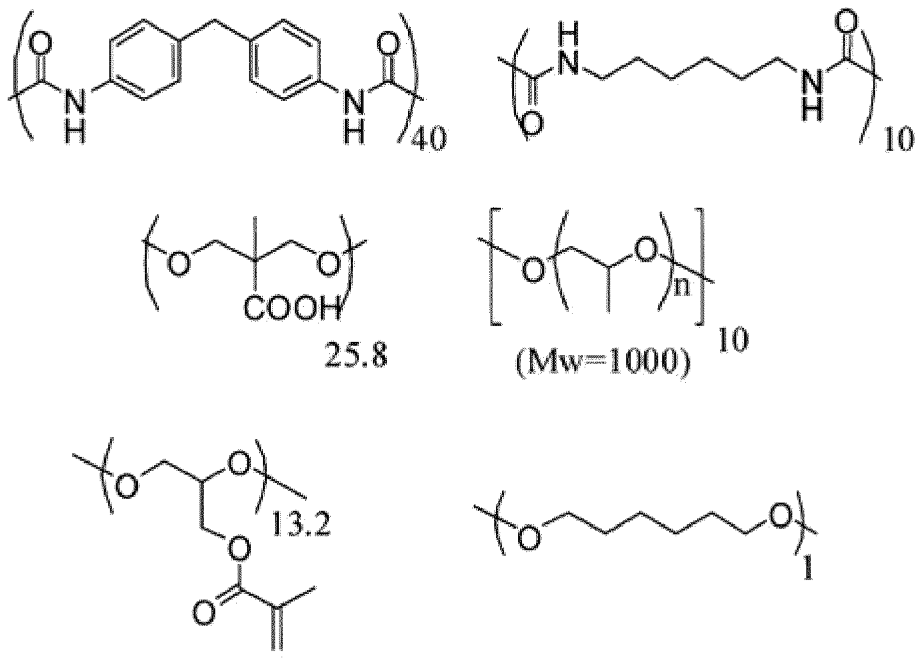

Acrylic resin B-1

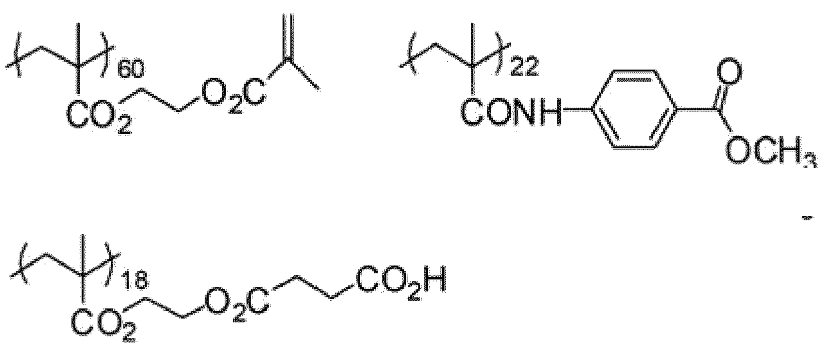

Acrylic resin C-1

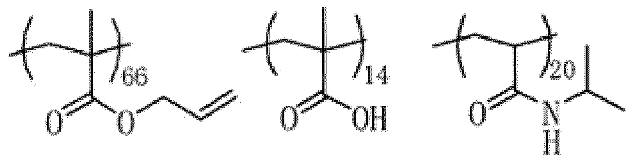

Q-1

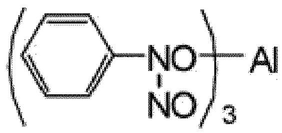

<Formation of outermost layer (protective layer) D>

A mixed aqueous solution (coating solution for lower protective layer) of synthetic mica (SOMASIF MEB-3L, 3.2% aqueous dispersion, manufactured by CO-OP CHEMICAL CO., LTD.), a polyvinyl alcohol (GOSERAN CKS-50: saponification degree of 99 mol%, degree of polymerization of 300, sulfonic acid-modified polyvinyl alcohol manufactured by Nippon Synthetic Chemical Industry Co., Ltd.) surfactant A (manufactured by NIHON EMULSION Co., Ltd., EMALEX 710), and a surfactant B (ADEKA PLURONIC (registered trademark) P-84: manufactured by Asahi Denka Kogyo Co., Ltd.) were applied onto the image-recording layer D and dried at 125°C for 30 seconds using a hot air drying device. The content ratio of synthetic mica (solid content)/polyvinyl alcohol/surfactant A/surfactant B in the mixed aqueous solution (coating liquid for lower protective layer) was 7.5/89/2/1.5 (parts by mass), and the coating amount (coating amount after drying) was 0.5 $g/m^2$.

A mixed aqueous solution (coating solution for upper protective layer) of an organic filler (ART PEARL J-7P, manufactured by Negami Chemical Industrial Co., Ltd.), synthetic mica (SOMASIF MEB-3L, 3.2% aqueous dispersion, manufactured by Co-op Chemical Co., Ltd.), polyvinyl alcohol (L-3266: saponification degree of 87% by mole, degree of polymerization of 300, sulfonic acid-modified polyvinyl alcohol, manufactured by Nippon Synthetic Chemical Industry Co., Ltd.), a thickener (CELLOGEN FS-B, manufactured by DKS Co., Ltd.), a polymer compound A (the following structure), and a surfactant (EMALEX 710, manufactured by NIHON EMULSION Co., Ltd.) was applied onto the obtained lower protective layer, and dried with a hot air drying device at 125°C for 30 seconds. The content ratio of the organic filler/synthetic mica (solid content)/polyvinyl alcohol/thickener/polymer compound A/surfactant in the mixed aqueous solution (coating liquid for upper protective layer) was 4.7/2.8/67.4/18.6/2.3/4.2 (parts by mass), and the coating amount (coating amount after drying) was 1.8 $g/m^2$.

Polymer compound A

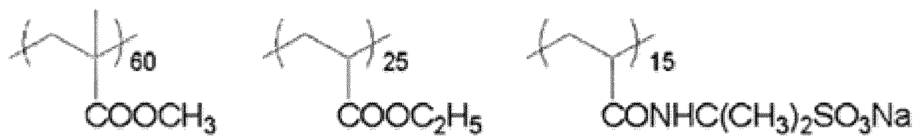

(Example 23 and Comparative Example 7)

<Preparation of support E>

An aluminum plate of a material 1S having a thickness of 0.30 mm was treated with a No. 8 nylon brush and an 800 mesh aqueous suspension of pumice stone, and the surface thereof was sanded and then thoroughly washed with water. The sample was immersed in 10% sodium hydroxide at 70°C for 60 seconds for etching, washed with running water, neutralized and washed with 20% $HNO_3$, and then washed with running water. An electrolytic roughening treatment was performed in a 1% aqueous nitric acid solution using a sinusoidal alternating waveform current at an anodic electric quantity of 300 coulombs/$dm^2$ under the condition of VA = 12.7 V. The surface roughness thereof was measured and found to be 0.45 μm (Ra display). Subsequently, the aluminum plate was immersed in a 30% $H_2SO_4$ aqueous solution, desmutting was carried out at 55°C for 2 minutes, and then the cathode was disposed on the grained surface in a 20% $H_2SO_4$ aqueous solution at 33°C, and anodization was carried out at a current density of 5 A/dm2 for 50 seconds, and the

thickness was 2.6 g/m$^2$. This was used as a support E.

<Formation of undercoat layer E>

The support E was coated with the following undercoat layer coating liquid using a bar coater such that the coating amount after drying was 2 mg/m$^2$, and dried at 80°C for 20 seconds to form an undercoat layer E.

-Undercoat layer coating liquid-

- Polymer (the following structure): 0.3 parts
- Pure water: 60.0 parts
- Methanol: 939.7 parts

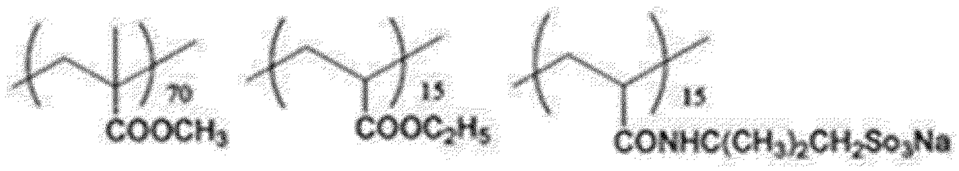

<Image recording layer E>

The undercoat layer E was coated with a coating solution for an image-recording layer E having the following composition using a bar coater so that the coating amount after drying was 1.35 g/m$^2$, and dried at 90°C for 1 minute, thereby forming an image-recording layer E.

-Coating liquid for image-recording layer E-

- PLEX6661-O manufactured by Degussa: 1.69 parts
- Binder polymer PP-3 (the following structure): 1.87 parts
- Sensitizing dye D40 (the following structure): 0.13 parts
- BIMD (hexaarylbisimidazole manufactured by Kurogane Kasei Co., Ltd.): 0.46 parts
- ε-phthalocyanine (the following F-1) dispersion (25% MEK dispersion liquid): 1.70 parts
- Mercapto group-containing heterocyclic compound SH-8 (the following structure): 0.34 parts
- Polymer shown in Table 5: 0.03 parts
- 10% solution of Cupferron AL (manufactured by Wako Pure Chemical Industries, Ltd.) tricresyl phosphate: 0.12 parts
- Methyl ethyl ketone: 27.0 parts
- Propylene glycol monomethyl ether: 26.7 parts
- S-2358 Yellow (manufactured by Dainichiseika Color & Chemicals Mfg. Co., Ltd.): 0.50 parts

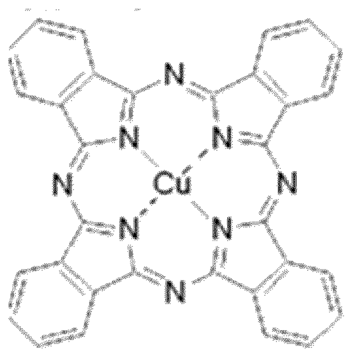

F-1

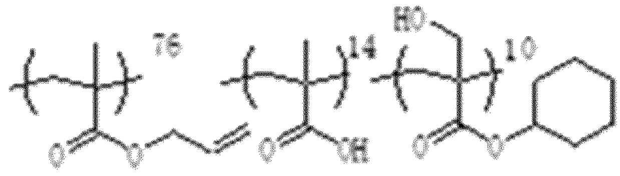

PP-3

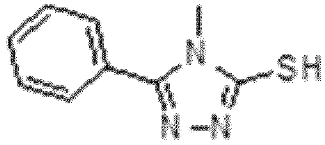

SH-8

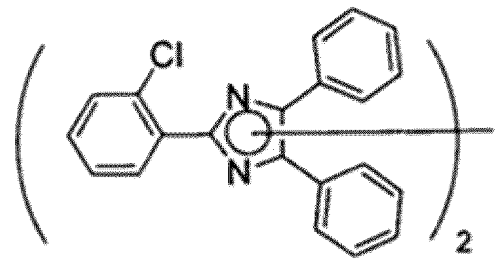

D40

<Formation of outermost layer (protective layer) E>

The image-recording layer E was coated with the following aqueous solution for a protective layer using a bar coater such that the coating amount after drying was 2.5 g/m$^2$, and dried at 120°C for 1 minute to form an outermost layer (protective layer) E.

-Aqueous solution for protective layer-

· PVA105 (saponification degree: 98 mol%, manufactured by Kuraray Co., Ltd.): 1.80 parts
· Polyvinylpyrrolidone: 0.40 parts
· EMALEX 710 (nonionic surfactant manufactured by NIPPON NYUKAZAI CO., LTD.): 0.04 parts
· PIONIN D230 (manufactured by TAKEMOTO OIL & FAT Co., Ltd., surfactant): 0.05 parts
· Luviskol V64W (manufactured by BASF SE): 0.06 parts
· 13% aqueous solution of sulfonic acid group-containing polymer having the following structure: 0.36 parts
· Pure water: 36.0 parts

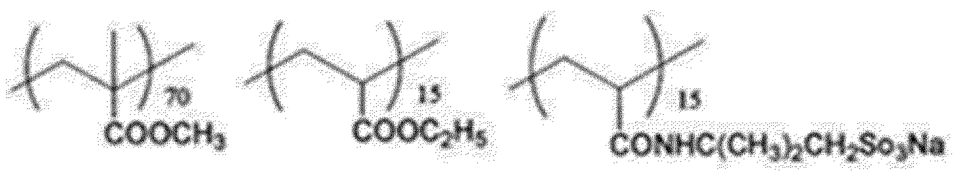

(Example 24 and Comparative Example 8)

<Production of support F>

The following surface treatment was performed using an aluminum plate (JIS A1050) having a thickness of 0.03 mm.

(Electrochemical roughening treatment)

An electrochemical roughening treatment was continuously performed using an alternating current voltage of 60 Hz. As an electrolytic solution of this case, an aqueous solution containing 10.5 g/L of nitric acid (containing 5 g/L of aluminum ions and 0.007% by mass of ammonium ions) was used, and the liquid temperature was 50°C. Using a trapezoidal rectangular waveform AC having a time TP, until the current value reached a peak from zero, of 0.8 msec and the duty ratio of 1:1, the electrochemical roughening treatment was performed using a carbon electrode as a counter electrode. As an auxiliary anode, ferrite was used. As the electrolytic cell, a radial cell type electrolytic cell was used. The current density was 30 A/$dm^2$ as the peak current value, and the electric quantity was 220 C/$dm^2$ as the sum total of electric quantity in a case of anodization of the aluminum plate. 5% of the current from the power source was separately flowed to the auxiliary anode. Then, rinsing was performed by means of spraying.

(Alkaline etching treatment)

The aluminum plate was subjected to an etching treatment by spraying an aqueous solution in which the concentration of caustic soda was 26% by mass and the concentration of aluminum ions was 6.5% by mass at a temperature of 32°C so that 0.50 g/$m^2$ of the aluminum plate was dissolved. Further, a smut component mainly containing aluminum hydroxide generated in a case of the electrochemical roughening treatment using the alternating current at the former step was removed, an edge portion of a generated pit was dissolved to smooth the edge portion. Then, rinsing was performed by means of spraying.

(Desmutting treatment)

A desmutting treatment was performed by spraying an aqueous solution (containing 4.5% by mass of aluminum ions) having a sulfuric acid concentration of 15% by mass at a temperature of 30°C, and then the material was washed with water by spraying.

(Electrochemical roughening treatment)

An electrochemical roughening treatment was continuously performed using an alternating current voltage of 60 Hz. As an electrolyte in this case, an aqueous solution containing 5.0 g/L of hydrochloric acid (containing 5 g/L of aluminum ions) was used, and the temperature was 35°C. Using a trapezoidal rectangular waveform AC having a time TP, until the current value reached a peak from zero, of 0.8 msec and the duty ratio of 1:1, the electrochemical roughening treatment was performed using a carbon electrode as a counter electrode. As an auxiliary anode, ferrite was used. As the electrolytic cell, a radial cell type electrolytic cell was used. The current density was 25 A/$dm^2$ as the peak current value, and the electric quantity was 50 C/$dm^2$ as the sum total of electric quantity in a case of anodization of the aluminum plate. Then, rinsing was performed by means of spraying.

(Anodization treatment)

An anodization treatment was performed using an anodization device for a two-stage power supply electrolytic treatment method (6 m of length for each of first and second electrolytic units, 3 m of length for each of first and second power supply units, and 2.4 m of length for each of first and second power supply electrodes). The electrolytic solution supplied to the first and second electrolytic units had a sulfuric acid concentration of 50 g/L (containing 0.5% by mass of aluminum ions) and a temperature of 20°C. Then, rinsing was performed by means of spraying. The final amount of the oxide film was 2.7 g/$m^2$.

(Hydrophilization treatment)

The plate was immersed in a treatment liquid at 53°C obtained by dissolving 0.4% by mass of polyvinylphosphonic acid (manufactured by PCAS) in pure water for 10 seconds, and the excess treatment liquid was removed with a nip roller. Thereafter, the plate was washed for 4 seconds with well water at 60°C containing a calcium ion concentration of 20 to 400 ppm, and further washed for 4 seconds with pure water at 25°C, and excess pure water was removed with nip

rolls. The moisture on the aluminum plate was completely removed in a subsequent drying step.

In a case where a center line average roughness (Ra in accordance with JIS B0601) of the obtained support F was measured using a needle having a diameter of 2 μm, it was 0.28 μm.

<Formation of image-recording layer F>

The support F was coated with a coating liquid for an image-recording layer F having the following composition such that the dry coating mass was 1.4 $g/m^2$, and dried at 100°C for 1 minute to form an image-recording layer F.

-Coating liquid for image-recording layer F-

· Polymerizable compound (compound A): 4.0 parts
· Binder polymer (binder A) (Mw = 50,000): 2.0 parts
· Sensitizing dye (C-1): 0.32 parts
· Polymerization initiator (D-1): 0.61 parts
· Chain transfer agent (E-1): 0.57 parts
· N-nitrosophenylhydroxylamine aluminum salt: 0.020 parts
· ε-phthalocyanine pigment (F1) dispersion: 0.71 parts (pigment: 15 parts, dispersant: the following polymer (1): 10 parts)
· Solvent: cyclohexanone/methoxypropyl acetate/1-methoxy-2-propanol = 15 parts/20 parts/40 parts
· Polymer shown in Table 5 below: 0.016 parts
· Methyl ethyl ketone: 47 parts
· Propylene glycol monomethyl ether: 45 g

Compound A

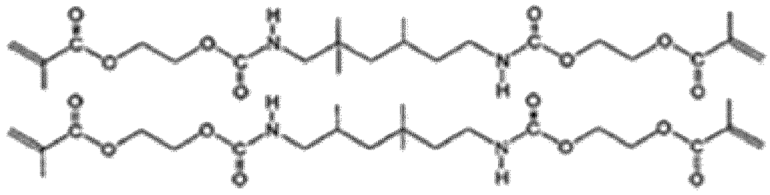

Mixture of above-described isomer

Binder A

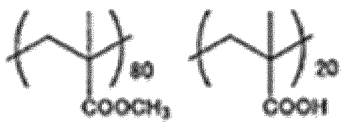

Sensitizing dye C-1

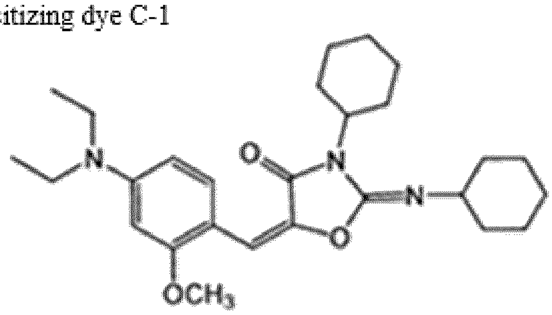

Polymerization initiator D-1

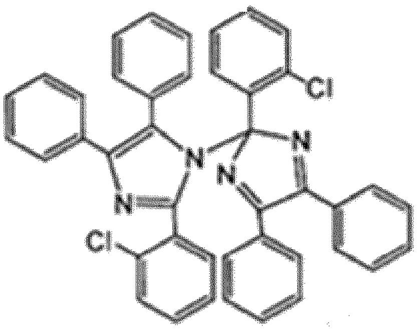

Chain transfer agent E-1

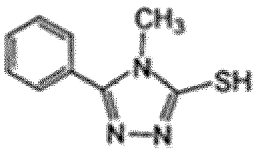

<Formation of outermost layer (protective layer) F>

The image-recording layer F was bar-coated with a coating solution for a protective layer having the following composition such that the coating amount after drying was 25 g/$m^2$, and dried in an oven at 125°C for 70 seconds to form an outermost layer (protective layer) F.

-Coating solution for protective layer-

· Mica dispersion liquid shown below: 0.6 g
· Sulfonic acid-modified polyvinyl alcohol (GOSERAN CKS-50, manufactured by Nippon Synthetic Chemical Industry Co., Ltd. (saponification degree: 99 mol%, average degree of polymerization: 300, degree of modification: about 0.4 mol%)): 0.8 g
· Poly(vinylpyrrolidone/vinyl acetate (1/1)) (molecular weight: 70,000): 0.001 g Surfactant (EMALEX (registered trademark) 710, manufactured by NIHON EMULSION Co., Ltd.): 0.002 parts
· Water: 13 g

(Mica dispersion liquid)

32 g of synthetic mica (SOMASIF ME-100, manufactured by CO-OP CHEMICAL CO., LTD., aspect ratio: 1000 or more) was added to 368 g of water, and the mixture was dispersed using a homogenizer until the average particle diameter

(laser scattering method) reached 0.5 μm, thereby obtaining a mica dispersion liquid.

(Evaluation)

1. Evaluation of surface state

The prepared lithographic printing plate precursor was processed into a size of 40 cm × 62 cm. A surface of the obtained sample on the outermost layer side was visually observed under white lamp irradiation of 750 to 1,500 Lux, and the surface state was evaluated according to the following criteria. The results are shown in Table 5.

-Standard-

A: No unevenness is visually recognized on the entire surface.
B: Weak unevenness is visually recognized partially.
C: Weak unevenness is visually recognized on the entire surface.
D: Strong unevenness is visually recognized on the entire surface.

[Table 5]

| | Support | Undercoat layer | Image-recording layer | | | Protective layer | Evaluation |
|---|---|---|---|---|---|---|---|
| | | | Type | Polymer | Molecular weight | | Surface state |
| Example 20 | C | C | C1 | P-3 | 30900 | None | A |
| Example 21 | C | C | C2 | P-3 | 30900 | None | A |
| Example 22 | D | D | D | P-3 | 30900 | D | A |
| Example 23 | E | E | E | P-3 | 30900 | E | A |
| Example 24 | F | F | F | P-3 | 30900 | F | A |
| Comparative Example 4 | C | C | C1 | P-12 | 30000 | None | C |
| Comparative Example 5 | C | C | C2 | P-12 | 30000 | None | C |
| Comparative Example 6 | D | D | D | P-12 | 30000 | D | C |
| Comparative Example 7 | E | E | E | P-12 | 30000 | E | C |
| Comparative Example 8 | F | F | F | P-12 | 30000 | F | C |

(Examples 27, 28)

<Support G>

The following treatments (J-a) to (J-m) were performed on an aluminum plate (aluminum alloy plate) made of a material 1S having a thickness of 0.3 mm, thereby manufacturing a support G. A rinsing treatment was performed between all the treatment steps. After the rinsing treatment, water was drained using a nip roller.

(J-a) Mechanical roughening treatment (brush graining method)

By using the device shown in Fig. 5, a pumice suspension (specific gravity: 1.1 g/cm$^3$) as an abrasive slurry was supplied to the surface of an aluminum plate, and in this state, a mechanical roughening treatment was performed using a rotating bundled brush. In Fig. 5, 31 represents an aluminum plate, 32 and 34 represent roller-shaped brushes (bundled brushes in the present example), 33 represents an abrasive slurry, and 35, 36, 37, and 38 represent support rollers.

In the mechanical roughening treatment, an abrasive having a median diameter (μm) of 30 μm and 4 brushes were used, and the rotation speed (rpm) of the brushes was set to 250 rpm. The bundle brush was made of 6·10 nylon and consisted of bristles having a diameter of 0.3 mm and a bristle length of 50 mm. The brush was prepared by making holes in

a φ 300 mm stainless steel cylinder and densely implanting bristles therein. The distance between two support rollers (φ 200 mm) under the bundled brush was 300 mm. The bundle brush was pressed until the load of the drive motor for rotating the brush was 10 kW or higher than the load applied before the bundle brush was pressed on the aluminum plate. The rotation direction of the brush was the same as the movement direction of the aluminum plate.

(J-b) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of dissolved aluminum within the surface to be subjected to the electrochemical roughening treatment later was 10 g/$m^2$.

(J-c) Desmutting treatment using acidic aqueous solution

As an acidic aqueous solution, the waste liquid of nitric acid used in the following step, an electrochemical roughening treatment, at a liquid temperature of 35°C was sprayed on the aluminum plate for 3 seconds. In this way, a desmutting treatment was performed.

(J-d) Electrochemical roughening treatment using aqueous nitric acid solution

An electrochemical roughening treatment was continuously performed using alternating current voltage of 60 Hz. An electrolytic solution at a liquid temperature of 35°C was used which was prepared by adding aluminum nitrate to 10.4 g/L aqueous nitric acid solution such that the aluminum ion concentration was adjusted to 4.5 g/L. By using an alternating current power source having the waveform shown in Fig. 3, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 4 was used. The current density was 30 A/$dm^2$ in terms of the peak value of current, and 5% of the current coming from the power source was allowed to flow into the auxiliary anode. The quantity of electricity (C/$dm^2$) was 185 C/$dm^2$, which is the total quantity of electricity used during the anodization of the aluminum plate.

(J-e) Alkaline etching treatment

An aqueous solution of caustic soda having a caustic soda concentration of 27% by mass and an aluminum ion concentration of 2.5% by mass was sprayed onto the aluminum plate at a temperature of 50°C, thereby performing an etching treatment. The amount of dissolved aluminum was 3.5 g/$m^2$.

(J-f) Desmutting treatment using acidic aqueous solution

As an acidic aqueous solution, an aqueous solution at a liquid temperature of 30°C having a sulfuric acid concentration of 170 g/L and an aluminum ion concentration of 5 g/L was sprayed on an aluminum plate for 3 seconds, thereby performing a desmutting treatment.

(J-g) Electrochemical roughening treatment using aqueous hydrochloric acid solution

An electrochemical roughening treatment was continuously performed using alternating current voltage of 60 Hz. An electrolytic solution was used which was prepared by adding aluminum chloride to 6.2 g/L aqueous hydrochloric acid solution at a liquid temperature of 35°C such that the aluminum ion concentration was adjusted to 4.5 g/L. By using an alternating current power source having the waveform shown in Fig. 3, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 4 was used. The current density was 25 A/$dm^2$ in terms of the peak value of current, and the quantity of electricity (C/$dm^2$) during the hydrochloric acid electrolysis was 63 C/$dm^2$ which is the total quantity of electricity used during the anodic reaction of the aluminum plate.

(J-h) Alkaline etching treatment

An aqueous solution of caustic soda having a caustic soda concentration of 5% by mass and an aluminum ion

concentration of 0.5% by mass was sprayed onto the aluminum plate at a temperature of 60°C, thereby performing an etching treatment. The amount of dissolved aluminum was 0.2 g/$m^2$.

(J-i) Desmutting treatment using acidic aqueous solution

As an acidic aqueous solution, an aqueous solution at a liquid temperature of 35°C (sulfuric acid concentration 170 g/L and aluminum ion concentration 5 g/L) which was a waste liquid generated in the anodization treatment step was sprayed on an aluminum plate for 4 seconds, thereby performing a desmutting treatment.

(J-j) First-stage anodization treatment

By using the anodization device for direct current electrolysis having the structure shown in Fig. 6, a first-stage anodization treatment was performed. By using a 170 g/L aqueous sulfuric acid solution as an electrolytic solution, an anodization treatment was performed under the conditions of a liquid temperature of 50°C and a current density of 30 A/$dm^2$, thereby forming an anodic oxide film having a film amount of 0.3 g/$m^2$.

(J-k) Pore widening treatment

The aluminum plate having undergone the anodization treatment was immersed in an aqueous solution of caustic soda having a caustic soda concentration of 5% by mass and an aluminum ion concentration of 0.5% by mass for 3 seconds at 40°C, thereby performing a pore widening treatment.

(J-l) Second-stage anodization treatment

By using the anodization device for direct current electrolysis having the structure shown in Fig. 6, a second-stage anodization treatment was performed. By using a 170 g/L aqueous sulfuric acid solution as an electrolytic solution, an anodization treatment was performed under the conditions of a liquid temperature of 50°C and a current density of 13 A/$dm^2$, thereby forming an anodic oxide film having a film amount of 2.6 g/$m^2$.

(J-m) Hydrophilic treatment

In order to ensure the hydrophilicity of the non-image area, the aluminum plate was immersed in a 2.5% by mass No. 3 aqueous soda silicate solution at 50°C for 7 seconds, thereby performing a silicate treatment. The amount of Si adhered was 8.5 mg/$m^2$. The average diameter of the micropores was 30 nm.

The value of the brightness L* of the surface of the anodic oxide film of the support G was 72.3 in the L*a*b* color system.

The film amount of the anodic oxide film of the support G was 2.6 g/$m^2$.

<Formation of undercoat layer G>

The support G obtained above was coated with an undercoat layer coating liquid G having the following composition such that the dry coating amount was 26 mg/$m^2$. In this way, an undercoat layer G was formed.

(Coating liquid G for undercoat layer)

- Compound for undercoat layer (2) (the following structure): 0.13 parts
- Hydroxyethyl iminodiacetic acid: 0.05 parts
- Tetrasodium ethylenediaminetetraacetate: 0.05 parts
- Polyoxyethylene lauryl ether: 0.03 parts
- Water: 61.39 parts

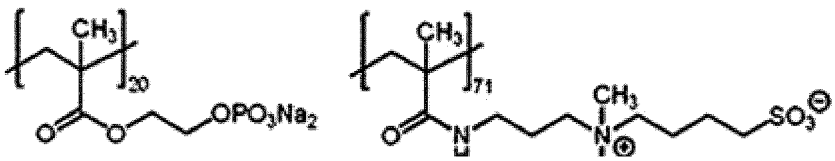

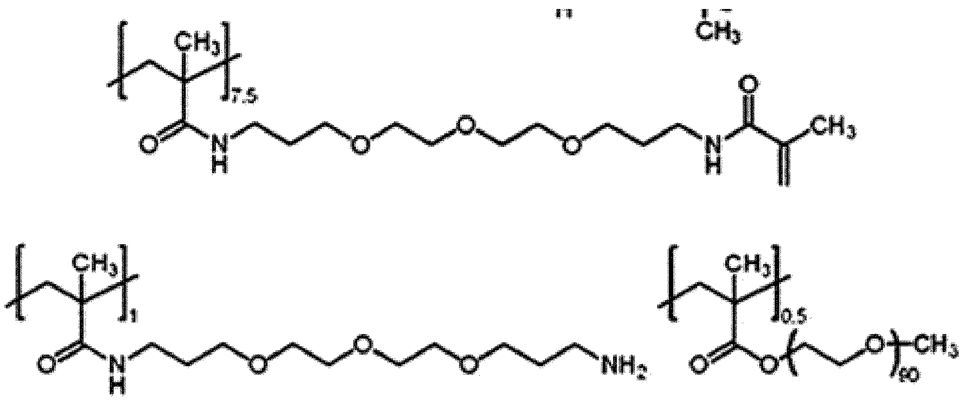

Compound for undercoat layer (2) Mw 100,000

<Formation of image-recording layer G>

The undercoat layer G was bar-coated with coating solution for the image recording layer G with the following composition and dried in an oven at 100°C for 60 seconds, thereby forming an image recording layer G having a thickness of 1.2 μm.

The coating solution for the image recording layer G was obtained by mixing a photosensitive solution G and a microgel liquid (1) described below immediately before the coating and then stirring the solution.

(Photosensitive solution G)

· Binder polymer (1) 23% by mass 1-methoxy-2-propanol solution (the following structure): 0.3750 parts
· Binder polymer (2) 23% by mass 1-methoxy-2-propanol solution (the following structure): 0.3834 parts
· Infrared absorber (1) (the following structure): 0.0185 parts
· Borate compound (1) (sodium tetraphenylborate): 0.0040 parts
· Polymerization initiator (1) (the following structure): 0.1250 parts
· Polymerizable compound (1) (tris(acryloyloxyethyl)isocyanurate, NK ESTER A-9300 40% 2-butanone solution, manufactured by SHIN-NAKAMURA CHEMICAL Co., LTD.): 0.2050 parts
Low-molecular-weight hydrophilic compound (1) (tris(2-hydroxyethyl)isocyanurate): 0.0287 parts
· Low-molecular-weight hydrophilic compound (2) (trimethylglycine): 0.0147 parts
· Anionic surfactant 1: 30% by mass aqueous solution (the following structure): 0.240 parts
· Ultraviolet absorber (1) (TINUVIN405, manufactured by BASF SE) (the following structure): 0.040 parts
· Polymer P-14 (the above structure): 0.004 parts
· Phosphonium compound (1) (the following structure): 0.025 parts
· Ammonium group-containing polymer (1) (the following structure, reduced specific viscosity: 44 ml/g): 0.030 parts
· Benzyldimethyloctylammonium·$PF_6$ salt: 0.023 parts
· 2-Butanone: 5.391 parts
· 1-Methoxy-2-propanol: 3.154 parts
· Methanol: 1.117 parts

(Microgel liquid (1))

· Microgel (1) (concentration of solid contents 21.8% by mass): 2.243 parts
· 1-Methoxy-2-propanol: 0.600 parts

(Preparation of microgel (1))

A method of preparing a microgel (1) used for the microgel liquid (1) will be described below.

<Preparation of polyvalent isocyanate compound (1)>

Bismuth tris(2-ethylhexanoate) (NEOSTAN U-600, manufactured by NITTO KASEI Co., Ltd., 0.043 parts) was added to an ethyl acetate (25.31 g) suspension solution of 17.78 parts (80 molar equivalents) of isophorone diisocyanate and 7.35 parts (20 molar equivalents) of the following polyhydric phenol compound (1), and the obtained solution was stirred. The reaction temperature was set to 50°C at a point in time when heat release subsided, and the solution was stirred for 3 hours, thereby obtaining an ethyl acetate solution of the polyvalent isocyanate compound (1) (50% by mass).

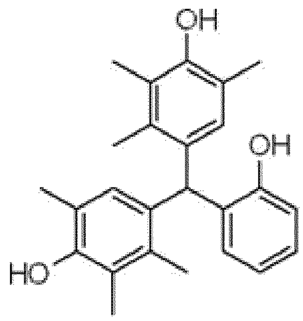

Polyhydric phenol compound (1)

<Preparation of microgel (1)>

The following oil-phase components and water-phase components were mixed together and emulsified at 12,000 rpm for 10 minutes by using a homogenizer. The obtained emulsion was stirred at 45°C for 4 hours, a 10% by mass aqueous solution of 5.20 parts of 1,8-diazabicyclo[5.4.0]undeca-7-ene-octylate (U-CAT SA102, manufactured by San-Apro Ltd.) was added thereto, and the solution was stirred at room temperature for 30 minutes and left to stand at 45°C for 24 hours. The concentration of solid contents was adjusted to 21.8% by mass using distilled water, thereby obtaining an aqueous dispersion liquid of the microgel (1). The volume average particle diameter was measured using a dynamic light scattering type particle size distribution measuring device LB-500 (manufactured by Horiba Ltd.) according to a light scattering method, and the value was 0.28 μm.

(Oil-phase components)

(Component 1) ethyl acetate: 12.0 parts
(Component 2) adduct (50 mass% ethyl acetate solution, manufactured by Mitsui Chemicals, Inc.) obtained by adding trimethylolpropane (6 mol) and xylene diisocyanate (18 mol) and adding methyl one-terminal polyoxyethylene (1 mol, repetition number of oxyethylene units: 90) thereto: 3.76 parts
(Component 3) polyvalent isocyanate compound (1) (as 50% by mass ethyl acetate solution): 15.0 parts
(Component 4) 65% by mass ethyl acetate solution of dipentaerythritol pentaacrylate (SR-399, manufactured by Sartomer Company Inc.): 11.54 parts
(Component 5) 10% ethyl acetate solution of sulfonate type surfactant (PIONIN A-41-C, manufactured by TAKEMOTO OIL & FAT Co., Ltd.): 4.42 parts

(Water-phase component)

Distilled water: 46.87 parts

<Synthesis of binder polymer (1)>

78.0 g of 1-methoxy-2-propanol was weighed in a three-neck flask and heated to 70°C in a nitrogen stream. A mixed solution consisting of 52.1 g of BLEMMER PME-100 (methoxy diethylene glycol monomethacrylate, manufactured by NOF Corporation), 21.8 g of methyl methacrylate, 14.2 g of methacrylic acid, 2.15 g of hexakis(3-mercaptopropionic acid) dipentaerythritol, 0.38 g of V-601 (2,2'-azobis(isobutyric acid) dimethyl, manufactured by FUJIFILM Wako Pure Chemical Corporation), and 54 g of 1-methoxy-2-propanol was added dropwise to this reaction container over 2 hours and 30 minutes. After dropwise addition ended, the solution was heated to 80°C, and the reaction was continued for 2 more

hours. A mixed solution consisting of 0.04 g of V-601 and 4 g of 1-methoxy-2-propanol was added thereto, the solution was heated to 90°C, and the reaction was continued for 2.5 hours. After the reaction ended, the reaction solution was cooled to room temperature.

137.2 g of 1-methoxy-2-propanol, 0.24 g of 4-hydroxy tetramethylpiperidine-N-oxide, 26.0 g of glycidyl methacrylate, and 3.0 g of tetraethylammonium bromide were added to the reaction solution, and the resulting solution was stirred thoroughly and heated to 90°C.

After 18 hours, the reaction solution was cooled to room temperature (25°C) and diluted by adding 99.4 g of 1-methoxy-2-propanol thereto.

The concentration of solid contents in the binder polymer (1) which had been obtained in the above-described manner was 23% by mass, and the weight-average molecular weight thereof in terms of polystyrene which had been measured by GPC was 35,000.

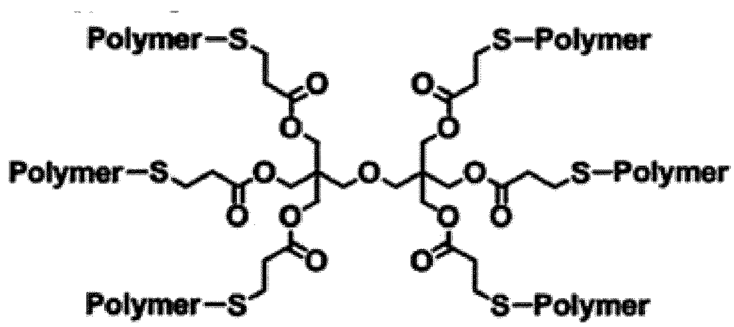

Polymer moiety

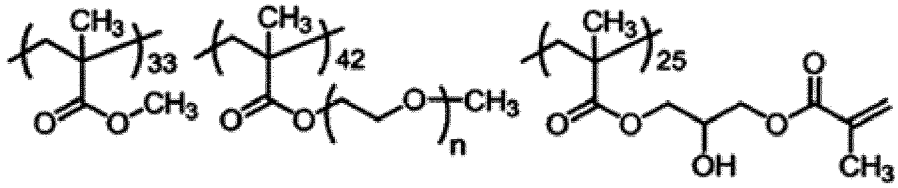

Binder polymer (1) n = 2

<Synthesis of binder polymer (2)>

78.00 g of 1-methoxy-2-propanol was weighed in a three-neck flask and heated to 70°C in a nitrogen stream. A mixed solution consisting of 65.8 g of BLEMMER PME-100 (methoxy diethylene glycol monomethacrylate, manufactured by NOF Corporation), 28.4 g of methyl methacrylate, 2.8 g of methacrylic acid, 6.4 g of hexakis(3-mercaptopropionic acid) dipentaerythritol, 1.1 g of V-601 (2,2'-azobis(isobutyric acid) dimethyl, manufactured by FUJIFILM Wako Pure Chemical Corporation), and 55 g of 1-methoxy-2-propanol was added dropwise to this reaction container over 2 hours and 30 minutes. After dropwise addition ended, the solution was heated to 80°C, and the reaction was continued for 2 more hours. 2 hours later, a mixed solution consisting of 0.11 g of V-601 and 1 g of 1-methoxy-2-propanol was added thereto, the solution was heated to 90°C, and the reaction was continued for 2.5 hours. After the reaction ended, the reaction solution was cooled to room temperature.

177.2 g of 1-methoxy-2-propanol, 0.28 g of 4-hydroxy tetramethylpiperidine-N-oxide, 46.0 g of glycidyl methacrylate, and 3.4 g of tetrabuthylammonium bromide were added to the reaction solution, and the resulting solution was stirred thoroughly and heated to 90°C.

After 18 hours, the reaction solution was cooled to room temperature (25°C) and diluted by adding 0.06 g of 4-methoxyphenol and 114.5 g of 1-methoxy-2-propanol thereto.

The concentration of solid contents in the binder polymer (2) which had been obtained in the above-described manner was 23% by mass, and the weight-average molecular weight thereof in terms of polystyrene which had been measured by GPC was 50,000.

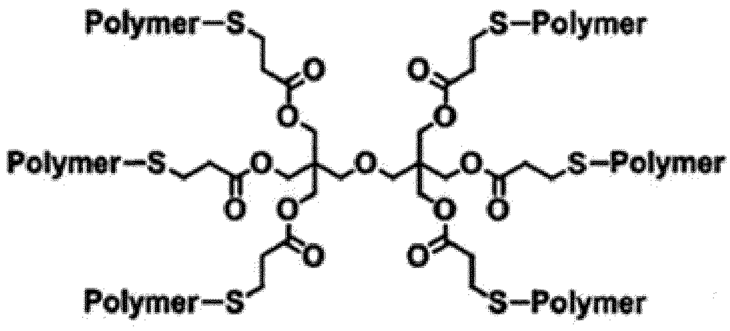

Polymer moiety

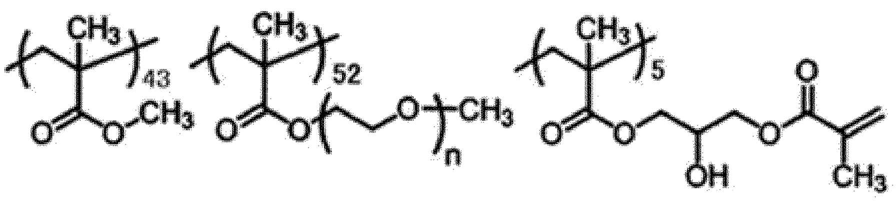

Binder polymer (2) n = 2

<Formation of image-recording layer H>

The undercoat layer H was bar-coated with coating solution for the image recording layer G with the following composition and dried in an oven at 100°C for 60 seconds, thereby forming an image recording layer H having a thickness of 1.2 μm.

The coating solution for the image recording layer H was obtained by mixing a photosensitive solution H and a microgel liquid (1) described below immediately before the coating and then stirring the solution.

(Photosensitive solution H)

· Binder polymer (1) 23% by mass 1-methoxy-2-propanol solution (the above-described structure): 0.2891 parts
· Binder polymer (3) 23% by mass 1-methoxy-2-propanol solution (the following structure): 0.4574 parts
· Infrared absorber (1) (the following structure): 0.0278 parts
· Borate compound (1) (sodium tetraphenylborate): 0.015 parts
· Polymerization initiator (1) (the following structure): 0.2348 parts
· Polymerizable compound (1) (tris(acryloyloxyethyl)isocyanurate, NK ESTER A-9300 40% 2-butanone solution, manufactured by SHIN-NAKAMURA CHEMICAL Co., LTD.): 0.2875 parts
Low-molecular-weight hydrophilic compound (1) (tris(2-hydroxyethyl)isocyanurate): 0.0287 parts
· Low-molecular-weight hydrophilic compound (2) (trimethylglycine): 0.0147 parts
· Anionic surfactant 1: 30% by mass aqueous solution (the following structure): 0.25 parts
· Ultraviolet absorbing agent (1) (TINUVIN405, manufactured by BASF SE) (the following structure): 0.04 parts
· Polymer P-14 (the above structure): 0.004 parts
· Phosphonium compound (1) (the following structure): 0.020 parts
· 2-Butanone: 5.346 parts
· 1-Methoxy-2-propanol: 3.128 g
· Methanol: 0.964 parts
· Pure water: 0.036 parts

(Microgel liquid (1))

· Microgel (1) (concentration of solid contents 21.8% by mass): 2.345 parts
· 1-Methoxy-2-propanol: 0.655 parts

(Preparation of microgel (1))

The microgel (1) was produced in the same manner as the microgel (1) used in the coating liquid for the image-recording layer G.

<Synthesis of binder polymer (3)>

78.00 g of 1-methoxy-2-propanol was weighed in a three-neck flask and heated to 70°C in a nitrogen stream. A mixed solution consisting of 52.8 g of BLEMMER PME-100 (methoxy diethylene glycol monomethacrylate, manufactured by NOF Corporation), 2.8 g of methyl methacrylate, 25.0 g of methacrylic acid, 6.4 g of hexakis(3-mercaptopropionic acid) dipentaerythritol, 1.1 g of V-601 (2,2'-azobis(isobutyric acid) dimethyl, manufactured by Wako Pure Chemical Industries, Ltd.), and 55 g of 1-methoxy-2-propanol was added dropwise to the reaction container for 2 hours and 30 minutes. After dropwise addition ended, the solution was heated to 80°C, and the reaction was continued for 2 more hours. 2 hours later, a mixed solution consisting of 0.11 g of V-601 and 1 g of 1-methoxy-2-propanol was added thereto, the solution was heated to 90°C, and the reaction was continued for 2.5 hours. After the reaction ended, the reaction solution was cooled to room temperature.

177.2 g of 1-methoxy-2-propanol, 0.28 g of 4-hydroxy tetramethylpiperidine-N-oxide, 46.0 g of glycidyl methacrylate, and 3.4 g of tetrabuthylammonium bromide were added to the reaction solution, and the resulting solution was stirred thoroughly and heated to 90°C.

After 18 hours, the reaction solution was cooled to room temperature (25°C) and diluted by adding 0.06 g of 4-methoxyphenol and 114.5 g of 1-methoxy-2-propanol thereto.

The concentration of solid contents in the binder polymer (3) which had been obtained in the above-described manner was 23% by mass, and the weight-average molecular weight thereof in terms of polystyrene which had been measured by GPC was 15,000.

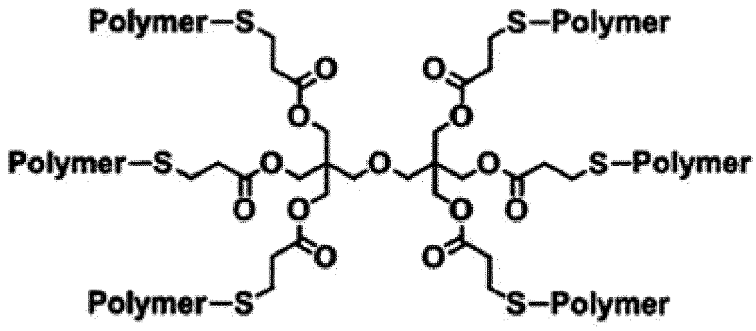

Polymer moiety

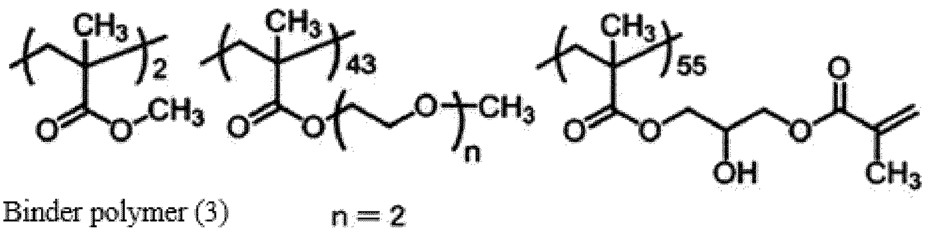

Binder polymer (3) n = 2

<Formation of protective layer G>

The image recording layer G was bar-coated with a protective layer coating liquid G with the following composition and dried in an oven at 120°C for 60 seconds, thereby forming a protective layer G having a thickness of 0.15 μm.

(Coating liquid G for protective layer)

Inorganic lamellar compound dispersion (1): 1.799 parts

Hydrophilic polymer (1) (20% aqueous solution of the following compound): 0.264 parts
· Polyvinyl alcohol (CKS50 manufactured by Nippon Synthetic Chemical Industry Co., Ltd., sulfonic acid-modified, saponification degree: 99 mol% or more, degree of polymerization: 300) 6% by mass of aqueous solution 0.012 parts
Polyvinyl alcohol (PVA-405 manufactured by KURARAY CO., LTD., saponification degree: 81.5 mol%, degree of polymerization: 500), 6% by mass of aqueous solution 0.001 parts
RAPISOL A-80 (anionic surfactant, manufactured by NOF CORPORATION, 80% aqueous solution): 0.145 parts
Deionized water: 5.3379 parts

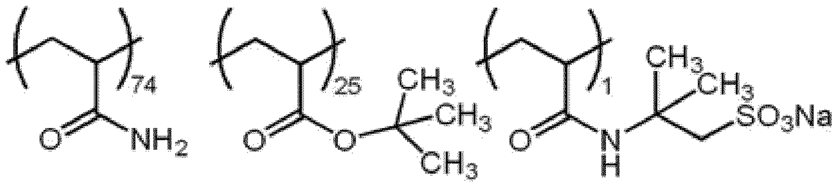

Hydrophilic polymer (1)

(Preparation of inorganic lamellar compound dispersion (1))

6.4 parts of synthetic mica Somasif ME-100 (manufactured by CO-OP CHEMICAL CO., LTD.) was added to 193.6 parts of deionized water and dispersed such that the volume average particle diameter (laser scattering method) was set to 3 μm using a homogenizer, thereby preparing an inorganic lamellar compound dispersion (1). The aspect ratio of the dispersed particles was 100 or more.

<Formation of protective layer H>

The image recording layer H was bar-coated with a protective layer coating liquid H with the following composition and dried in an oven at 120°C for 60 seconds, thereby forming a protective layer H having a thickness of 0.18 μm.

(Coating liquid H for protective layer)

· Inorganic lamellar compound dispersion liquid (1): 2.212 parts
Polyvinyl alcohol (GOSERAN L-3266, manufactured by Nippon Synthetic Chemical Industry Co., Ltd., sulfonic acid-modified, saponification degree: 85 mol%) 6% by mass of aqueous solution: 1.440 parts
· Phosphoric acid: 0.020 parts
· Diammonium phosphate: 0.032 parts
· Surfactant (PIONINE A-32-B (following structure), manufactured by TAKEMOTO OIL & FAT Co., Ltd., 40 mass% aqueous solution): 0.014 parts
· Surfactant (SURFYNOL 465 (described below), manufactured by Nissin Chemical Co., Ltd.): 0.006 parts
· Pure water: 3.955 parts

(Preparation of inorganic lamellar compound dispersion (1))

6.4 parts of synthetic mica Somasif ME-100 (manufactured by CO-OP CHEMICAL CO., LTD.) was added to 193.6 parts of deionized water and dispersed such that the volume average particle diameter (laser scattering method) was set to 3 μm using a homogenizer, thereby preparing an inorganic lamellar compound dispersion (1). The aspect ratio of the dispersed particles was 100 or more.

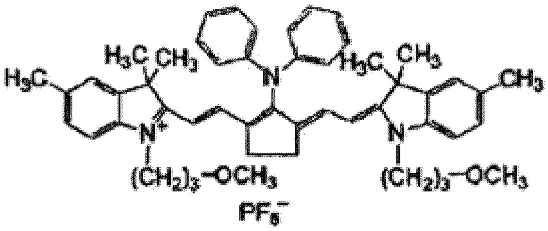

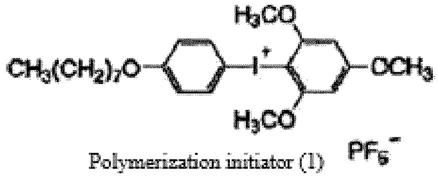

Polymerization initiator (1)

Infrared absorber (1)

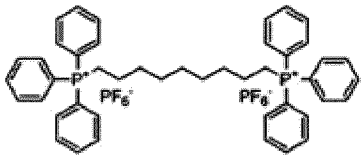

Phosphonium compound (1)

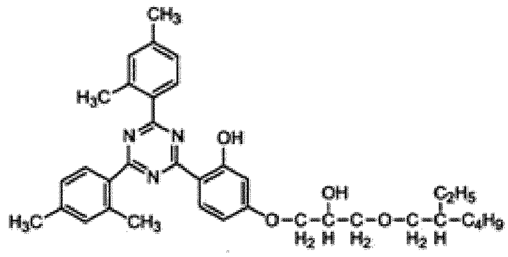

Ultraviolet absorber (1)

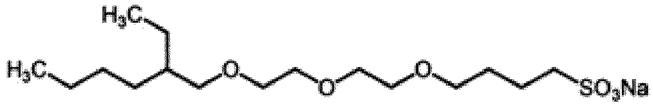

Anionic surfactant 1

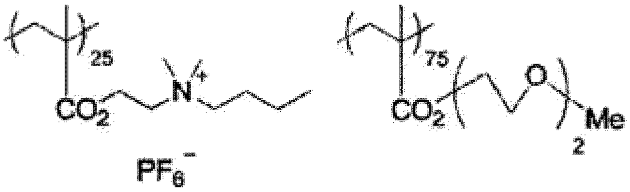

Ammonium group-containing polymer

(Evaluation)

1. Evaluation of surface state

The prepared lithographic printing plate precursor was processed into a size of 40 cm × 62 cm. A surface of the obtained sample on the outermost layer side was visually observed under white lamp irradiation of 750 to 1,500 Lux, and the surface state was evaluated according to the following criteria. The results thereof are shown in Tables 3 to 4.

-Standard-

A: No unevenness is visually recognized on the entire surface.
B: Weak unevenness is visually recognized partially.
C: Weak unevenness is visually recognized partially in a region wider than a region of B.
D: Weak unevenness is visually recognized on the entire surface.
E: Strong unevenness is visually recognized on the entire surface.

2. Evaluation of on-press developability

By using Magnus 800 Quantum manufactured by Kodak Japan Ltd. that was equipped with an infrared semiconductor laser, the prepared lithographic printing plate precursor was exposed (equivalent to irradiation energy of 110 $mJ/cm^2$) under the conditions of output of 27 W, an outer drum rotation speed of 450 rpm, and a resolution of 2,400 dots per inch (dpi, 1 inch is equal to 2.54 cm). The exposure image included a solid image and an amplitude modulation screen (AM screen) as a 50% halftone dot chart. The obtained exposed precursor was mounted on a Kikuban-sized

cylinder of a printer SX-74 manufactured by Heidelberger Druckmaschinen AG without being developed. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and T&K UV OFS K-HS black GE-M (manufactured by T&K TOKA Co., Ltd.) was used as printing ink. The dampening water and ink were supplied by a standard automatic printing start method, and then printing was performed on 200 sheets of TOKUBISHI art paper (ream weight: 76.5 kg, manufactured by MITSUBISHI PAPER MILLS LIMITED.) at a printing speed of 10,000 sheets/hour. During the on-press development described above, the number of printing papers used until no ink was transferred to a non-image area was measured (hereinafter, also called number of sheets of on-press development). It can be said that the smaller the number of sheets of on-press development, the better the on-press developability. During the on-press development described above, the number of printing papers used until no ink was transferred to a non-image area was obtained as the on-press developability. It can be said that the smaller the number of printing papers, the better the on-press developability. The results are shown in Table 6.

[Table 6]

| | Support | Undercoat layer | Image-recording layer | | | | Protective layer | Evaluation | |
|---|---|---|---|---|---|---|---|---|---|
| | | | Type | Polymer | Addition amount | Molecular weight | | Surface state | On-press developability [number] |
| Example 27 | G | G | G | P-14 | 0.004 parts | 18400 | G | A | 10 |
| Example 28 | G | G | H | P-14 | 0.004 parts | 18400 | H | A | 10 |

From the results shown in Tables 3 to 6, it was found that the lithographic printing plate precursors according to Examples were excellent in surface state as compared with the lithographic printing plate precursors according to Comparative Examples.

In addition, from the results shown in Tables 3 and 4, it is also found that the lithographic printing plate precursors of Examples 1 to 19 and 25 to 26 are excellent in on-press developability as compared with the lithographic printing plate precursors of Comparative Examples 1 to 3 and 9.

(Evaluation of image-recording layer subjected to acid color development)

The lithographic printing plate precursors were prepared and evaluated in the same manner as in Examples 1 to 19, 25, and 26, except that in the evaluation of the on-press developability of the lithographic printing plate precursors of Examples 1 to 19, 25, and 26, exposure development in a case of setting each parameter such as the SD value, the slope value, and the curve value was performed under the following conditions.

Specifically, the lithographic printing plate precursor was exposed in a predetermined image shape, lightly rubbed with a sponge (manufactured by 3M) impregnated with PS finishing gum FN-6 (manufactured by FUJIFILM Corporation) to perform development, and then the surface of the plate was washed with a waste cloth containing water. Next, an acidic aqueous solution obtained by mixing 10 g of citric acid (manufactured by FUJIFILM Wako Pure Chemical Corporation) and 90 cc of a kitchen alcohol disinfectant solution (manufactured by Fumakilla Co., Ltd.) was impregnated into a sponge (manufactured by 3M) and uniformly spread on the plate surface to color-develop the image area.

The evaluation results of the on-press developability in Examples 1 to 19 and 25 to 26 were the same as the evaluation results of the on-press developability in the corresponding Examples 1 to 19 and 25 to 26. That is, it was confirmed that even in a case where the image area was color-developed for the purpose of improving visibility, the lithographic printing plate precursors of Examples had good on-press developability.

Explanation of References

12a, 12b: aluminum support
18: aluminum plate
20a, 20b: anodic oxide film
22a, 22b: micropore
24: large diameter portion

26: small diameter portion
D: depth of large diameter portion
1: aluminum plate
2 and 4: roller-shaped brush
3: abrasive slurry
5, 6, 7 and 8: support roller
50: main electrolytic cell
51: alternating current power source
52: radial drum roller
53a, 53b: main pole
54: electrolytic solution supply port
55: electrolytic solution
56: auxiliary anode
57: electrolytic liquid channel
58: auxiliary anode
60: auxiliary anode cell
610: anodization treatment device
612: power supply tank
614: electrolytic treatment tank
616: aluminum plate
618, 26: electrolytic solution
620: power supply electrode
622, 628: roller
624: nip roller
630: electrolysis electrode
632: cell wall
634: direct current power source
W: aluminum plate
S: liquid supply direction
Ex: electrolytic solution discharge direction
ta: anodic reaction time
tc: cathodic reaction time
tp: time taken for current to reach peak from 0
Ia: peak current on anodic cycle side
Ic: peak current on cathodic cycle side
AA: current of anodic reaction of aluminum plate
CA: current of cathodic reaction of aluminum plate

The contents of the disclosures of JP2022-192211 filed on November 30, 2022, and JP2023-113277 filed on July 10, 2023, are incorporated in the present specification by reference in their entirety.

All publications, patent applications, and technical standards mentioned in the present disclosure are herein incorporated by reference to the same extent as if each individual publication, patent application, and technical standard were specifically and individually indicated to be incorporated by reference.

## Claims

**1.** A lithographic printing plate precursor comprising:

a support; and
an image-recording layer on the support,
wherein the image-recording layer contains a (meth)acrylic polymer A having a substituent containing two or more silicon atoms in a side chain.

**2.** A lithographic printing plate precursor comprising:

a support; and
an image-recording layer on the support,

wherein the image-recording layer contains a polymer B having a constitutional unit represented by Formula (I),

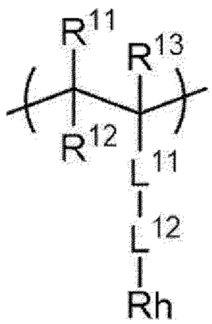 (I)

in Formula (I), $R^{11}$ and $R^{12}$ each independently represent a hydrogen atom or an alkyl group, $R^{13}$ represents a hydrogen atom or a monovalent substituent, $L^{11}$ and $L^{12}$ each independently represent a single bond or a divalent linking group, and Rh represents a substituent containing two or more silicon atoms.

**3.** The lithographic printing plate precursor according to claim 1 or 2,
wherein the lithographic printing plate precursor is an on-press development type lithographic printing plate precursor.

**4.** The lithographic printing plate precursor according to claim 3,
wherein the image-recording layer further contains resin particles.

**5.** The lithographic printing plate precursor according to claim 3,
wherein the image-recording layer further contains a color developing agent.

**6.** The lithographic printing plate precursor according to claim 1,
wherein the (meth)acrylic polymer A is a copolymer including the constitutional unit having a substituent containing two or more silicon atoms in a side chain and a constitutional unit having a hydrophilic group in the side chain.

**7.** The lithographic printing plate precursor according to claim 1,
wherein the (meth)acrylic polymer A is a copolymer including the constitutional unit having a substituent containing two or more silicon atoms in a side chain and a constitutional unit having a polyalkyleneoxy group in the side chain.

**8.** The lithographic printing plate precursor according to claim 2,

wherein Rh in Formula (I) is a group including two or more structures represented by Formula (Ia),

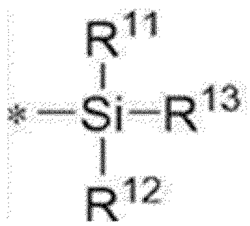 (Ia)

in Formula (Ia), * represents a bonding position, and $R^{11}$, $R^{12}$, and $R^{13}$ each independently represent an alkyl group, an alkenyl group, an aryl group, or an alkylene aryl group.

**9.** The lithographic printing plate precursor according to claim 2,
wherein the polymer B is a copolymer further having a constitutional unit having a hydrophilic group in a side chain.

**10.** The lithographic printing plate precursor according to claim 9,

wherein the constitutional unit having a hydrophilic group in a side chain is a constitutional unit represented by Formula (a4),

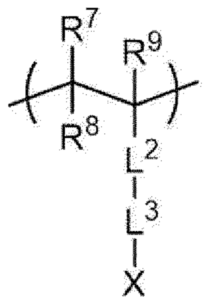

(a4)

in Formula (a4), $R^7$ and $R^8$ each independently represent a hydrogen atom or an alkyl group, $R^9$ represents a hydrogen atom or a monovalent substituent, $L^2$ represents -C(=O)-O- or -C(=O)-NH-, $L^3$ represents a single bond or a divalent linking group, and X represents a hydrophilic group.

**11.** The lithographic printing plate precursor according to claim 10,
wherein, in Formula (a4), $L^2$ represents -C(=O)-NH-.

**12.** The lithographic printing plate precursor according to claim 10,
wherein, in Formula (a4), the hydrophilic group represented by X is a hydroxyl group, a polyalkyleneoxy group, or a group obtained by combining two or more of these groups.

**13.** The lithographic printing plate precursor according to claim 2,
wherein the polymer B is a copolymer further having a constitutional unit having a polyalkyleneoxy group in a side chain.

**14.** The lithographic printing plate precursor according to claim 2 or 7,
wherein $L^{11}$ in Formula (I) is an ester bond.

**15.** A method of preparing a lithographic printing plate, comprising:

a step of exposing the lithographic printing plate precursor according to claim 3 in a shape of an image; and
a step of supplying at least one selected from the group consisting of a printing ink and dampening water on a printer to remove an image-recording layer in a non-image area.

**16.** A lithographic printing method comprising:

a step of exposing the lithographic printing plate precursor according to claim 3 in a shape of an image;
a step of supplying at least one selected from the group consisting of a printing ink and dampening water on a printer to remove an image-recording layer in a non-image area and to prepare a lithographic printing plate; and
a step of performing printing using the obtained lithographic printing plate.

FIG. 1

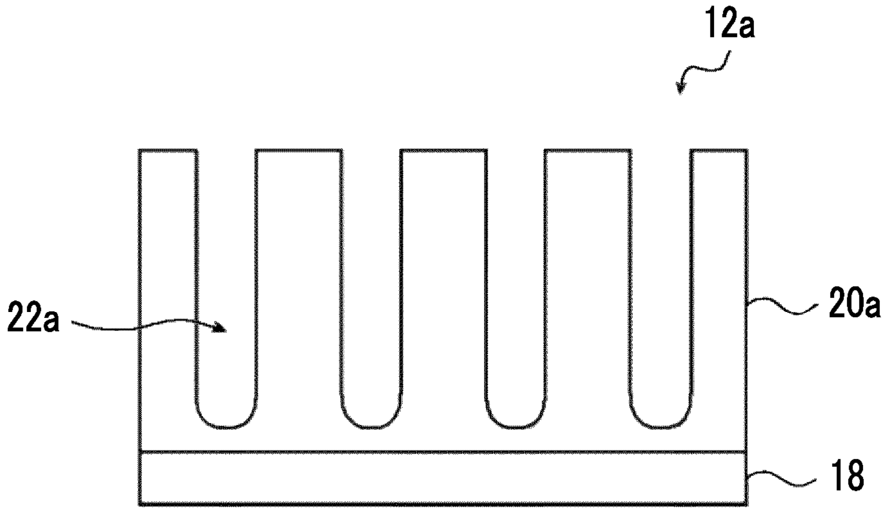


FIG. 2

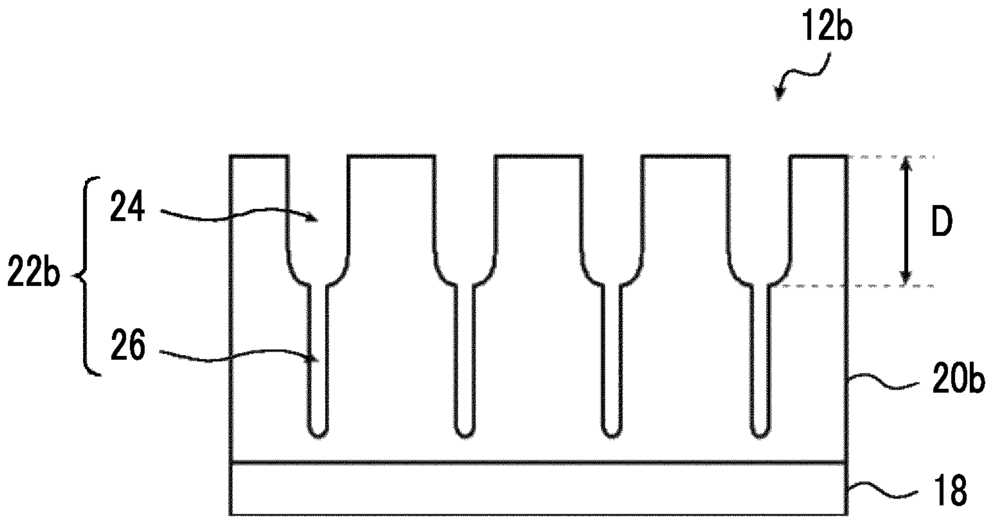

FIG. 3

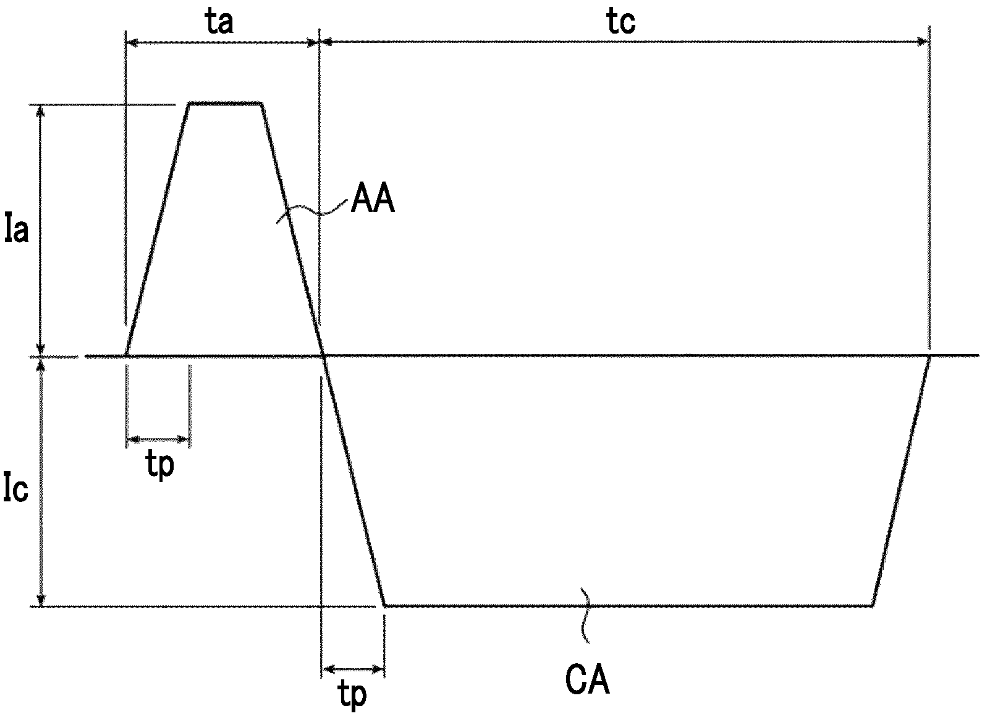


FIG. 4

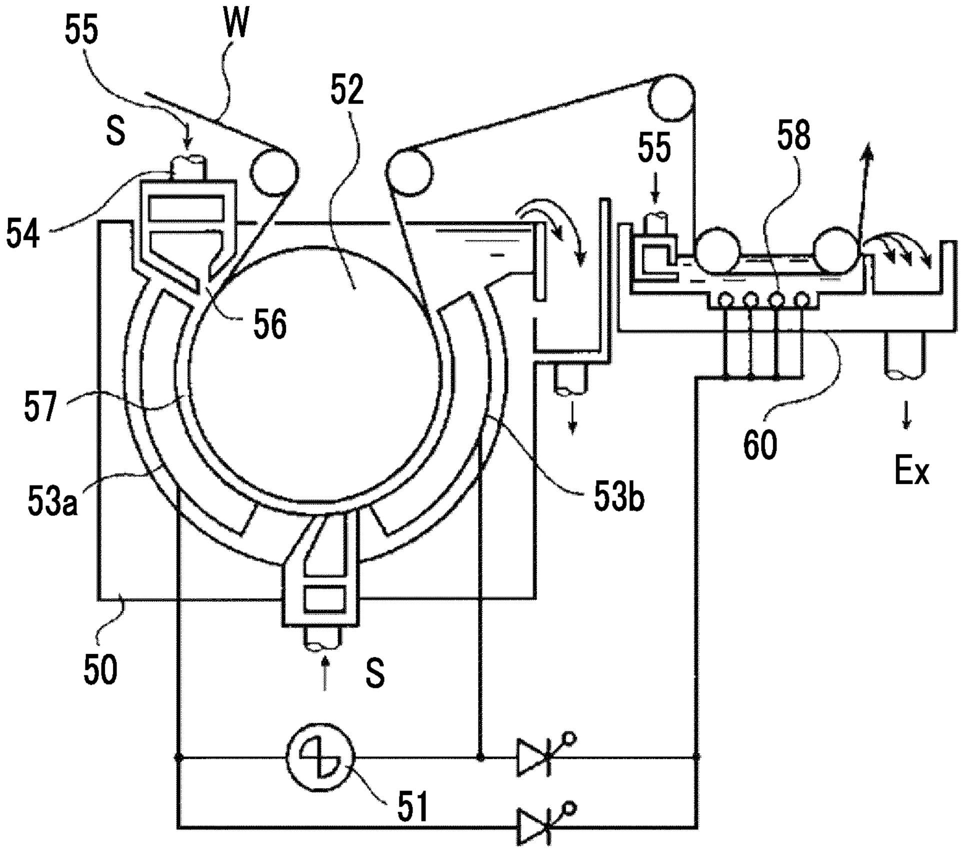

FIG. 5

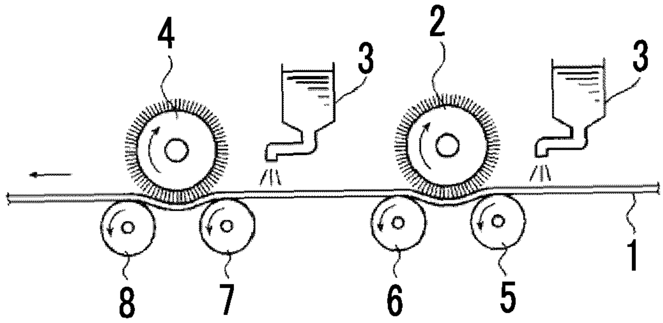


FIG. 6

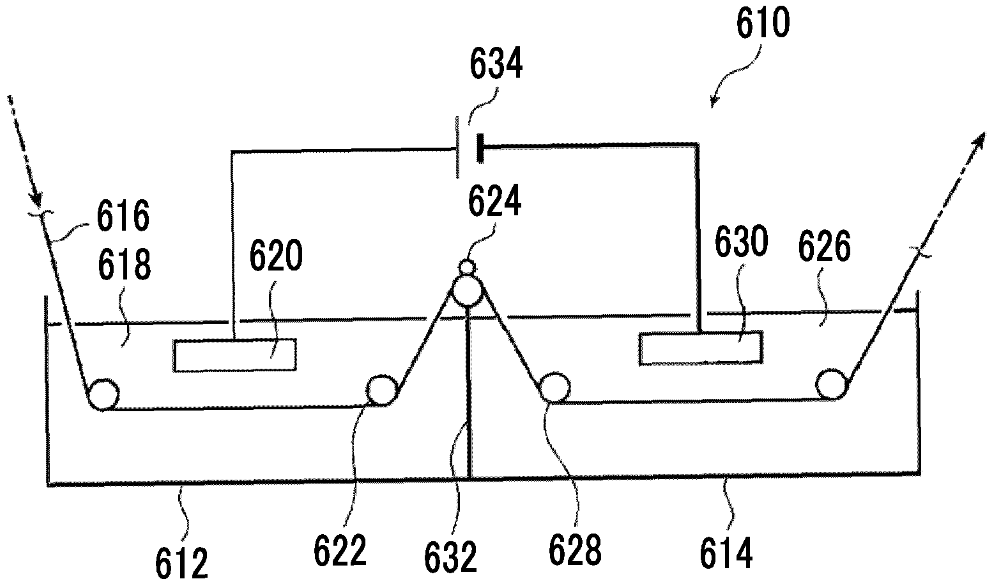

## INTERNATIONAL SEARCH REPORT

International application No.
**PCT/JP2023/043021**

**A. CLASSIFICATION OF SUBJECT MATTER**

***B41N 1/14***(2006.01)i; ***B41C 1/10***(2006.01)i; ***B41M 1/06***(2006.01)i; ***G03F 7/00***(2006.01)i; ***G03F 7/004***(2006.01)i; ***G03F 7/075***(2006.01)i; ***G03F 7/095***(2006.01)i
FI: B41N1/14; G03F7/00 503; G03F7/004 501; G03F7/004 507; G03F7/095; G03F7/075 521; B41C1/10; B41M1/06

According to International Patent Classification (IPC) or to both national classification and IPC

**B. FIELDS SEARCHED**

Minimum documentation searched (classification system followed by classification symbols)

B41N1/00-3/08; B41C1/00-3/08; B41M1/00-3/18; G03F7/00; G03F7/004; G03F7/075; G03F7/095

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 11-174666 A (FUJI PHOTO FILM CO., LTD.) 02 July 1999 (1999-07-02) paragraphs [0008]-[0044], [0121]-[0123], [0137]-[0139] | 1-10, 12-16<br>11 |
| X | US 2005/0106501 A1 (AGFA-GEVAERT) 19 May 2005 (2005-05-19) paragraphs [0019]-[0046] | 1-2, 6-7, 9, 13-14 |
| A | JP 2007-237586 A (KONICA MINOLTA MEDICAL & GRAPHIC, INC.) 20 September 2007 (2007-09-20) paragraphs [0127]-[0133] | 1-16 |

☐ Further documents are listed in the continuation of Box C.  ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **02 February 2024** | **20 February 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2023/043021**

| Patent document cited in search report | Publication date (day/month/year) | Patent family member(s) | Publication date (day/month/year) |
| --- | --- | --- | --- |
| JP 11-174666 A | 02 July 1999 | US 6228559 B1 column 2, lines 27-66, columns 3-12, whole part, column 13, lines 1-15, column 25, lines 41-67, column 26, lines 1-51, column 29, lines 1-29, column 30, lines 1-19 | |
| US 2005/0106501 A1 | 19 May 2005 | EP 1531042 A1 paragraphs [0016]-[0029] | |
| JP 2007-237586 A | 20 September 2007 | (Family: none) | |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009237381 A
- JP 2004029680 A
- JP 2006235390 A
- JP 9054432 A
- JP H09054432 A
- JP 7285275 A
- JP H07285275 A
- JP 2003345014 A
- JP 7020625 A
- JP H07020625 A
- JP 11218903 A
- JP H11218903 A
- JP 2001100412 A
- JP 2002169282 A
- JP 2008015504 A
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H055005 A
- JP 2001222101 A
- WO 2019013268 A
- JP 2019018412 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- WO 2018043259 A
- JP 2019064269 A
- JP 2009255434 A
- JP 2012187907 A
- JP 2012148555 A
- JP 2005250216 A
- JP 2006259137 A
- WO 2019219560 A
- WO 2016047392 A
- JP 2019162855 A
- JP 5045885 A
- JP H545885 A
- JP 6035174 A
- JP H635174 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- JP 2022192211 A
- JP 2023113277 A


### Non-patent literature cited in the description


- Dye Handbooks. *Society of Synthetic Organic Chemistry*, 1970
- **IWANAMI**. Dictionary of Physics and Chemistry. Iwanami Shoten, Publishers, 1998